(19) Europäisches Patentamt
European Patent Office
Office européen des brevets

(11) EP 4 685 840 A1

(12) **EUROPEAN PATENT APPLICATION**
published in accordance with Art. 153(4) EPC

(43) Date of publication:
**28.01.2026 Bulletin 2026/05**

(21) Application number: **24774783.5**

(22) Date of filing: **13.03.2024**

(51) International Patent Classification (IPC):
***H01L 21/304*** *(2006.01)* ***C09D 5/20*** *(2006.01)*
***H01L 21/02*** *(2006.01)* ***H01L 21/683*** *(2006.01)*

(52) Cooperative Patent Classification (CPC):
**C09D 5/20; H01L 21/02; H01L 21/304; H01L 21/683**

(86) International application number:
**PCT/JP2024/009720**

(87) International publication number:
**WO 2024/195644 (26.09.2024 Gazette 2024/39)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **23.03.2023 JP 2023046679**

(71) Applicant: **Nissan Chemical Corporation**
**Tokyo 103-6119 (JP)**

(72) Inventors:
- **YAGYU Masafumi**
  **Toyama-shi, Toyama 939-2792 (JP)**
- **SHINJO Tetsuya**
  **Toyama-shi, Toyama 939-2792 (JP)**

(74) Representative: **Hoffmann Eitle**
**Patent- und Rechtsanwälte PartmbB**
**Arabellastraße 30**
**81925 München (DE)**

# (54) RELEASE AGENT COMPOSITION FOR PHOTOIRRADIATION RELEASE, LAYERED PRODUCT, AND METHOD FOR PRODUCING PROCESSED SEMICONDUCTOR SUBSTRATE

(57) This release agent composition for release by irradiation with light includes a polymer and a solvent, the polymer including a first structure, a second structure, and a third structure, wherein the first structure has a structure that absorbs light to impart releasability to a release agent layer formed from the release agent composition, the second structure has a -Si-O-Si- structure in a main chain of the polymer, and the third structure has an aromatic hydrocarbon ring and/or a heterocyclic ring.

FIG. 1

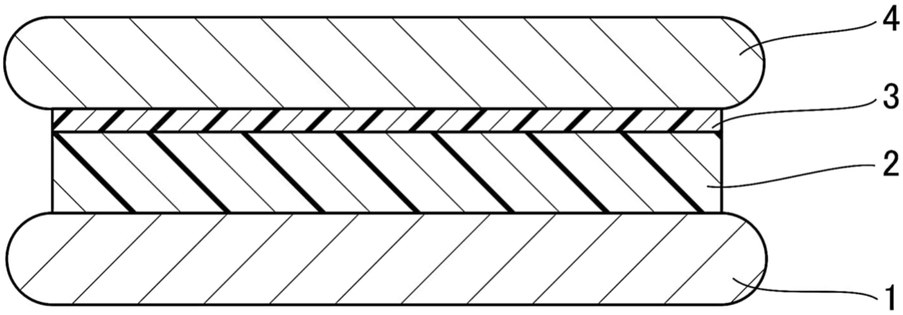




Processed by Luminess, 75001 PARIS (FR)

## Description

### Technical Field

The present invention relates to a release agent composition for release by irradiation with light, a laminate, and a method for producing a processed semiconductor substrate.

### Background Art

For a semiconductor wafer that has been conventionally integrated in a two-dimensional planar direction, a semiconductor integration technology is required by which a planar surface is further integrated (laminated) also in a three-dimensional direction for the purpose of further integration. This three-dimensional lamination is a technology of integrating multiple layers while connecting the layers by a through silicon via (TSV). At the time of multilayer integration, respective wafers to be integrated are thinned by polishing on the side opposite to the formed circuit surface (that is, the back surface), and the thinned semiconductor wafers are laminated.

A semiconductor wafer before thinning (also referred to herein simply as a wafer) is adhered to a support in order to be polished with a polishing apparatus. The adhesion at that time needs to be easily releasable after polishing, and is therefore referred to as temporary adhesion. This temporary adhesion needs to allow easy removal from the support. Otherwise, the thinned semiconductor wafer may be cut or deformed when a large force is applied for the removal. In order to prevent such a situation, the semiconductor wafer is easily removed. On the other hand, it is not also preferable that polishing stress at the time of polishing the back surface of the semiconductor wafer causes the semiconductor wafer to be detached or displaced. Therefore, the performance required for temporary adhesion is to withstand the stress during polishing and to allow for easy removal after polishing.

For example, there is a demand for a performance having a high stress (strong adhesion force) in the planar direction at the time of polishing and a low stress (weak adhesion force) in the vertical direction at the time of removal.

Although methods by irradiation with a laser have been disclosed for such adhesion and separation processes (for example, refer to Patent Literatures 1 and 2), new technologies related to release by irradiation with light such as a laser are always required with further progress in the recent semiconductor field.

The present applicant has proposed a laminate for allowing for processing of a workpiece, the laminate including an intermediate layer adhered between a support and the workpiece to be releasable, in which the intermediate layer includes at least a release layer in contact with the support side, and the release layer includes a Novolac resin that is altered by absorbing light having a wavelength of 190 nm to 600 nm emitted through the support (refer to Patent Literature 3).

### Citation List

### Patent Literature

Patent Literature 1: JP 2004-64040 A
Patent Literature 2: JP 2012-106486 A
Patent Literature 3: WO 2019/088103 A

### Summary of Invention

### Technical Problem

In a method for release by irradiation with light, after a semiconductor substrate such as a semiconductor wafer is processed, a release agent layer is altered by irradiation with light to facilitate release of the semiconductor substrate from a support substrate. Since foreign matter such as an adhesive layer, a release agent layer, and residues thereof may attach to the surface of the semiconductor substrate and/or the support substrate after release, the semiconductor substrate and/or the support substrate is cleaned. However, depending on the type of the release agent layer, foreign matter on the semiconductor substrate and the support substrate is hardly removed, and thus cleaning may be difficult.

The present invention has been made in view of the above circumstances, and an object thereof is to provide a release agent composition for light irradiation release in which a release agent layer having not only excellent releasability but also excellent cleanability can be formed, a laminate using the release agent composition, and a method for producing a processed semiconductor substrate.

Solution to Problem

As a result of intensive studies to solve the above-mentioned problems, the present inventors have found that the above-mentioned problems can be solved, and completed the present invention having the following gist.

That is, the present invention includes the following items.

[1] A release agent composition for release by irradiation with light, including

a polymer and a solvent,
the polymer including a first structure, a second structure, and a third structure, wherein
the first structure has a structure that absorbs light to impart releasability to a release agent layer formed from the release agent composition,
the second structure has a -Si-O-Si- structure in a main chain of the polymer, and
the third structure has an aromatic hydrocarbon ring and/or a heterocyclic ring.

[2] The release agent composition according to [1],
wherein the first structure is a repeating unit represented by the following formula (1):

[Chem. 1]

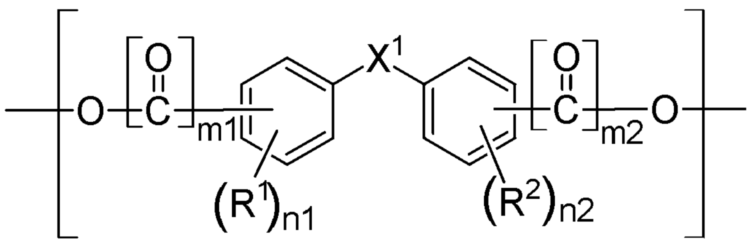 (1)

wherein in the formula (1), $X^1$ represents -O-, -CO-, - $NR^a$- (where $R^a$ represents a hydrogen atom, an optionally substituted alkyl group, or an optionally substituted aryl group.), -SO-, $-SO_2-$, -N=N-, -CH=CH-CO-, or -CH=CH-CO-$CH_2$-CO-CH=CH-,
m1 and m2 each independently represent 0 or 1,
$R^1$ and $R^2$ each independently represent a halogen atom or a monovalent group,
n1 and n2 each independently represent an integer of 0 to 4,
when there are two or more $R^1$ moieties, the two or more $R^1$ moieties are the same or different, and
when there are two or more $R^2$ moieties, the two or more $R^2$ moieties are the same or different.

[3] The release agent composition according to [1] or [2], wherein the second structure is a repeating unit represented by the following formula (2-1) or (2-2):

[Chem. 2]

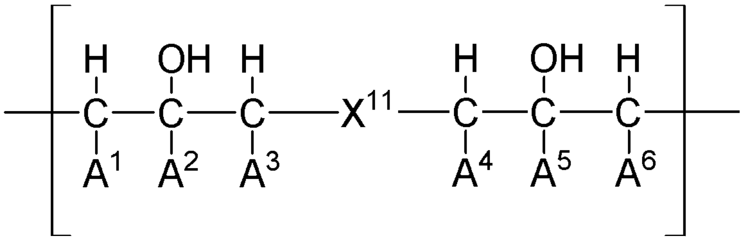

(2-1)

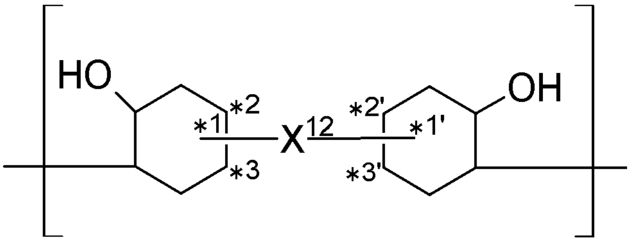

(2-2)

wherein in the formula (2-1), $X^{11}$ represents a divalent group having a -Si-O-Si- structure, and $A^1$, $A^2$, $A^3$, $A^4$, $A^5$, and $A^6$ each independently represent a hydrogen atom, a methyl group, or an ethyl group, in the formula (2-2), $X^{12}$ represents a divalent group having a -Si-O-Si- structure, *1 and *1' represent a bond, the bond *1 is bonded to a carbon atom *2 or a carbon atom *3, and the bond *1' is bonded to a carbon atom *2' or a carbon atom *3'.

[4] The release agent composition according to [3], wherein $X^{11}$ in the formula (2-1) and $X^{12}$ in the formula (2-2) are each independently a structure represented by the following formula (S):

[Chem. 3]

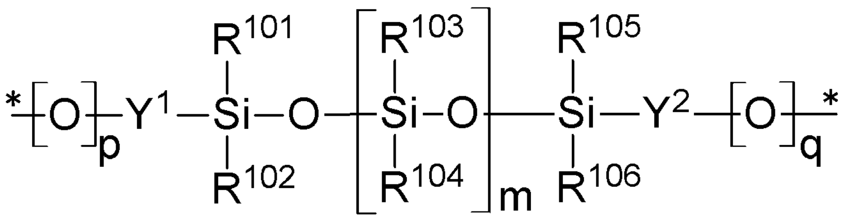

(S)

wherein in the formula (S), $R^{101}$ to $R^{106}$ each independently represent a substituted or unsubstituted alkyl group, a substituted or unsubstituted alkenyl group, or a substituted or unsubstituted aryl group,
$Y^1$ and $Y^2$ each independently represent a $C_{1-10}$ alkylene group,
m represents an integer of 0 or 1 or more,
p and q each independently represent 0 or 1,
when m is 2 or more, 2 or more of $R^{103}$ or $R^{104}$ are the same or different, and
* represents a bond.

[5] The release agent composition according to any one of [1] to [4], wherein the third structure is a repeating unit represented by the following formula (3):

[Chem. 4]

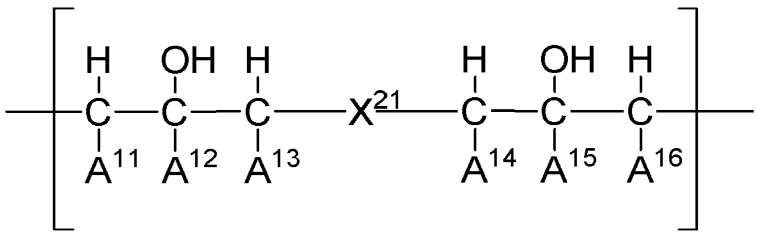

(3)

wherein in the formula (3), $X^{21}$ represents a divalent group having an aromatic hydrocarbon ring and/or a heterocyclic ring, and

$A^{11}$, $A^{12}$, $A^{13}$, $A^{14}$, $A^{15}$, and $A^{16}$ each independently represent a hydrogen atom, a methyl group, or an ethyl group.

[6] The release agent composition according to [5], wherein $X^{21}$ in the formula (3) is any of a structure represented by the following formula (3-1) and a structure represented by the following formula (3-2):

[Chem. 5]

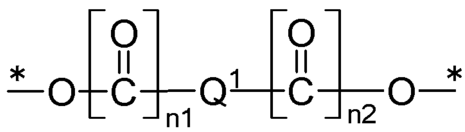

(3-1)

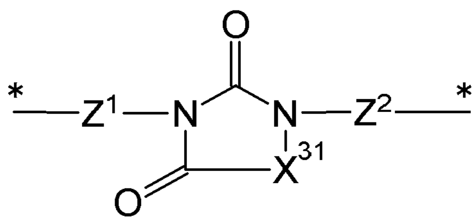

(3-2)

wherein in the formula (3-1), $Q^1$ represents a divalent organic group represented by the following formula (3-1-1) or a divalent organic group represented by the following formula (3-1-2), n1 and n2 each independently represent 0 or 1, * represents a bond,

in the formula (3-2), $X^{31}$ represents a divalent group represented by any one of the following formulae (3-2-1) to (3-2-3), $Z^1$ and $Z^2$ each independently represent a single bond or a divalent group represented by formula (3-2-4) below, and * represents a bond;

[Chem. 6]

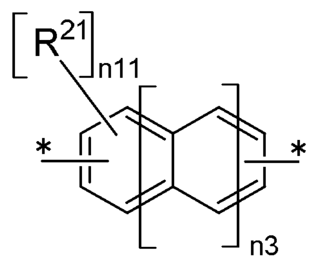

(3-1-1)

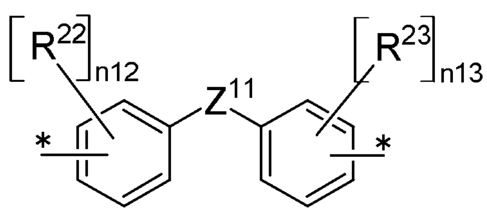

(3-1-2)

wherein in the formulae (3-1-1) and (3-1-2), $R^{21}$ to $R^{23}$ each independently represent a halogen atom, a hydroxy group, a $C_{1-6}$ alkyl group, a $C_{2-6}$ alkenyl group, a $C_{2-6}$ alkynyl group, a $C_{1-6}$ alkoxy group, a $C_{2-6}$ alkenyloxy group, a $C_{2-6}$ alkynyloxy group, a $C_{2-6}$ acyl group, a $C_{6-12}$ aryloxy group, a $C_{7-13}$ arylcarbonyl group, or a $C_{7-13}$ aralkyl group, and * represents a bond,

in the formula (3-1-1), n3 represents 0 or 1, when n3 is 0, n11 represents an integer of 0 to 4, when n3 is 1, n11 represents an integer of 0 to 6, and when there are two or more $R^{21}$ moieties, the two or more $R^{21}$ moieties are the same or different,

in the formula (3-1-2), $Z^{11}$ represents a single bond or a $C_{1-6}$ alkylene group, n12 and n13 each independently represent an integer of 0 to 4, when there are two or more $R^{22}$ moieties, the two or more $R^{22}$ moieties are the same or different, and when there are two or more $R^{23}$ moieties, the two or more $R^{23}$ moieties are the same or different;

[Chem. 7]

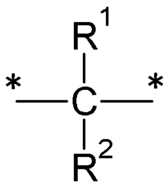
(3-2-1)

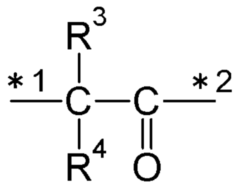
(3-2-2)

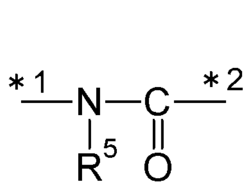
(3-2-3)

in the formulae (3-2-1) to (3-2-3), $R^1$ to $R^5$ each independently represent a hydrogen atom, a $C_{1-10}$ alkyl group optionally interrupted by an oxygen atom or a sulfur atom, a $C_{2-10}$ alkenyl group optionally interrupted by an oxygen atom or a sulfur atom, a $C_{2-10}$ alkynyl group optionally interrupted by an oxygen atom or a sulfur atom, a benzyl group, or a phenyl group provided that the phenyl group is optionally substituted with at least one monovalent group selected from the group consisting of a $C_{1-6}$ alkyl group, a halogen atom, a $C_{1-6}$ alkoxy group, a nitro group, a cyano group, and a $C_{1-6}$ alkylthio group, $R^1$ and $R^2$ are optionally bonded to each other to form a $C_{3-6}$ ring, $R^3$ and $R^4$ are optionally bonded to each other to form a $C_{3-6}$ ring,

* represents a bond, *1 represents a bond bonded to a carbon atom in the formula (3-2), and *2 represents a bond bonded to a nitrogen atom in the formula (3-2); and

[Chem. 8]

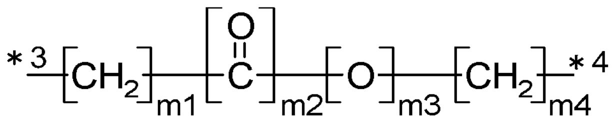
(3-2-4)

wherein in the formula (3-2-4), m1 is an integer of 0 to 4, m2 is 0 or 1, m3 is 0 or 1, and m4 is an integer of 0 to 2, provided that, when m3 is 1, m1 and m2 are not both 0 at the same time, *3 represents a bond bonded to a nitrogen atom in the formula (3-2), and *4 represents a bond.

[7] A laminate including:

a semiconductor substrate or an electronic device layer;
a light-transmissive support substrate; and
a release agent layer provided between the semiconductor substrate or the electronic device layer and the support substrate, in which
the release agent layer is a release agent layer formed from the release agent composition according to any one of [1] to [6].

[8] The laminate according to [7], including an adhesive layer provided between the semiconductor substrate or the electronic device layer and the support substrate.

[9] A method for producing a processed semiconductor substrate or a processed electronic device layer, the method

including:

step 5A of processing the semiconductor substrate of the laminate according to [7] or [8], or step 5B of processing the electronic device layer of the laminate according to [7] or [8]; and
step 6A of separating the semiconductor substrate processed in step 5A and the support substrate from each other, or step 6B of separating the electronic device layer processed in step 5B and the support substrate from each other.

[10] The method for producing a processed semiconductor substrate or an electronic device layer according to [9], in which step 6A or step 6B includes a step of irradiating the laminate with a laser from the support substrate side.

Advantageous Effects of Invention

According to the present invention, it is possible to provide a release agent composition for light irradiation release in which a release agent layer having not only excellent releasability but also excellent cleanability can be formed, a laminate using the release agent composition, and a method for producing a processed semiconductor substrate.

Brief Description of Drawings

[Fig. 1] Fig. 1 is a schematic cross-sectional view of an example of a laminate according to a first embodiment.
[Fig. 2A] Fig. 2A is a schematic cross-sectional view for illustrating a method for producing a laminate showing an example in a first embodiment (part 1).
[Fig. 2B] Fig. 2B is a schematic cross-sectional view for illustrating a method for producing a laminate showing an example in a first embodiment (part 2).
[Fig. 2C] Fig. 2C is a schematic cross-sectional view for illustrating a method for producing a laminate showing an example in a first embodiment (part 3).
[Fig. 3] Fig. 3 is a schematic cross-sectional view of an example of a laminate according to a second embodiment.
[Fig. 4] Fig. 4 is a schematic cross-sectional view of another example of a laminate according to a second embodiment.
[Fig. 5A] Fig. 5A is a schematic cross-sectional view for illustrating a method for producing a laminate showing an example in a second embodiment (part 1).
[Fig. 5B] Fig. 5B is a schematic cross-sectional view for illustrating a method for producing a laminate showing an example in a second embodiment (part 2).
[Fig. 5C] Fig. 5C is a schematic cross-sectional view for illustrating a method for producing a laminate showing an example in a second embodiment (part 3).
[Fig. 5D] Fig. 5D is a schematic cross-sectional view for illustrating a method for producing a laminate showing an example in a second embodiment (part 4).
[Fig. 6A] Fig. 6A is a schematic cross-sectional view for illustrating a method for processing a laminate showing an example in a first embodiment (part 1).
[Fig. 6B] Fig. 6B is a schematic cross-sectional view for illustrating a method for processing a laminate showing an example in a first embodiment (part 2).
[Fig. 6C] Fig. 6C is a schematic cross-sectional view for illustrating a method for processing a laminate showing an example in a first embodiment (part 3).
[Fig. 6D] Fig. 6D is a schematic cross-sectional view for illustrating a method for processing a laminate showing an example in a first embodiment (part 4).
[Fig. 7A] Fig. 7A is a schematic cross-sectional view for illustrating a method for processing a laminate showing an example in a second embodiment (part 1).
[Fig. 7B] Fig. 7B is a schematic cross-sectional view for illustrating a method for processing a laminate showing an example in a second embodiment (part 2).
[Fig. 7C] Fig. 7C is a schematic cross-sectional view for illustrating a method for processing a laminate showing an example in a second embodiment (part 3).
[Fig. 7D] Fig. 7D is a schematic cross-sectional view for illustrating a method for processing a laminate showing an example in a second embodiment (part 4).
[Fig. 7E] Fig. 7E is a schematic cross-sectional view for illustrating a method for processing a laminate showing an example in a second embodiment (part 5).
[Fig. 7F] Fig. 7F is a schematic cross-sectional view for illustrating a method for processing a laminate showing an example in a second embodiment (part 6).

Description of Embodiments

(Release agent composition for light irradiation release)

The release agent composition for light irradiation release according to the present invention contains a polymer and a solvent.

The release agent composition for light irradiation release may contain other components.

<Polymer>

The polymer has a first structure, a second structure, and a third structure.

The first structure has a structure that absorbs light to impart releasability to a release agent layer formed from the release agent composition.

The second structure has a -Si-O-Si- structure in the main chain of the polymer.

The third structure has an aromatic hydrocarbon ring and/or a heterocyclic ring.

The first structure, the second structure, and the third structure are different from each other.

<<First Structure>>

The first structure is not particularly limited as long as the structure absorbs light to impart releasability to a release agent layer formed from the release agent composition.

The wavelength of the light used for release is preferably, for example, a wavelength of 250 to 600 nm, more preferably a wavelength of 250 to 370 nm as described above. A more suitable wavelength is 308 nm, 343 nm, 355 nm, 365 nm, or 532 nm. The irradiation amount of light required for release is an irradiation amount that can cause suitable alteration, for example, decomposition of the first structure.

The light used for release may be laser light or non-laser light emitted from a light source such as an ultraviolet lamp.

From the viewpoint of reproducibly achieving the effects of the present invention, the first structure preferably has a repeating unit represented by the following formula (1):

[Chem. 9]

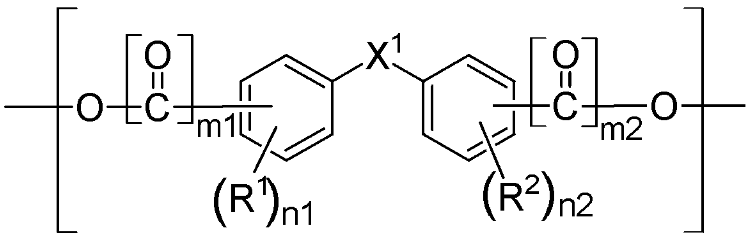

(1)

wherein in the formula (1), $X^1$ represents -O-, -CO-, - $NR^a$- (where $R^a$ represents a hydrogen atom, an optionally substituted alkyl group, or an optionally substituted aryl group.), -SO-, -$SO_2$-, -N=N-, -CH=CH-CO-, or -CH=CH-CO-$CH_2$-CO-CH=CH-,

m1 and m2 each independently represent 0 or 1,

$R^1$ and $R^2$ each independently represent a halogen atom or a monovalent group,

n1 and n2 each independently represent an integer of 0 to 4,

when there are two or more $R^1$ moieties, the two or more $R^1$ moieties are the same or different, and

when there are two or more $R^2$ moieties, the two or more $R^2$ moieties are the same or different.

Note that the "-CH=CH-CO-$CH_2$-CO-CH=CH-" has a tautomer and is synonymous with "-CH=CH-CO-CH=C(OH)-CH=CH-" or "-CH=CH-C(OH)=CH-CO-CH=CH-".

$X^1$ in the formula (1) is preferably -CO- or -$NR^a$- from the viewpoint of reproducibly achieving the effects of the present invention.

Examples of the substituent in the optionally substituted alkyl group in $R^a$ of -$NR^a$- in the formula (1) include a halogen atom, a hydroxy group, a carboxy group, and a $C_{1-6}$ alkoxy group.

The number of carbon atoms of the "alkyl group" in the optionally substituted alkyl group as $R^a$ is, for instance, 1 to 6.

The optionally substituted alkyl group as $R^a$ is preferably a $C_{1-6}$ alkyl group, and more preferably a $C_{1-4}$ alkyl group.

In the present description, examples of a halogen atom include a fluorine atom, a chlorine atom, a bromine atom, and an iodine atom.

Examples of the substituent in the optionally substituted aryl group in $R^a$ of $-NR^a-$ in the formula (1) include a halogen atom, a hydroxy group, a carboxy group, a $C_{1-6}$ alkyl group, and a $C_{1-6}$ alkoxy group.

The aromatic ring in the optionally substituted aryl group as $R^a$ may be an aromatic hydrocarbon ring or may be an aromatic heterocyclic ring; however, the aromatic ring is preferably an aromatic hydrocarbon ring. Examples of the aromatic hydrocarbon ring include a benzene ring, a naphthalene ring, and an anthracene ring.

The optionally substituted aryl group as $R^a$ is preferably an optionally substituted phenyl group.

Examples of the monovalent group in $R^1$ or $R^2$ in the formula (1) include a halogen atom, a hydroxy group, a carboxy group, an optionally substituted alkyl group, an optionally substituted alkoxy group, and an optionally substituted aryl group.

Examples of the substituent in the optionally substituted alkyl group as $R^1$ or $R^2$ include a halogen atom, a hydroxy group, a carboxy group, and a $C_{1-6}$ alkoxy group.

The optionally substituted alkyl group as $R^1$ or $R^2$ is preferably a $C_{1-6}$ alkyl group, and more preferably a $C_{1-4}$ alkyl group.

Examples of the substituent in the optionally substituted alkoxy group as $R^1$ or $R^2$ include a halogen atom, a hydroxy group, and a carboxy group.

The optionally substituted alkoxy group as $R^1$ or $R^2$ is preferably a $C_{1-6}$ alkoxy group and more preferably a $C_{1-4}$ alkoxy group.

Examples of the substituent in the optionally substituted aryl group as $R^1$ or $R^2$ include a halogen atom, a hydroxy group, a carboxy group, a $C_{1-6}$ alkyl group, and a $C_{1-6}$ alkoxy group.

The aromatic ring in the optionally substituted aryl group as $R^1$ or $R^2$ may be an aromatic hydrocarbon ring or may be an aromatic heterocyclic ring; however, the aromatic ring is preferably an aromatic hydrocarbon ring. Examples of the aromatic hydrocarbon ring include a benzene ring, a naphthalene ring, and an anthracene ring.

The optionally substituted aryl group as $R^1$ or $R^2$ is preferably an optionally substituted phenyl group.

m1 and m2 each independently represent 0 or 1, but it is preferable that m1 and m2 are both 0.

In the repeating unit represented by the formula (1), the bonding position to the benzene ring is not particularly limited, but the repeating unit represented by the formula (1) is preferably a repeating unit represented by the following formula (1-1):

[Chem. 10]

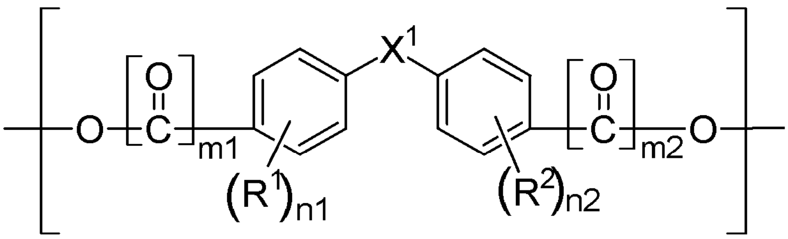

(1-1)

wherein in the formula (1-1), $X^1$, $R^1$, $R^2$, m1, m2, n1, and n2 have the same meanings as $X^1$, $R^1$, $R^2$, m1, m2, n1, and n2 in the formula (1), respectively.

Examples of the repeating unit represented by the formula (1) include the following repeating units:

[Chem. 11]

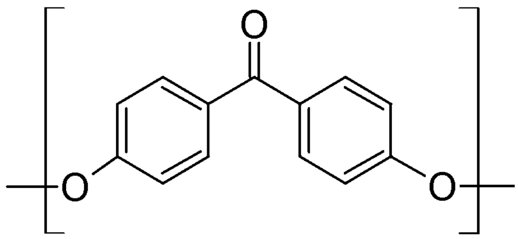

(1A)

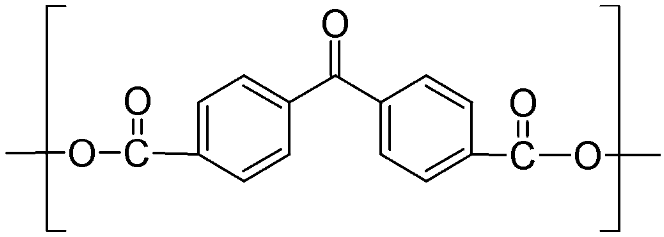

(1B)

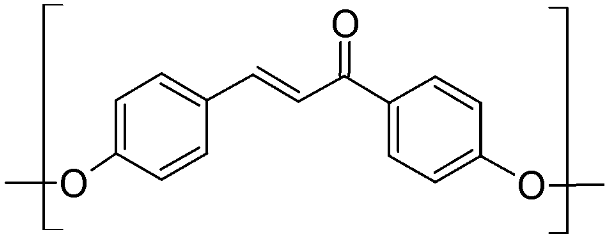

(1C)

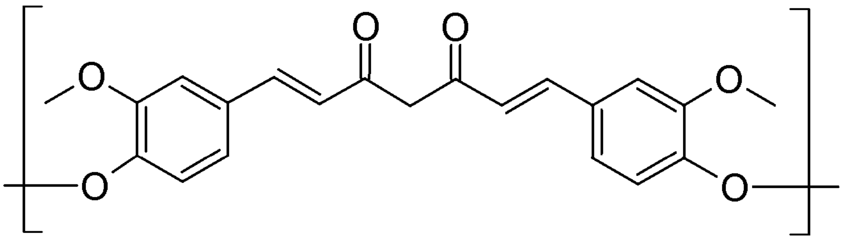

(1D)

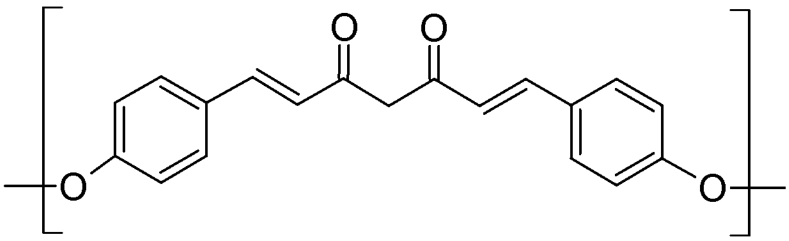

(1E)

<<Second Structure>>

The second structure is not particularly limited as long as the structure has a -Si-O-Si- structure in the main chain of the polymer.

When the polymer has the second structure, cleanability is imparted to a release agent layer formed from the release agent composition.

From the viewpoint of reproducibly achieving the effects of the present invention, the second structure preferably has a repeating unit represented by the following formula (2-1) or (2-2):

[Chem. 12]

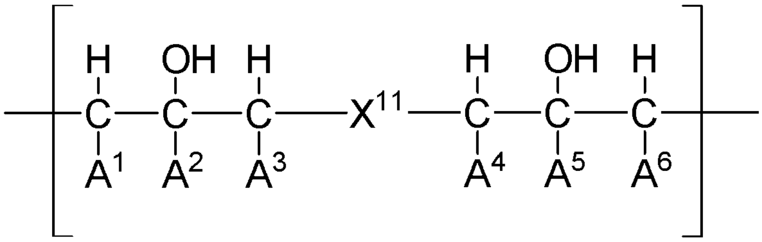

(2-1)

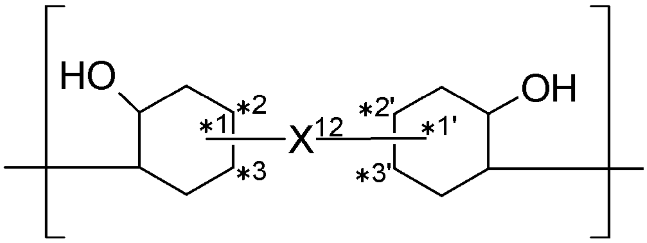

(2-2)

wherein in the formula (2-1), $X^{11}$ represents a divalent group having a -Si-O-Si- structure, and $A^1$, $A^2$, $A^3$, $A^4$, $A^5$, and $A^6$ each independently represent a hydrogen atom, a methyl group, or an ethyl group, in the formula (2-2), $X^{12}$ represents a divalent group having a -Si-O-Si- structure, *1 and *1' represent a bond, the bond *1 is bonded to a carbon atom *2 or a carbon atom *3, and the bond *1' is bonded to a carbon atom *2' or a carbon atom *3'.

$A^1$, $A^2$, $A^3$, $A^4$, $A^5$, and $A^6$ are preferably hydrogen atoms.

From the viewpoint of reproducibly achieving the effects of the present invention, $X^{11}$ in the formula (2-1) and $X^{12}$ in the formula (2-2) preferably have a structure represented by the following formula (S):

[Chem. 13]

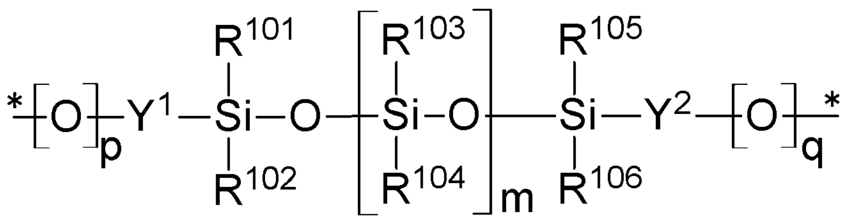

(S)

wherein in the formula (S), $R^{101}$ to $R^{106}$ each independently represent a substituted or unsubstituted alkyl group, a substituted or unsubstituted alkenyl group, or a substituted or unsubstituted aryl group,
$Y^1$ and $Y^2$ each independently represent a $C_{1-10}$ alkylene group,
m represents an integer of 0 or 1 or more,
p and q each independently represent 0 or 1,
when m is 2 or more, 2 or more of $R^{103}$ or $R^{104}$ are the same or different, and
* represents a bond.

The "alkyl group" in the "substituted or unsubstituted alkyl group" of $R^{101}$ to $R^{106}$ in the formula (S) is preferably a $C_{1-10}$ alkyl group. Examples of the "alkyl group" include a methyl group, an ethyl group, a propyl group, an isopropyl group, a butyl group, an isobutyl group, a sec-butyl group, a tert-butyl group, a pentyl group, an isopentyl group, a neopentyl group, a sec-pentyl group, a tert-pentyl group, a cyclopentyl group, a cyclohexyl group, a cyclopentylmethyl group, a 2-cyclohexylmethyl group, a 2-cyclopentylethyl group, and a 2-cyclohexylethyl group.

The "alkenyl group" in the "substituted or unsubstituted alkenyl group" of $R^{101}$ to $R^{106}$ in the formula (S) is preferably a $C_{2-10}$ alkenyl group. Examples of the "alkenyl group" include a vinyl group, a 1-propenyl group, a 2-propenyl group, a 2-methyl-1-propenyl group, a 1-butenyl group, a 2-butenyl group, a 3-butenyl group, a 3-methyl-2-butenyl group,

a 1-pentenyl group, a 2-pentenyl group, a 3-pentenyl group, a 4-pentenyl group, a 4-methyl-3-pentenyl group, a 1-hexenyl group, a 3-hexenyl group, a 5-hexenyl group, and a 2-cyclohexenyl group.

The substituent of the alkyl group in the "substituted or unsubstituted alkyl group" of $R^{101}$ to $R^{106}$ in the formula (S) and the substituent of the alkenyl group in the "substituted or unsubstituted alkenyl group" are not particularly limited, and examples thereof include a halogen atom, a cyano group, a nitro group, an alkyl-oxy group, an alkyl-carbonyl group, an alkyl-oxy-carbonyl group, an alkyl-carbonyl-oxy group, an alkenyl-oxy group, an alkenyl-carbonyl group, an alkenyl-oxy-carbonyl group, an alkenyl-carbonyl-oxy group, an aryl group, an aryl-oxy group, an aryl-carbonyl group, an aryl-oxy-carbonyl group, and an aryl-carbonyl-oxy group, and combinations thereof. The number of substituents is preferably 1 to 3, and more preferably 1.

The "aryl group" in the "substituted or unsubstituted aryl group" of $R^{101}$ to $R^{106}$ in the formula (S) is preferably a $C_{6-14}$ aryl group. Examples of the "aryl group" include a phenyl group, a 1-naphthyl group, and a 2-naphthyl group.

The substituent of the aryl group in the "substituted or unsubstituted aryl group" of $R^{101}$ to $R^{106}$ is not particularly limited, and examples thereof include a halogen atom, a cyano group, a nitro group, an alkyl group, an alkyl-oxy group, an alkyl-carbonyl group, an alkyl-oxy-carbonyl group, an alkyl-carbonyl-oxy group, an alkenyl group, an alkenyl-oxy group, an alkenyl-carbonyl group, an alkenyl-oxy-carbonyl group, an alkenyl-carbonyl-oxy group, an aryl group, an aryl-alkyl group, an aryl-alkenyl group, an aryl-oxy group, an aryl-carbonyl group, an aryl-oxy-carbonyl group, an aryl-carbonyl-oxy group, or a combination thereof. The number of substituents is preferably 1 to 3, and more preferably 1.

$R^{101}$ to $R^{106}$ in the formula (S) are each preferably a substituted or unsubstituted alkyl group or a substituted or unsubstituted aryl group, more preferably a (unsubstituted) alkyl group or a (unsubstituted) aryl group, still more preferably a methyl group, an ethyl group, a propyl group, an isopropyl group, or a phenyl group, and particularly preferably a methyl group or a phenyl group.

$Y^1$ and $Y^2$ in the formula (S) are each a $C_{1-10}$ alkylene group, and are each preferably a $C_{1-6}$ alkylene group.

Examples of the formula (S) as $X^{11}$ in the formula (2-1) include the following structures:

[Chem. 14]

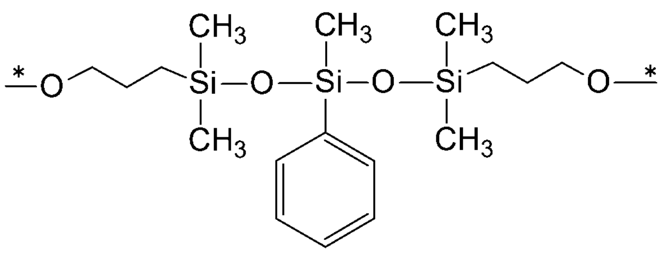

(S1)

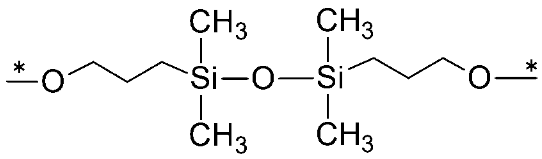

(S2)

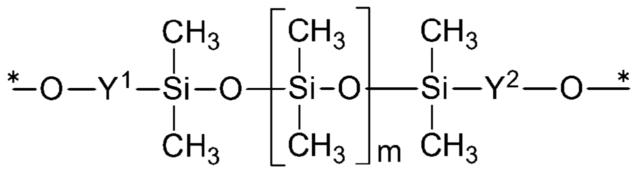

(S3)

wherein in the formula (S3), $Y^1$ and $Y^2$ have the same meanings as $Y^1$ and $Y^2$ in the formula (S), respectively, m represents an integer of 1 or more, and
in the formulas, * represents a bond.

Examples of the formula (S) as $X^{12}$ in the formula (2-2) include the following structure:

[Chem. 15]

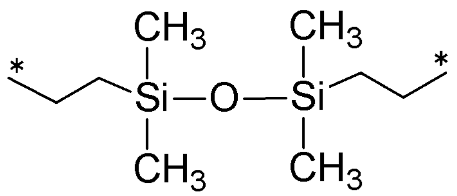

(S4)

wherein in the formula, * represents a bond.

<<Third Structure>>

The third structure is not particularly limited as long as the structure has an aromatic hydrocarbon ring and/or a heterocyclic ring.

Examples of the aromatic hydrocarbon ring include a benzene ring, a naphthalene ring, an anthracene ring, and the like.

Examples of the heteroatom included in the heterocyclic ring include an oxygen atom and a nitrogen atom.

Examples of the number of members of the heterocyclic ring include a 5-membered ring to a 7-membered ring.

From the viewpoint of reproducibly achieving the effects of the present invention, the third structure preferably has a repeating unit represented by the following formula (3):

[Chem. 16]

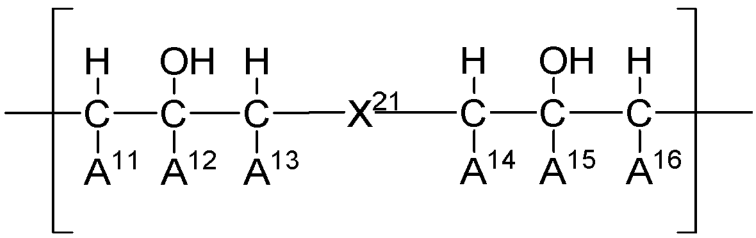

(3)

wherein in the formula (3), $X^{21}$ represents a divalent group having an aromatic hydrocarbon ring and/or a heterocyclic ring, and

$A^{11}$, $A^{12}$, $A^{13}$, $A^{14}$, $A^{15}$, and $A^{16}$ each independently represent a hydrogen atom, a methyl group, or an ethyl group.

In the formula (3), $X^{21}$ represents, for example, either a structure represented by the following formula (3-1) or a structure represented by the following formula (3-2):

[Chem. 17]

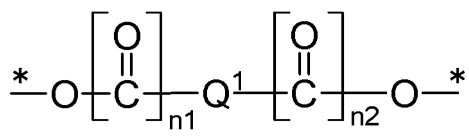

(3-1)

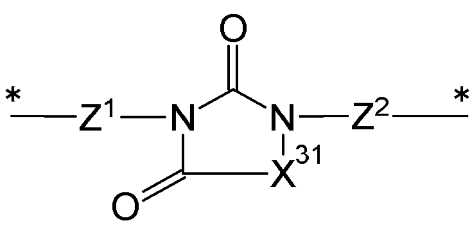

(3-2)

wherein in the formula (3-1), $Q^1$ represents a divalent organic group represented by the following formula (3-1-1) or a divalent organic group represented by the following formula (3-1-2), n1 and n2 each independently represent 0 or 1, *

represents a bond,
in the formula (3-2), $X^{31}$ represents a divalent group represented by any one of the following formulae (3-2-1) to (3-2-3), $Z^1$ and $Z^2$ each independently represent a single bond or a divalent group represented by formula (3-2-4) below, and * represents a bond;

[Chem. 18]

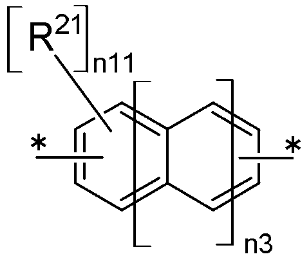

(3-1-1)

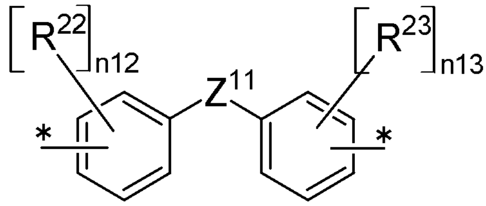

(3-1-2)

wherein in the formulae (3-1-1) and (3-1-2), $R^{21}$ to $R^{23}$ each independently represent a halogen atom, a hydroxy group, a $C_{1-6}$ alkyl group, a $C_{2-6}$ alkenyl group, a $C_{2-6}$ alkynyl group, a $C_{1-6}$ alkoxy group, a $C_{2-6}$ alkenyloxy group, a $C_{2-6}$ alkynyloxy group, a $C_{2-6}$ acyl group, a $C_{6-12}$ aryloxy group, a $C_{7-13}$ arylcarbonyl group, or a $C_{7-13}$ aralkyl group, and * represents a bond,
in the formula (3-1-1), n3 represents 0 or 1, when n3 is 0, n11 represents an integer of 0 to 4, when n3 is 1, n11 represents an integer of 0 to 6, and when there are two or more $R^{21}$ moieties, the two or more $R^{21}$ moieties are the same or different,
in the formula (3-1-2), $Z^{11}$ represents a single bond or a $C_{1-6}$ alkylene group, n12 and n13 each independently represent an integer of 0 to 4, when there are two or more $R^{22}$ moieties, the two or more $R^{22}$ moieties are the same or different, and when there are two or more $R^{23}$ moieties, the two or more $R^{23}$ moieties are the same or different;

[Chem. 19]

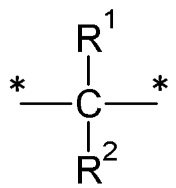

(3-2-1)

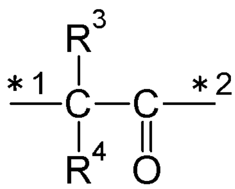

(3-2-2)

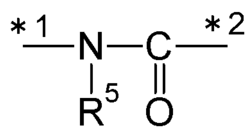

(3-2-3)

in the formulae (3-2-1) to (3-2-3), $R^1$ to $R^5$ each independently represent a hydrogen atom, a $C_{1-10}$ alkyl group optionally interrupted by an oxygen atom or a sulfur atom, a $C_{2-10}$ alkenyl group optionally interrupted by an oxygen atom or a sulfur atom, a $C_{2-10}$ alkynyl group optionally interrupted by an oxygen atom or a sulfur atom, a benzyl group, or a phenyl group provided that the phenyl group is optionally substituted with at least one monovalent group selected from the group consisting of a $C_{1-6}$ alkyl group, a halogen atom, a $C_{1-6}$ alkoxy group, a nitro group, a cyano group, and a $C_{1-6}$ alkylthio group, $R^1$ and $R^2$ are optionally bonded to each other to form a $C_{3-6}$ ring, $R^3$ and $R^4$ are optionally bonded to each other to form a $C_{3-6}$ ring,
* represents a bond, *1 represents a bond bonded to a carbon atom in the formula (3-2), and *2 represents a bond bonded to a nitrogen atom in the formula (3-2); and

[Chem. 20]

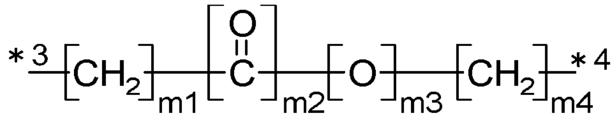

(3-2-4)

wherein in the formula (3-2-4), m1 is an integer of 0 to 4, m2 is 0 or 1, m3 is 0 or 1, and m4 is an integer of 0 to 2, provided that, when m3 is 1, m1 and m2 are not both 0 at the same time, *3 represents a bond bonded to a nitrogen atom in the formula (3-2), and *4 represents a bond.

In the present description, the alkyl group is not limited to a linear alkyl group, and may be branched or cyclic. Examples of the linear or branched alkyl group include a methyl group, an ethyl group, an isopropyl group, a tert-butyl group, and a n-hexyl group. Examples of the cyclic alkyl group (cycloalkyl group) include a cyclobutyl group, a cyclopentyl group, and a cyclohexyl group.

In the present description, examples of the alkoxy group include a methoxy group, an ethoxy group, a n-pentyloxy group, and an isopropoxy group.

In the present description, examples of the alkylthio group include a methylthio group, an ethylthio group, a n-pentylthio group, and an isopropylthio group.

In the present description, examples of the alkenyl group include an ethenyl group, a 1-propenyl group, a 2-propenyl group, a 1-methyl-1-ethenyl group, a 1-butenyl group, a 2-butenyl group, a 3-butenyl group, a 2-methyl-1-propenyl group, and a 2-methyl-2-propenyl group.

In the present description, examples of the alkynyl group include a group in which a double bond of an alkenyl group listed above as the "alkenyl group" is replaced with a triple bond.

In the present description, examples of the alkenyloxy group include a vinyloxy group, a 1-propenyloxy group, a 2-n-propenyloxy group (allyloxy group), a 1-n-butenyloxy group, and a prenyloxy group.

In the present description, examples of the alkynyloxy group include a 2-propynyloxy group, a 1-methyl-2-propynyloxy group, a 2-methyl-2-propynyloxy group, a 2-butynyloxy group, and a 3-butynyloxy group.

In the present description, examples of the acyl group include an acetyl group and a propionyl group.

In the present description, examples of the aryloxy group include a phenoxy group and naphthyloxy.

In the present description, examples of the arylcarbonyl group include a phenylcarbonyl group.

In the present description, examples of the aralkyl group include a benzyl group and a phenethyl group.

In the present description, examples of the alkylene group include a methylene group, an ethylene group, a 1,3-propylene group, a 2,2-propylene group, a 1-methylethylene group, a 1,4-butylene group, a 1-ethylethylene group, a 1-methylpropylene group, a 2-methylpropylene group, a 1,5-pentylene group, a 1-methylbutylene group, a 2-methylbutylene group, a 1,1-dimethylpropylene group, a 1,2-dimethylpropylene group, a 1-ethylpropylene group, a 2-ethylpropylene group, a 1,6-hexylene group, a 1,4-cyclohexylene group, a 1,8-octylene group, a 2-ethyloctylene group, a 1,9-nonylene group, and a 1,10-decylene group.

Examples of the $C_{1-10}$ alkyl group optionally interrupted by an oxygen atom or a sulfur atom of $R^1$ to $R^5$ in formulae (3-2-1) to (3-2-3) include a $C_{1-10}$ alkyl group, a $C_{1-10}$ alkoxy group, a $C_{2-10}$ alkoxyalkyl group, a $C_{3-10}$ alkoxyalkoxyalkyl group, a $C_{1-10}$ alkylthio group, and a $C_{2-10}$ alkylthioalkyl group.

In addition, the $C_{1-10}$ alkyl group optionally interrupted by an oxygen atom or a sulfur atom may contain two or more oxygen atoms or sulfur atoms.

Examples of the structure represented by the formula (3-1) include structures exemplified below.

[Chem. 21]

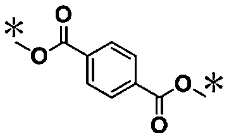
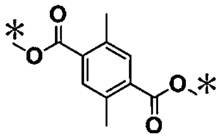
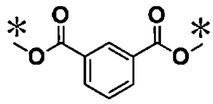
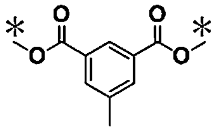
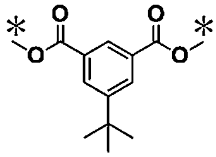
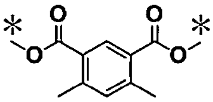
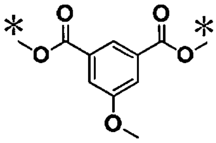
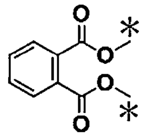
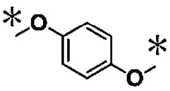
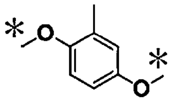
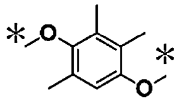
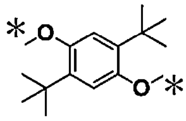
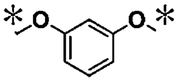
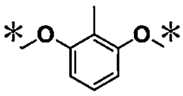
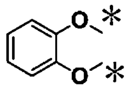
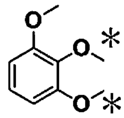

[Chem. 22]

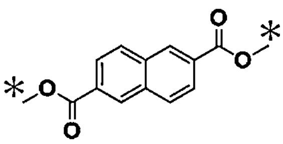
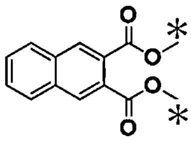
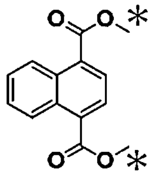
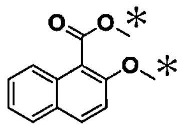
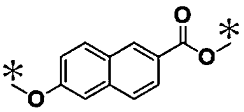
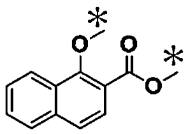
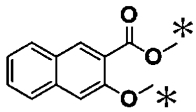
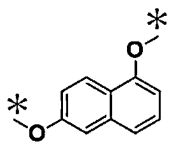
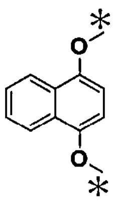
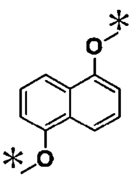
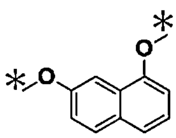
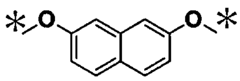
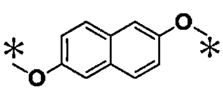
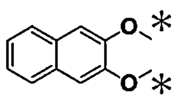

[Chem. 23]

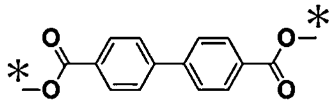
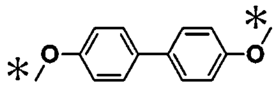
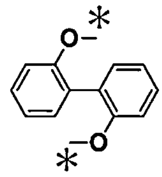
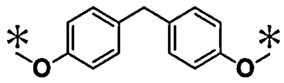
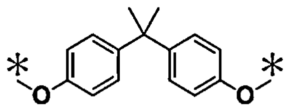
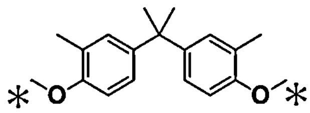
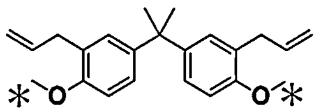

* represents a bond.

Examples of the structure represented by the formula (3-2) include structures exemplified below.

[Chem. 24]

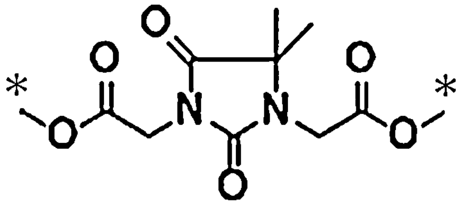

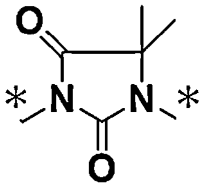

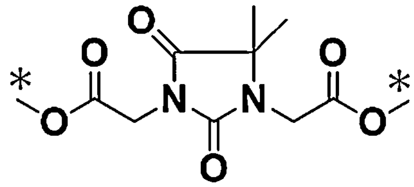

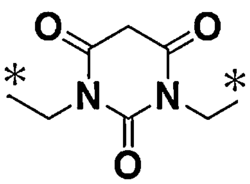

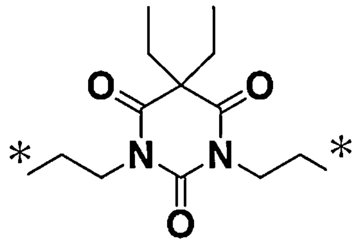

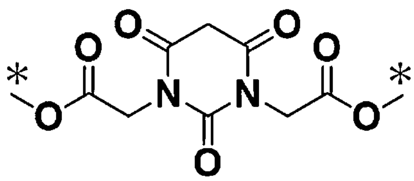

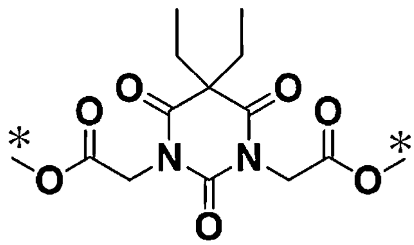

[Chem. 25]

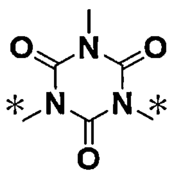 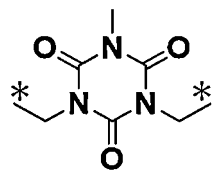 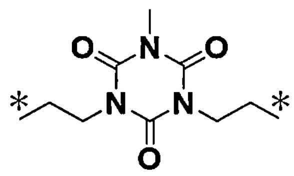

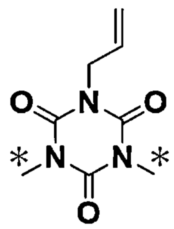 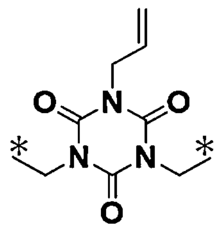 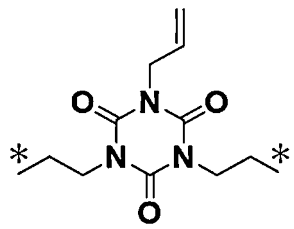

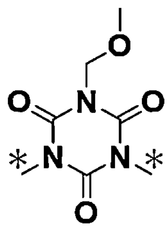 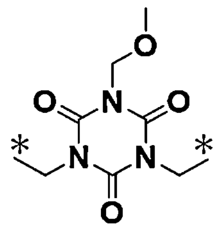 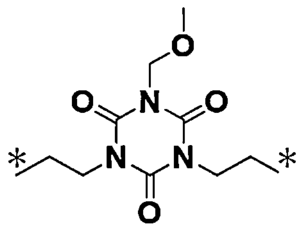

[Chem. 26]

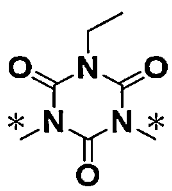 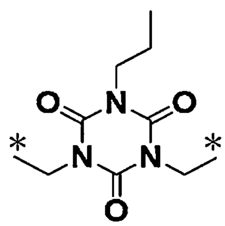 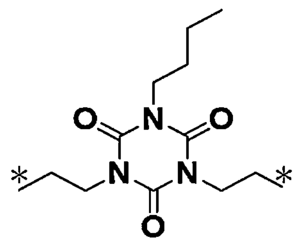

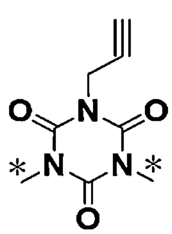 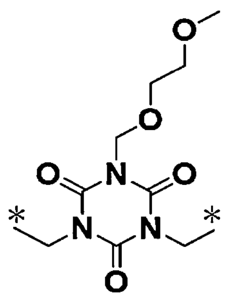 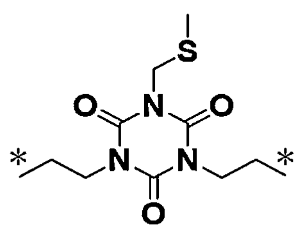

[Chem. 27]

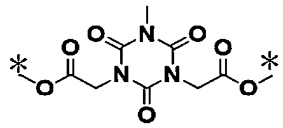
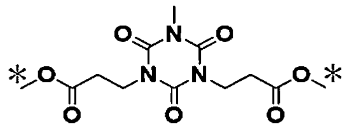
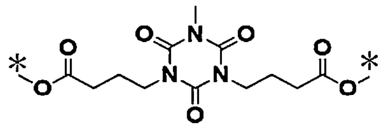

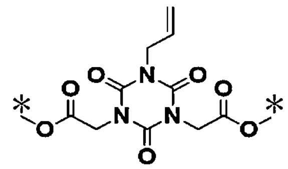
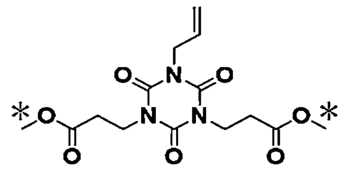
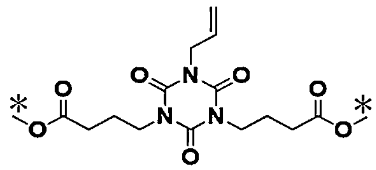

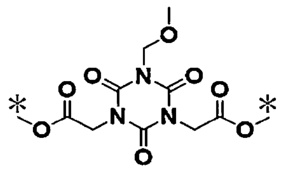
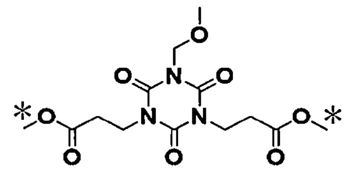
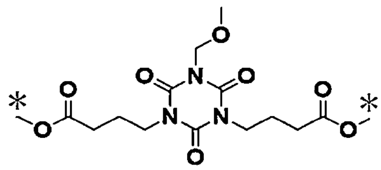

[Chem. 28]

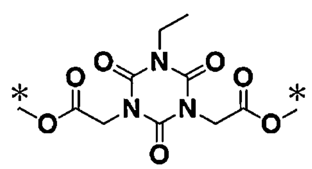
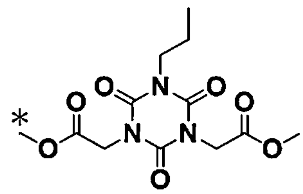
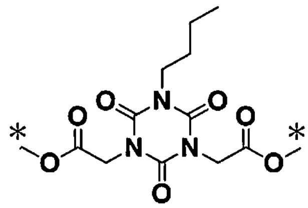

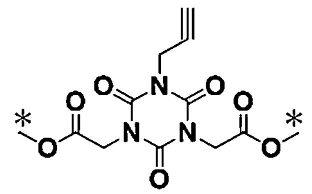
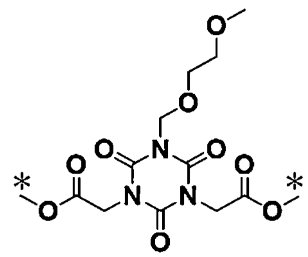
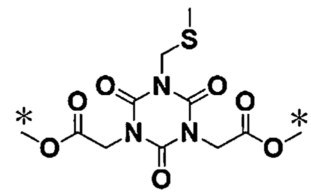

The polymer has, for example, a repeating unit represented by the following formula (X-2-1) as a repeating unit obtained by combining the repeating unit represented by formula (1) and the repeating unit represented by formula (2-1).

The polymer has, for example, a repeating unit represented by the following formula (X-2-2) as a repeating unit obtained by combining the repeating unit represented by formula (1) and the repeating unit represented by formula (2-2).

The polymer has, for example, a repeating unit represented by the following formula (X-3) as a repeating unit obtained by combining the repeating unit represented by formula (1) and the repeating unit represented by formula (3).

[Chem. 29]

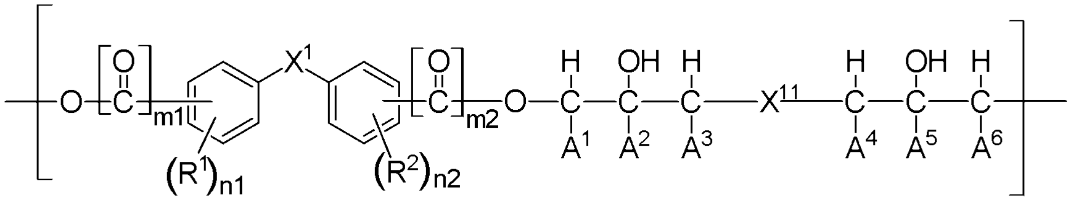

(X-2-1)

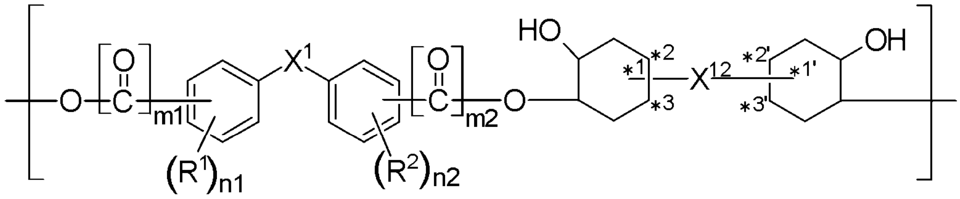

(X-2-2)

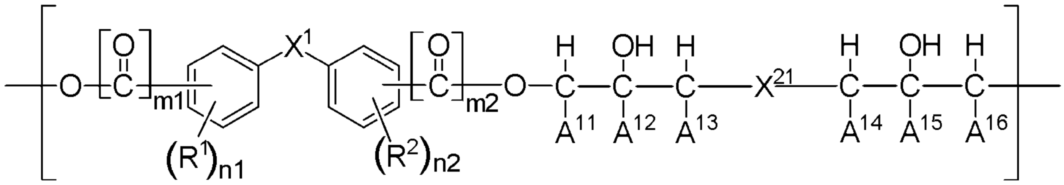

(X-3)

wherein in the formulae (X-2-1), (X-2-2), and (X-3), $X^1$, $R^1$, $R^2$, m1, m2, n1, and n2 have the same meanings as $X^1$, $R^1$, $R^2$, m1, m2, n1, and n2 in the formula (1), respectively;
in the formula (X-2-1), $X^{11}$, $A^1$, $A^2$, $A^3$, $A^4$, $A^5$, and $A^6$ have the same meanings as $X^{11}$, $A^1$, $A^2$, $A^3$, $A^4$, $A^5$, and $A^6$ in the formula (2-1), respectively;
in the formula (X-2-2), $X^{12}$ has the same meaning as $X^{12}$ in the formula (2-2); and
in the formula (X-3), $X^{21}$, $A^{11}$, $A^{12}$, $A^{13}$, $A^{14}$, $A^{15}$, and $A^{16}$ have the same meanings as $X^{21}$, $A^{11}$, $A^{12}$, $A^{13}$, $A^{14}$, $A^{15}$, and $A^{16}$ in the formula (3), respectively.

The polymer has, for example, a repeating unit represented by formula (X-2-1) and a repeating unit represented by formula (X-3).

The polymer has, for example, a repeating unit represented by formula (X-2-2) and a repeating unit represented by formula (X-3).

The molar ratio [(X-2):(X-3)] of the sum (X-2) of the repeating unit (X-2-1) represented by the formula (X-2-1) and the repeating unit (X-2-2) represented by the formula (X-2-2) to the repeating unit (X-3) represented by the formula (X-3) in the polymer is not particularly limited, but is preferably 10:90 to 80:20, more preferably 20:80 to 70:30, and particularly preferably 30:70 to 60:40.

The molar ratio [(X-2-1):(X-3)] of the repeating unit (X-2-1) represented by the formula (X-2-1) to the repeating unit (X-3) represented by the formula (X-3) in the polymer is not particularly limited, but is preferably 10:90 to 80:20, more preferably 20:80 to 70:30, and particularly preferably 30:70 to 60:40.

The molar ratio [(X-2-2):(X-3)] of the repeating unit (X-2-2) represented by the formula (X-2-2) to the repeating unit (X-3) represented by the formula (X-3) in the polymer is not particularly limited, but is preferably 10:90 to 80:20, more preferably 20:80 to 70:30, and particularly preferably 30:70 to 60:40.

The weight average molecular weight of the polymer is, for example, 300 to 100,000, preferably 800 to 50,000, more preferably 1,000 to 10,000, and particularly preferably 1,200 to 5,000.

A method for producing an example of the polymer will be described.

An example of the polymer is obtained, for example, by reaction (I) described below.

(I) Reaction between a compound represented by the following formula (1X), a compound represented by the following formula (2-1X) and/or a compound represented by the following formula (2-2X), and a compound represented by the following formula (3X).

In the reaction (I), other compounds may be used in combination.

[Chem. 30]

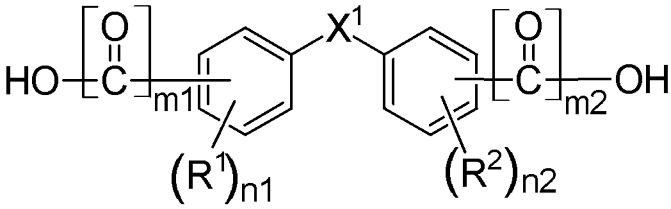

(1X)

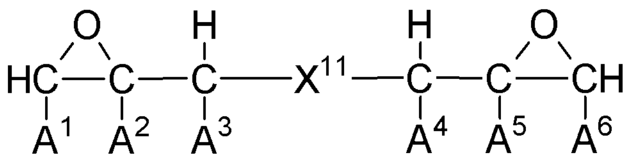

(2-1X)

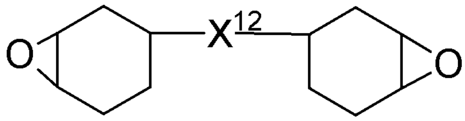

(2-2X)

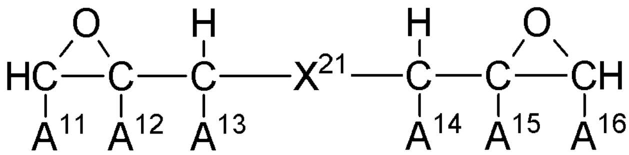

(3X)

wherein in the formula (1X), $X^1$, $R^1$, $R^2$, m1, m2, n1, and n2 have the same meanings as $X^1$, $R^1$, $R^2$, m1, m2, n1, and n2 in the formula (1), respectively;
in the formula (2-1X), $X^{11}$, $A^1$, $A^2$, $A^3$, $A^4$, $A^5$, and $A^6$ have the same meanings as $X^{11}$, $A^1$, $A^2$, $A^3$, $A^4$, $A^5$, and $A^6$ in the formula (2-1), respectively;
in the formula (2-2X), $X^{12}$ has the same meaning as $X^{12}$ in the formula (2-2); and
in the formula (3X), $X^{21}$, $A^{11}$, $A^{12}$, $A^{13}$, $A^{14}$, $A^{15}$, and $A^{16}$ have the same meanings as $X^{21}$, $A^{11}$, $A^{12}$, $A^{13}$, $A^{14}$, $A^{15}$, and $A^{16}$ in formula (3), respectively.

Examples of the compound represented by the formula (1X) include the following compounds:

[Chem. 31]

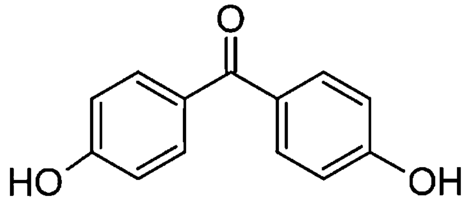

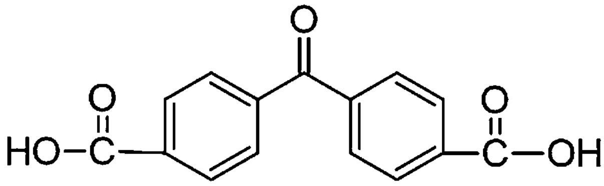

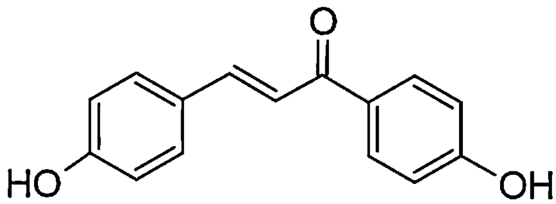

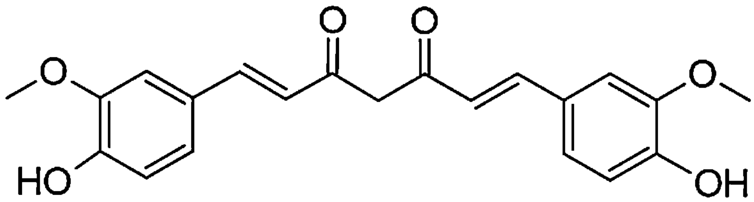

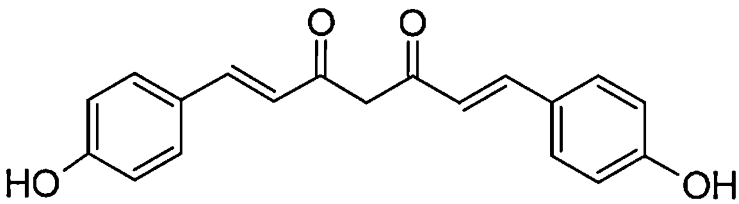

Examples of the compound represented by formula (2-1X) include the following compounds. Note that the compound also includes a polymer compound.

[Chem. 32]

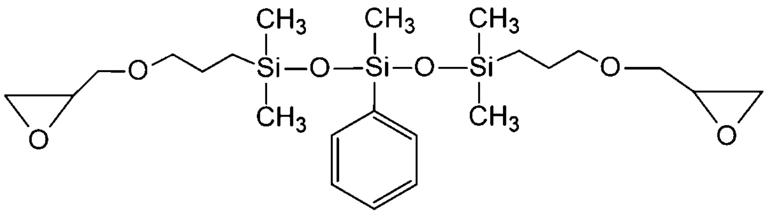

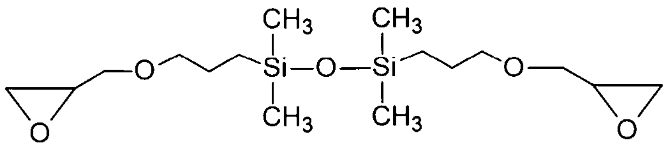

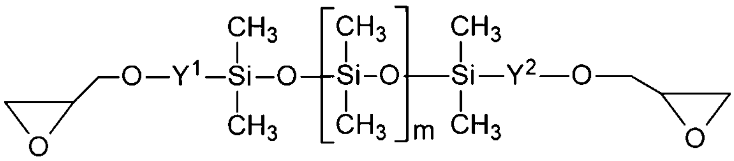

Examples of the compound represented by formula (2-2X) include the following compound:

[Chem. 33]

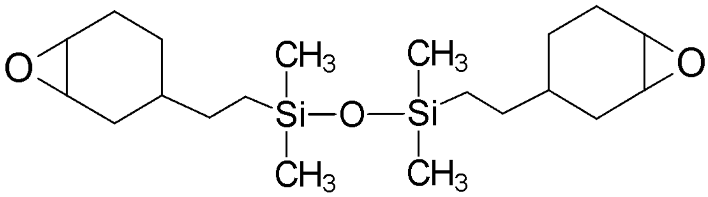

Examples of the compound represented by the formula (3X) include the following compounds:

[Chem. 34]

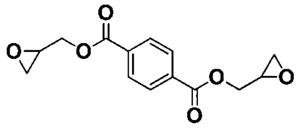 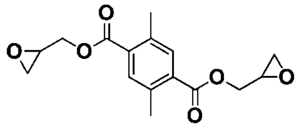 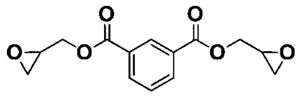 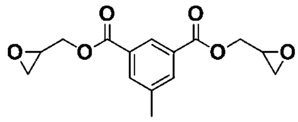

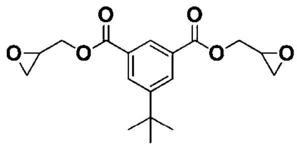 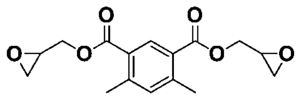 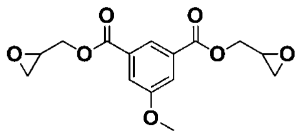 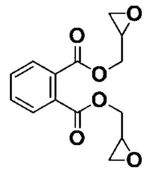

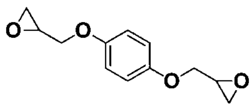 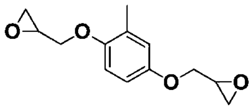 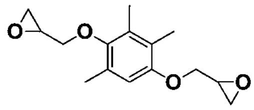 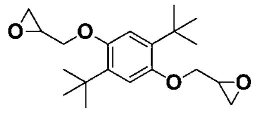

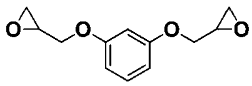 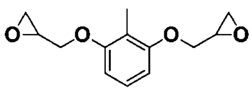 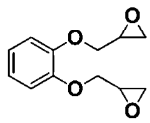 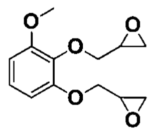

[Chem. 35]

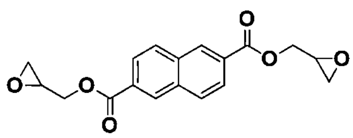 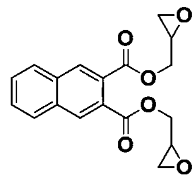 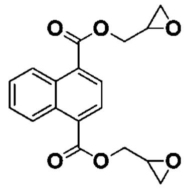 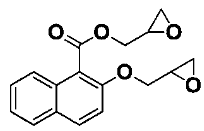

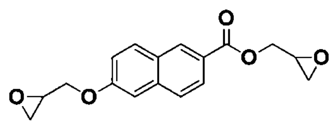 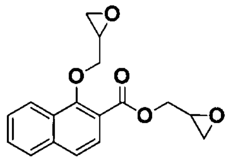 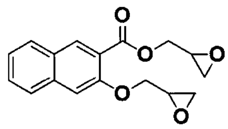 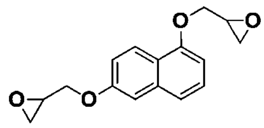

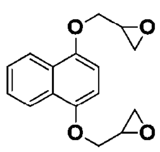 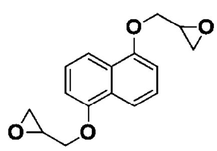 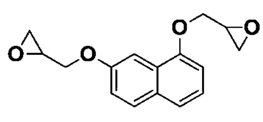 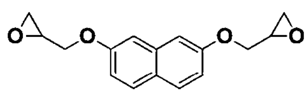

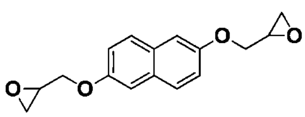 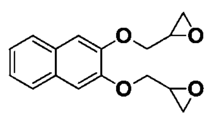

[Chem. 36]

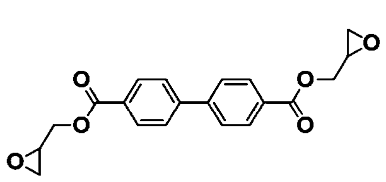

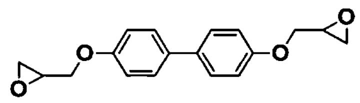

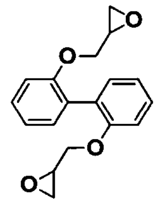

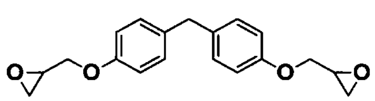

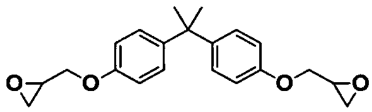

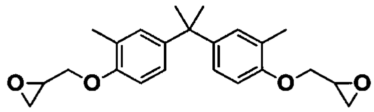

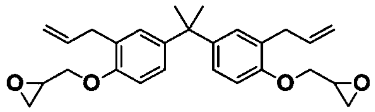

[Chem. 37]

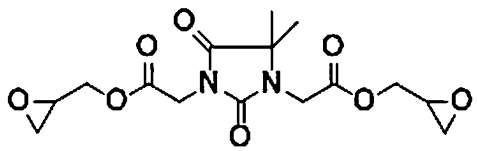

[Chem. 38]

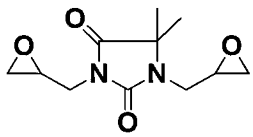

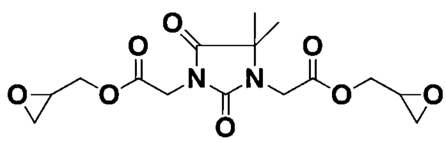

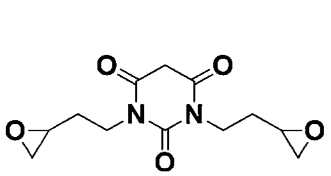

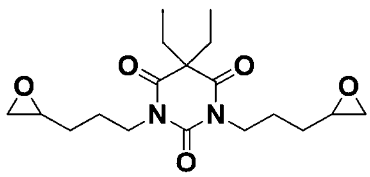

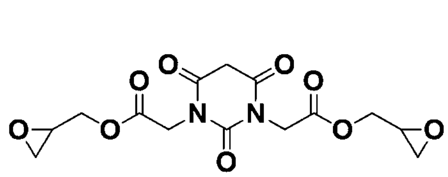

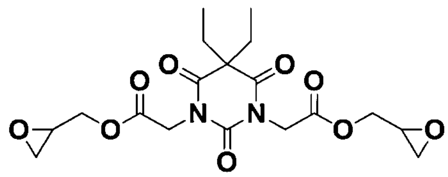

[Chem. 39]

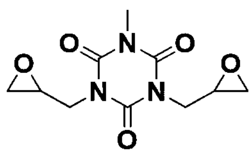
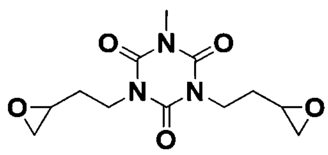
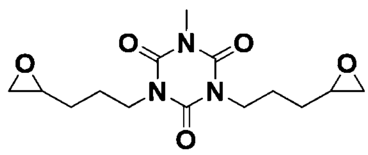

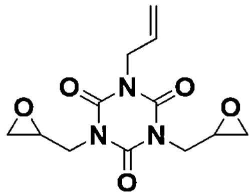
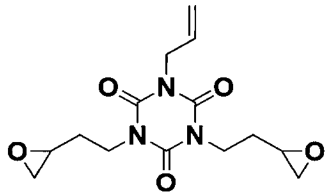
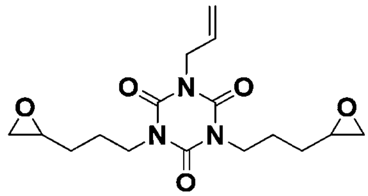

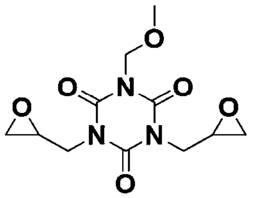
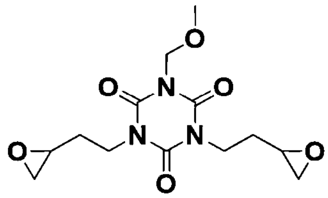
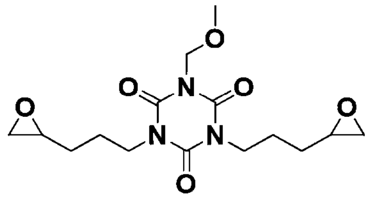

[Chem. 40]

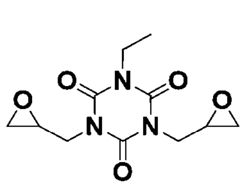
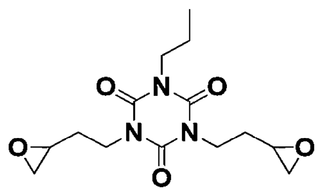
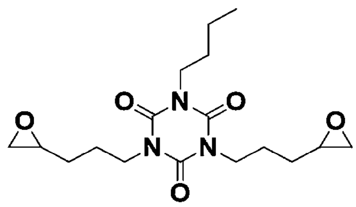

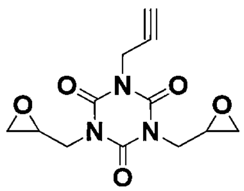
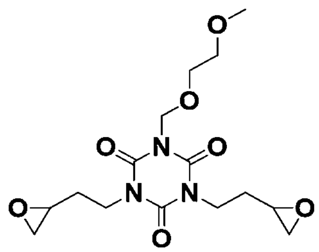
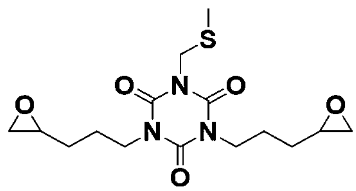

[Chem. 41]

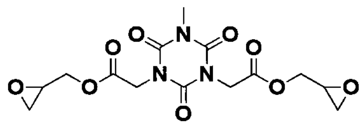
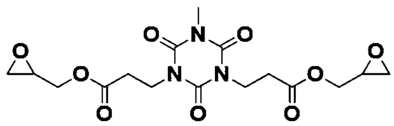
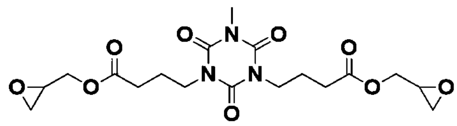

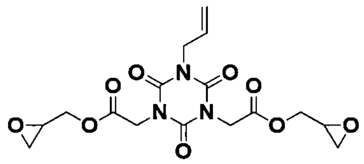
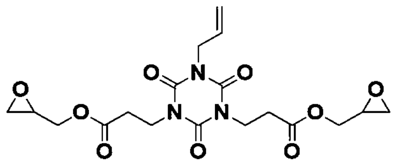
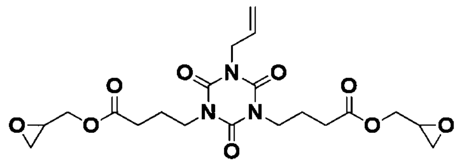

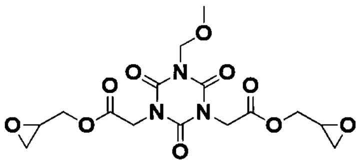
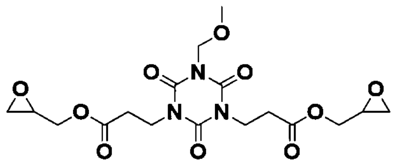
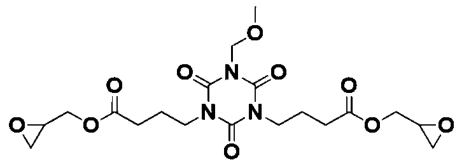

[Chem. 42]

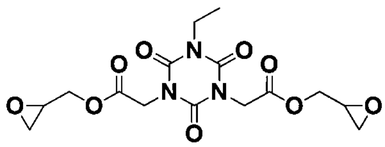
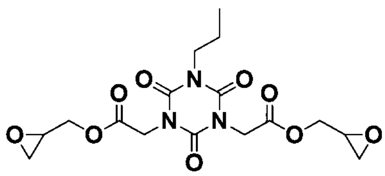
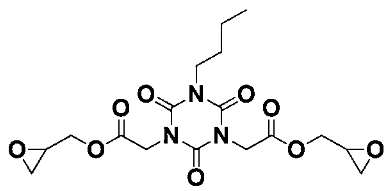

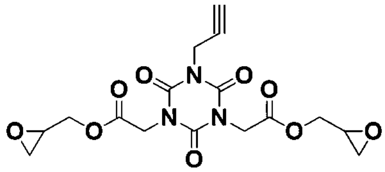
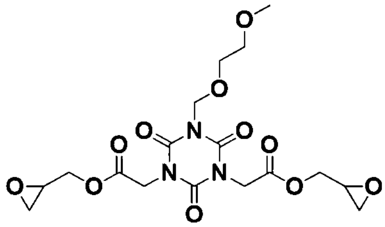
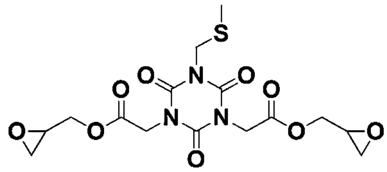

Reaction (I) may be carried out, for example, in the presence of a catalyst. The catalyst is, for example, a quaternary phosphonium salt such as tetrabutylphosphonium bromide or ethyltriphenylphosphonium bromide, or a quaternary ammonium salt such as benzyltriethylammonium chloride. As the amount of the catalyst used, an appropriate amount can be selected and used from a range of 0.1 to 10 mass% with respect to the total mass of a reaction raw material used in the reaction. As the temperature and time for the reaction, for example, optimum conditions can be selected from a range of 80 to 160°C and a range of 2 to 50 hours.

The content of the polymer in the release agent composition is not particularly limited, but is preferably 60 mass% to 100 mass%, more preferably 70 mass% to 100 mass%, and particularly preferably 80 mass% to 100 mass% based on the film constituent components in the release agent composition.

The film constituent components refer to components other than a solvent in the release agent composition.

<Crosslinking Agent>

The release agent composition may contain a crosslinking agent.

The crosslinking agent may cause a crosslinking reaction by self-condensation, but when crosslinkable substituents are present in the above-described polymer, the crosslinking agent can cause a crosslinking reaction with these crosslinkable substituents.

Specific examples of the crosslinking agent are not particularly limited, but typically include phenol-based

crosslinking agents, melamine-based crosslinking agents, urea-based crosslinking agents, thiourea-based crosslinking agents, and the like, each of which has a crosslinking-forming group in the molecule, such as an alkoxymethyl group (for example, a hydroxymethyl group, a methoxymethyl group, or a butoxymethyl group), and these may be low molecular weight compounds or high molecular weight compounds.

The crosslinking agent contained in the release agent composition usually has two or more crosslinking-forming groups, and the number of crosslinking-forming groups contained in a compound as the crosslinking agent is preferably 2 to 10, and more preferably 2 to 6 from the viewpoint of achieving more suitable curing with good reproducibility.

The crosslinking agent contained in the release agent composition preferably has an aromatic ring (for example, a benzene ring or a naphthalene ring) in the molecule from the viewpoint of achieving higher heat resistance, and typical examples of such a crosslinking agent include, but are not limited to, a phenol-based crosslinking agent.

The phenol-based crosslinking agent having a crosslinking-forming group is a compound having a crosslinking-forming group bonded to an aromatic ring and having at least one of a phenolic hydroxy group and an alkoxy group derived from a phenolic hydroxy group, and examples of such an alkoxy group derived from a phenolic hydroxy group include, but are not limited to, a methoxy group and a butoxy group.

Each of the aromatic ring to which the crosslinking-forming group is bonded and an aromatic ring to which the phenolic hydroxy group and/or the alkoxy group derived from a phenolic hydroxy group is bonded is not limited to a noncondensed ring type aromatic ring such as a benzene ring, and may be a condensed ring type aromatic ring such as a naphthalene ring or anthracene.

When a plurality of aromatic rings are present in the molecule of the phenol-based crosslinking agent, the crosslinking-forming group and the phenolic hydroxy group and the alkoxy group derived from a phenolic hydroxy group may be bonded to the same aromatic ring in the molecule or may be bonded to different aromatic rings.

The aromatic ring to which the crosslinking-forming group, the phenolic hydroxy group, and the alkoxy group derived from a phenolic hydroxy group are bonded may be further substituted with an alkyl group such as a methyl group, an ethyl group, or a butyl group, a hydrocarbon group such as an aryl group (for example, a phenyl group), a halogen atom such as a fluorine atom, or the like.

For example, specific examples of the phenol-based crosslinking agent having a crosslinking-forming group include compounds represented by any of formulae (L1) to (L4).

[Chem. 43]

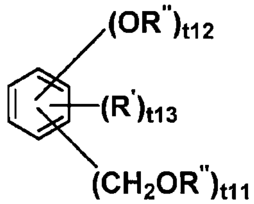

(L1)

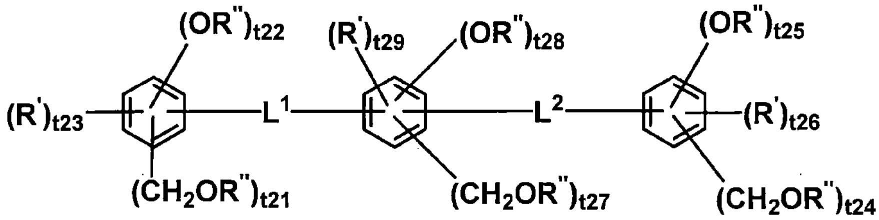

(L2)

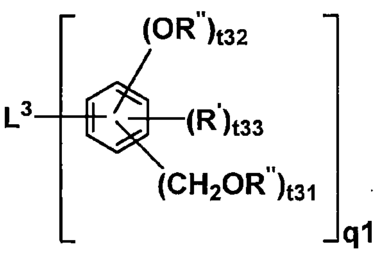

(L3)

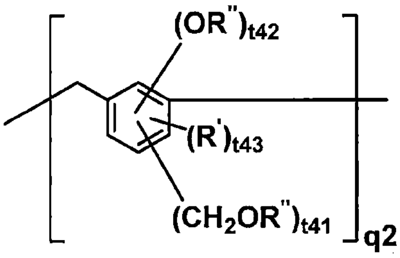

(L4)

In each formula, each R' independently represents a fluorine atom, an aryl group, or an alkyl group, each R'' independently represents a hydrogen atom or an alkyl group, $L^1$ and $L^2$ each independently represent a single bond, a methylene group, or a propane-2,2-diyl group, $L^3$ is determined depending on q1 and represents a single bond, a methylene group, a propane-2,2-diyl group, a methantriyl group, or an ethane-1,1,1-triyl group, t11, t12, and t13 are integers satisfying $2 \leq t11 \leq 5$, $1 \leq t12 \leq 4$, $0 \leq t13 \leq 3$, and $t11 + t12 + t13 \leq 6$, t21, t22, and t23 are integers satisfying $2 \leq t21 \leq 4$, $1 \leq t22 \leq 3$, $0 \leq t23 \leq 2$, and $t21 + t22 + t23 \leq 5$, t24, t25, and t26 are integers satisfying $2 \leq t24 \leq 4$, $1 \leq t25 \leq 3$, $0 \leq t26 \leq 2$, and

t24 + t25 + t26 ≤ 5, t27, t28, and t29 are integers satisfying 0 ≤ t27 ≤ 4, 0 ≤ t28 ≤ 4, 0 ≤ t29 ≤ 4, and t27 + t28 + t29 ≤ 4, t31, t32, and t33 are integers satisfying 2 ≤ t31 ≤ 4, 1 ≤ t32 ≤ 3, 0 ≤ t33 ≤ 2, and t31 + t32 + t33 ≤ 5, t41, t42, and t43 are integers satisfying 2 ≤ t41 ≤ 3, 1 ≤ t42 ≤ 2, 0 ≤ t43 ≤ 1, and t41 + t42 + t43 ≤ 4, q1 is 2 or 3, q2 represents the number of repetitions and is an integer of 0 or more, and specific examples of the aryl group and the alkyl group include those same as the following specific examples, but the aryl group is preferably a phenyl group, and the alkyl group is preferably a methyl group or a t-butyl group.

Hereinafter, specific examples of the compounds represented by formulae (L1) to (L4) will be given, but the compounds are not limited thereto. These compounds may be synthesized by a known method, and can also be obtained, for example, as a product of Asahi Organic Chemical Industry Co., Ltd. or Honshu Chemical Industry Co., Ltd.

[Chem. 44]

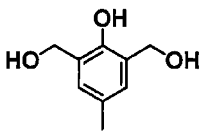

(L1)

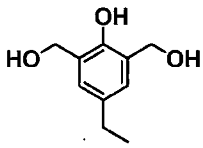

(L2)

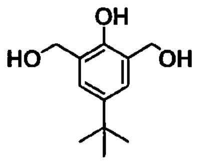

(L3)

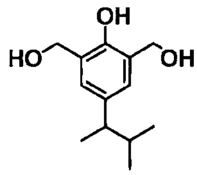

(L4)

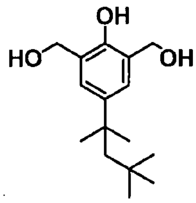

(L5)

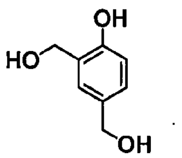

(L6)

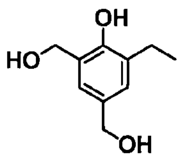

(L7)

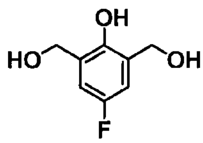

(L8)

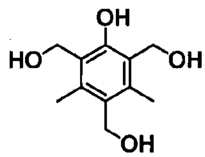

(L9)

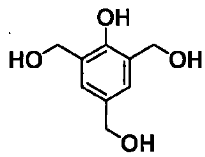

(L10)

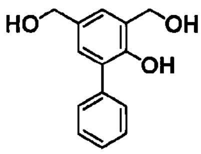

(L11)

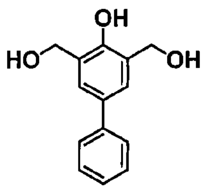

(L12)

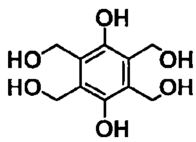

(L13)

[Chem. 45]

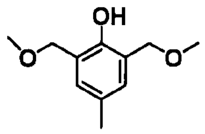
(L1M)

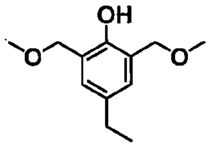
(L2M)

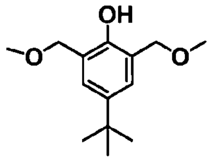
(L3M)

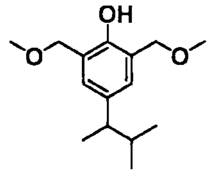
(L4M)

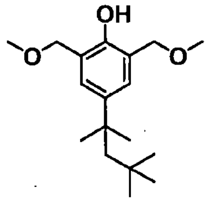
(L5M)

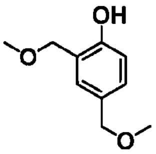
(L6M)

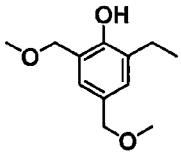
(L7M)

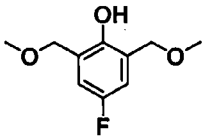
(L8M)

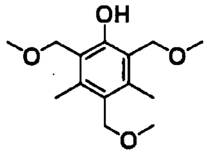
(L9M)

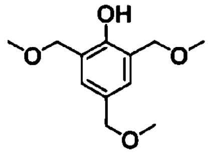
(L10M)

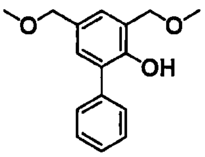
(L11M)

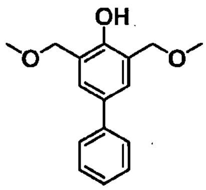
(L12M)

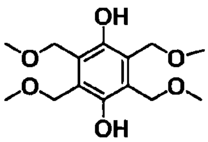
(L13M)

[Chem. 46]

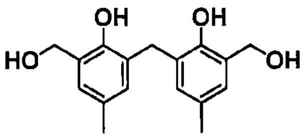
(L14)

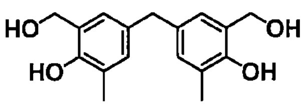
(L15)

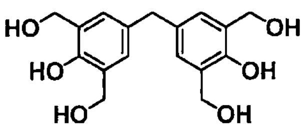
(L16)

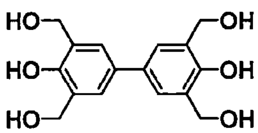
(L17)

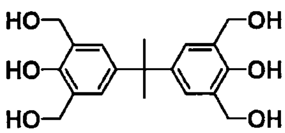
(L18)

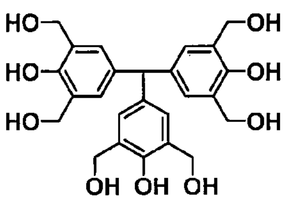
(L19)

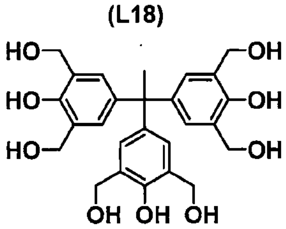
(L20)

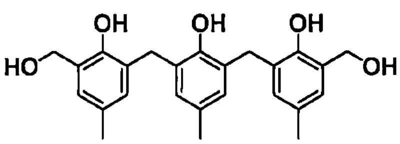
(L21)

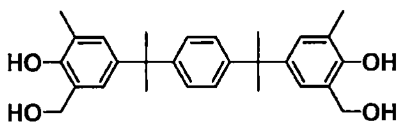
(L22)

[Chem. 47]

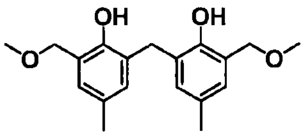

(L14M)

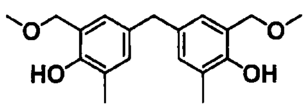

(L15M)

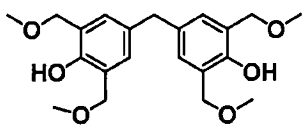

(L16M)

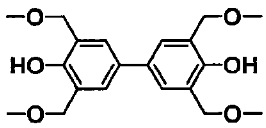

(L17M)

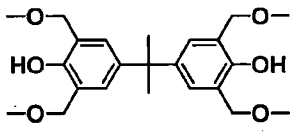

(L18M)

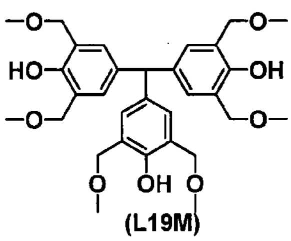

(L19M)

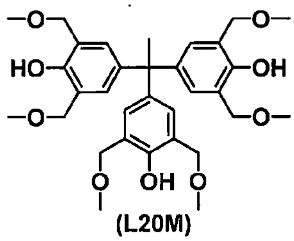

(L20M)

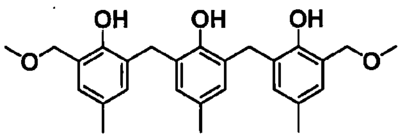

(L21M)

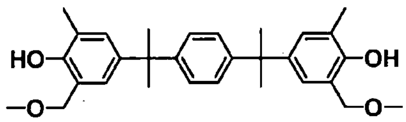

(L22M)

The melamine-based crosslinking agent having a crosslinking-forming group is a melamine derivative, a 2,4-diamino-1,3,5-triazine derivative, or a 2-amino-1,3,5-triazine derivative in which at least one of hydrogen atoms of an amino group bonded to the triazine ring is substituted with a crosslinking-forming group, and the triazine ring may further have a substituent such as an aryl group such as a phenyl group.

Specific examples of the melamine-based crosslinking agent having a crosslinking-forming group include, but are not limited to, mono-, bis-, tris-, tetrakis-, pentakis- or hexakisalkoxymethylmelamines such as N,N,N',N',N",N"-hexakis(methoxymethyl)melamine and N,N,N',N',N",N"-hexakis(butoxymethyl)melamine; and mono-, bis-, tris- or tetrakisalkoxymethylbenzoguanamines such as N,N,N',N'-tetrakis(methoxymethyl)benzoguanamine and N,N,N',N'-tetrakis(butoxymethyl)benzoguanamine.

The urea-based crosslinking agent having a crosslinking-forming group is a derivative of a urea bond-containing compound, and has a structure in which at least one of hydrogen atoms of an NH group constituting a urea bond is substituted with a crosslinking-forming group.

Specific examples of the urea-based crosslinking agent having a crosslinking-forming group include, but are not limited to, mono-, bis-, tris-, or tetrakisalkoxymethylglycolurils such as 1,3,4,6-tetrakis(methoxymethyl)glycoluril and 1,3,4,6-tetrakis(butoxymethyl)glycoluril; and mono-, bis-, tris-, or tetrakisalkoxymethylureas such as 1,3-bis(methoxymethyl)urea and 1,1,3,3-tetrakismethoxymethylurea.

The thiourea-based crosslinking agent having a crosslinking-forming group is a derivative of a thiourea bond-containing compound, and has a structure in which at least one of hydrogen atoms of an NH group constituting a thiourea bond is substituted with a crosslinking-forming group.

Specific examples of the thiourea-based crosslinking agent having a crosslinking-forming group include, but are not limited to, mono-, bis-, tris-, or tetrakisalkoxymethylthioureas such as 1,3-bis(methoxymethyl)thiourea and 1,1,3,3-tetrakismethoxymethylthiourea.

The amount of the crosslinking agent optionally contained in the release agent composition varies depending on the coating method to be employed, the desired film thickness, and the like, and thus cannot be generally specified, but is usually 0.01 to 50 mass% with respect to the polymer, and is preferably 0.1 mass% or more, more preferably 1 mass% or more, still more preferably 3 mass% or more, still more preferably 5 mass% or more, and preferably 45 mass% or less, more preferably 40 mass% or less, still more preferably 35 mass% or less, still more preferably 30 mass% or less from the viewpoint of achieving suitable curing and obtaining a laminate in which a semiconductor substrate or an electronic device

layer and a support substrate can be satisfactorily separated with high reproducibility.

<Acid Generator and Acid>

For the purpose of, for example, promoting the crosslinking reaction, the release agent composition may contain an acid generator or an acid.

Examples of the acid generator include a thermal acid generator and a photoacid generator.

The thermal acid generator is not particularly limited as long as an acid is generated by heat, and specific examples thereof include, but are not limited to, 2,4,4,6-tetrabromocyclohexadienone, benzoin tosylate, 2-nitrobenzyl tosylate, K-PURE [registered trademark] CXC-1612, CXC-1614, TAG-2172, TAG-2179, TAG-2678, TAG2689, and TAG2700 (manufactured by King Industries, Inc.), SI-45, SI-60, SI-80, SI-100, SI-110, and SI-150 (manufactured by Sanshin Chemical Industry Co., Ltd.), and other organic sulfonic acid alkyl esters.

Examples of the photoacid generator include an onium salt compound, a sulfonimide compound, and a disulfonyl diazomethane compound.

Specific examples of the onium salt compound include, but are not limited to, iodonium salt compounds such as diphenyliodonium hexafluorophosphate, diphenyliodonium trifluoromethanesulfonate, diphenyliodonium nonafluoronormal butanesulfonate, diphenyliodonium perfluoronormal octanesulfonate, diphenyliodonium camphor sulfonate, bis(4-tert-butylphenyl)iodonium camphor sulfonate, and bis(4-tert-butylphenyl)iodonium trifluoromethanesulfonate; and sulfonium salt compounds such as triphenylsulfonium nitrate, triphenylsulfonium hexafluoroantimonate, triphenylsulfonium nonafluoro-normal butanesulfonate, triphenylsulfonium camphorsulfonate, and triphenylsulfonium trifluoromethanesulfonate.

Specific examples of the sulfonimide compound include, but are not limited to, N-(trifluoromethanesulfonyloxy) succinimide, N-(nonafluoronormalbutanesulfonyloxy)succinimide, N-(camphorsulfonyloxy)succinimide, and N-(trifluoromethanesulfonyloxy)naphthalimide.

Specific examples of the disulfonyl diazomethane compound include, but are not limited to, bis(trifluoromethylsulfonyl)diazomethane, bis(cyclohexylsulfonyl)diazomethane, bis(phenylsulfonyl)diazomethane, bis(p-toluenesulfonyl) diazomethane, bis(2,4-dimethylbenzenesulfonyl)diazomethane, and methylsulfonyl-p-toluenesulfonyl diazomethane.

Specific examples of the acid include, but are not limited to, arylsulfonic acids and pyridinium salts such as p-toluenesulfonic acid, pyridinium p-toluenesulfonate(pyridinium paratoluenesulfonate), pyridinium trifluoromethanesulfonate, pyridinium phenolsulfonic acid, 5-sulfosalicylic acid, 4-phenolsulfonic acid, 4-chlorobenzenesulfonic acid, benzenedisulfonic acid, and 1-naphthalenesulfonic acid, and salts thereof; arylcarboxylic acids such as salicylic acid, benzoic acid, hydroxybenzoic acid, and naphthalenecarboxylic acid, and salts thereof; linear or cyclic alkylsulfonic acids such as trifluoromethanesulfonic acid and camphorsulfonic acid, and salts thereof; and linear or cyclic alkylcarboxylic acids such as citric acid, and salts thereof.

The amounts of the acid generator and the acid contained in the release agent composition cannot be generally specified because the amounts vary depending on the type of the crosslinking agent to be optionally used together, the heating temperature at the time of forming the film, and the like, but are usually 0.01% to 5% by mass with respect to the film constituent components.

<Surfactant>

The release agent composition may contain a surfactant for the purpose of, for example, adjusting the liquid physical properties of the composition itself or the film physical properties of the obtained film, or preparing a highly uniform release agent composition with high reproducibility.

Examples of the surfactant may include nonionic surfactants such as polyoxyethylene alkyl ethers (for example, polyoxyethylene lauryl ether, polyoxyethylene stearyl ether, polyoxyethylene cetyl ether, and polyoxyethylene oleyl ether), polyoxyethylene alkyl allyl ethers (for example, polyoxyethylene octylphenol ether and polyoxyethylene nonylphenol ether), polyoxyethylene/polyoxypropylene block copolymers, sorbitan fatty acid esters (for example, sorbitan monolaurate, sorbitan monopalmitate, sorbitan monostearate, sorbitan monooleate, sorbitan trioleate, and sorbitan tristearate), and polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate, fluorine surfactants such as EFTOP EF301, EF303, and EF352 (manufactured by Tohkemy Corporation, trade name), MEGAFACE F171, F173, R-30, and R-30N (manufactured by DIC Corporation, trade name), FLUORAD FC430 and FC431 (manufactured by Sumitomo 3M Ltd., trade name), ASAHIGUARD AG710, SURFLON S-382, SC101, SC102, SC103, SC104, SC105, and SC106 (manufactured by AGC Inc., trade name), and organosiloxane polymer KP341 (manufactured by Shin-Etsu Chemical Co., Ltd.).

Surfactants can be used alone or in combination of two or more thereof.

The amount of the surfactant is usually 2% by mass or less with respect to the film constituent components of the

release agent composition.

<Solvent>

The release agent composition contains a solvent.

As a solvent, it is possible to use, for example, a highly polar solvent capable of satisfactorily dissolving film constituent components such as the above-described polymer and a crosslinking agent, and it is also possible to use, as necessary, a less polar solvent for the purpose of adjusting, for instance, the viscosity and the surface tension. In the present invention, the low-polarity solvent is defined as a solvent having a relative permittivity of less than 7 at a frequency of 100 kHz, and the high-polarity solvent is defined as a solvent having a relative permittivity of 7 or more at a frequency of 100 kHz. The solvents can be used alone or in combination of two or more thereof.

Examples of the high-polarity solvent include amidebased solvents such as N,N-dimethylformamide, N,N-dimethylacetamide, N,N-dimethylisobutyramide, N-methylpyrrolidone, and 1,3-dimethyl-2-imidazolidinone; ketone-based solvent such as ethyl methyl ketone, isophorone, or cyclohexanone; cyano solvents such as acetonitrile and 3-methoxypropionitrile; polyhydric alcohol-based solvent such as ethylene glycol, diethylene glycol, triethylene glycol, dipropylene glycol, 1,3-butanediol, or 2,3-butanediol;

a monohydric alcohol-based solvent, other than aliphatic alcohols (for example, propylene glycol monomethyl ether, diethylene glycol monomethyl ether, diethylene glycol monophenyl ether, triethylene glycol monomethyl ether, dipropylene glycol monomethyl ether, benzyl alcohol, 2-phenoxyethanol, 2-benzyloxyethanol, 3-phenoxybenzyl alcohol, and tetrahydrofurfuryl alcohol); and sulfoxide-based solvents such as dimethyl sulfoxide.

Examples of the low-polarity solvent include chlorinebased solvents such as chloroform and chlorobenzene; aromatic hydrocarbon-based solvents such as alkylbenzenes (for example, toluene, xylene, tetralin, cyclohexylbenzene, and decylbenzene); aliphatic alcohol-based solvents such as 1-octanol, 1-nonanol, and 1-decanol; ether-based solvent such as tetrahydrofuran, dioxane, anisole, 4-methoxytoluene, 3-phenoxytoluene, dibenzyl ether, diethylene glycol dimethyl ether, diethylene glycol butyl methyl ether, triethylene glycol dimethyl ether, or triethylene glycol butyl methyl ether; and ester-based solvents such as methyl benzoate, ethyl benzoate, butyl benzoate, isoamyl benzoate, bis(2-ethylhexyl)phthalate, dibutyl maleate, dibutyl oxalate, hexyl acetate, propylene glycol monomethyl ether acetate, diethylene glycol monoethyl ether acetate, and diethylene glycol monobutyl ether acetate.

The content of the solvent is appropriately determined in consideration of the viscosity of the desired composition, the coating method to be adopted, the thickness of the film to be prepared, and the like, but is 99% by mass or less with respect to the entire composition, preferably 70 to 99% by mass with respect to the entire composition, more preferably 85 to 97% by mass with respect to the entire composition, that is, the amount of the film constituent components in that case is preferably 1 to 30% by mass with respect to the entire composition, and more preferably 3 to 15% by mass with respect to the entire composition.

The viscosity and surface tension of the release agent composition are appropriately adjusted by changing the type of the solvent to be used, the ratio thereof, the concentration of the film constituent components, and the like in consideration of various factors such as the coating method to be used and the desired film thickness.

In an aspect of the present invention, the release agent composition contains a glycol-based solvent from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like. The "glycol-based solvent" as used herein is a generic term for glycols, glycol monoethers, glycol diethers, glycol monoesters, glycol diesters, and glycol ester ethers.

An example of a preferred glycol-based solvent is represented by formula (G).

[Chem. 48]

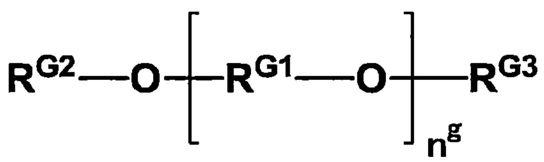

(G)

In formula (G), $R^{G1}$ each independently represents a linear or branched $C_{2-4}$ alkylene group, $R^{G2}$ and $R^{G3}$ each independently represent a hydrogen atom, a linear or branched $C_{1-8}$ alkyl group, or an alkylacyl group in which the alkyl portion is a linear or branched $C_{1-8}$ alkyl group, and $n^g$ is an integer of 1 to 6.

Specific examples of the $C_{2-4}$ linear or branched alkylene group include, but are not limited to, an ethylene group, a trimethylene group, a 1-methylethylene group, a tetramethylene group, a 2-methylpropane-1, 3-diyl group, a pentamethylene group, or a hexamethylene group.

Among them, a $C_{2-3}$ linear or branched alkylene group is preferable and a $C_3$ linear or branched alkylene group is more preferable, for example, from the viewpoint of reproducibly obtaining a highly uniform composition, from the viewpoint of reproducibly obtaining a highly storage stable composition, and from the viewpoint of reproducibly obtaining a composition that provides a highly uniform film.

Specific examples of the linear or branched $C_{1-8}$ alkyl group include, but are not limited to, a methyl group, an ethyl group, a n-propyl group, an i-propyl group, a n-butyl group, an i-butyl group, a s-butyl group, a tert-butyl group, a n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1 methyl-n-propyl group, or a 1-ethyl-2-methyl-n-propyl group.

Among them, a methyl group and an ethyl group are preferable, and a methyl group is more preferable from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

Specific examples of the $C_{1-8}$ linear or branched alkyl group in the alkylacyl group in which the alkyl moiety is a $C_{1-8}$ linear or branched alkyl group include the same as the specific examples described above.

Among them, a methylcarbonyl group and an ethylcarbonyl group are preferable, and a methylcarbonyl group is more preferable from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

$n^g$ is preferably 4 or less, more preferably 3 or less, still more preferably 2 or less, and most preferably 1 from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

In formula (G), preferably, at least one of $R^{G2}$ or $R^{G3}$ is a linear or branched $C_{1-8}$ alkyl group, more preferably, one of $R^{G2}$ and $R^{G3}$ is a linear or branched $C_{1-8}$ alkyl group, and the other is an alkylacyl group in which a hydrogen atom or an alkyl moiety is a linear or branched $C_{1-8}$ alkyl group from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

The content of the glycol-based solvent is preferably 50 mass% or more, more preferably 70 mass% or more, still more preferably 80 mass% or more, further preferably 90 mass% or more, and even more preferably 95 mass% or more with respect to the solvent contained in the release agent composition from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

In the release agent composition, the film constituent components are uniformly dispersed or dissolved, preferably dissolved in the solvent from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

In the present invention, for the purpose of removing foreign matter, a solvent, a solution, or the like to be used may be filtered using a filter or the like during the production of the release agent composition or after mixing all the components.

(Laminate)

The laminate according to the present invention includes a semiconductor substrate or an electronic device layer, a support substrate, and a release agent layer for release by irradiation with light.

The laminate according to the present invention preferably further includes an adhesive layer, and includes a semiconductor substrate or an electronic device layer, a support substrate, a release agent layer for release by irradiation with light, and an adhesive layer.

Note that when the release agent layer according to the present invention is formed to have not only a release function of releasing the semiconductor substrate or the electronic device layer from the support substrate by irradiation with light but also an adhesion function of adhering the semiconductor substrate or the electronic device layer to the support substrate (that is, when the release agent layer is formed using a release agent composition containing a component that exhibits both functions), the laminate may be formed not in a two-layer configuration of the release agent

layer and the adhesive layer but in a one-layer configuration of the release agent layer having adhesive performance.

The support substrate has light transmissivity.

The release agent layer for release by irradiation with light is provided between the semiconductor substrate or the electronic device layer and the support substrate.

The laminate is used for release of the semiconductor substrate or the electronic device layer from the support substrate after the release agent layer absorbs light emitted from the support substrate side.

The release agent layer for light irradiation release is a layer formed of the release agent composition for light irradiation release of the present invention described above.

The laminate of the present invention is used for temporary adhesion for processing the semiconductor substrate or the electronic device layer, and can be suitably used for processing such as thinning of the semiconductor substrate or the electronic device layer.

While the semiconductor substrate is subjected to processing such as thinning, the semiconductor substrate is supported by the support substrate. On the other hand, after the processing of the semiconductor substrate, the release agent layer is irradiated with light, and thereafter, the support substrate and the semiconductor substrate are separated from each other. Due to the polymer contained in the release agent composition, in the release agent layer formed from the release agent composition, the polymer (in particular, the first structure) absorbs light (for example, laser light) to change properties (for example, separation or decomposition) of the release agent layer. As a result, after the release agent layer is irradiated with light, the semiconductor substrate is easily released from the support substrate.

In addition, while the electronic device layer is subjected to processing such as thinning, the electronic device layer is supported by the support substrate. On the other hand, after the processing of the electronic device layer, the release agent layer is irradiated with light, and thereafter, the support substrate and the electronic device layer are separated from each other.

Owing to the release agent layer according to the present invention, the semiconductor substrate or the electronic device layer is easily released from the support substrate after being irradiated with light. Furthermore, after the semiconductor substrate or the electronic device layer is released from the support substrate, residues of the release agent layer or the adhesive layer remaining on the semiconductor substrate, the electronic device layer, or the support substrate can be removed by, for example, a cleaning agent composition for cleaning the semiconductor substrate and the like.

The wavelength of light used for release is preferably, for example, a wavelength of 250 to 600 nm, and more preferably a wavelength of 250 to 370 nm. A more suitable wavelength is 308 nm, 343 nm, 355 nm, 365 nm, or 532 nm. The irradiation amount of light required for release is an irradiation amount that can cause suitable alteration, for example, decomposition of the first structure in the release agent layer.

The light used for release may be laser light or nonlaser light emitted from a light source such as an ultraviolet lamp.

Hereinafter, a case where the laminate includes a semiconductor substrate and a case where the laminate includes an electronic device layer will be described in detail separately.

The case where the laminate includes a semiconductor substrate will be described in the following <First Embodiment>, and the case where the laminate includes an electronic device layer will be described in the following

<Second Embodiment>.

<First Embodiment>

The laminate having a semiconductor substrate is used for processing the semiconductor substrate. While the semiconductor substrate is processed, the semiconductor substrate is adhered to the support substrate. After processing the semiconductor substrate, the release agent layer is irradiated with light, and then the semiconductor substrate is separated from the support substrate.

<<Semiconductor Substrate>>

The main material constituting the entire semiconductor substrate is not particularly limited as long as the material is used for this type of application, and examples thereof include silicon, silicon carbide, and a compound semiconductor.

The shape of the semiconductor substrate is not particularly limited, and is, for example, a disk shape. The disk-shaped semiconductor substrate does not need to have a completely circular surface, and for example, the outer periphery of the semiconductor substrate may have a linear portion called an orientation flat or may have a cut called a notch.

The thickness of the disk-shaped semiconductor substrate may be appropriately determined depending on the purpose of use of the semiconductor substrate and the like, and is not particularly limited, and for example, 500 to 1,000

μm.

The diameter of the disk-shaped semiconductor substrate may be appropriately determined depending on the purpose of use of the semiconductor substrate and the like, and is not particularly limited, and for example, 100 to 1,000 mm.

The semiconductor substrate may have a bump. The bump is a protruding terminal.

In the laminate, when the semiconductor substrate has a bump, the semiconductor substrate has the bump on the support substrate side.

In the semiconductor substrate, the bump is usually formed on a surface on which a circuit is formed. The circuit may be a single layer or a multilayer. The shape of the circuit is not particularly limited.

In the semiconductor substrate, a surface (back surface) opposite to the surface having the bump is a surface to be processed.

The material, size, shape, structure, and density of the bump of the semiconductor substrate are not particularly limited.

Examples of the bump include a ball bump, a print bump, a stud bump, and a plating bump.

Usually, the height, radius, and pitch of the bump are appropriately determined from the conditions of a bump height of approximately 1 to 200 μm, a bump radius of 1 to 200 μm, and a bump pitch of 1 to 500 μm.

Examples of the material of the bump include low melting point solder, high melting point solder, tin, indium, gold, silver, and copper. The bump may contain only a single component or may contain a plurality of components. More specific examples thereof include alloy plating mainly containing Sn, such as SnAg bumps, SnBi bumps, Sn bumps, and AuSn bumps.

In addition, the bump may have a laminated structure including a metal layer made of at least one of these components.

An example of the semiconductor substrate is a silicon wafer having a diameter of about 300 mm and a thickness of about 770 μm.

<<Support Substrate>>

The support substrate is not particularly limited as long as the support substrate is a member that is light-transmissive to light irradiated onto the release agent layer and can support the semiconductor substrate when the semiconductor substrate is processed, and examples thereof include a glass support substrate.

The shape of the support substrate is not particularly limited, and examples thereof include a disk shape.

The thickness of the disk-shaped support substrate may be appropriately determined depending on the size of the semiconductor substrate and the like, and is not particularly limited, but is, for example, 500 to 1,000 μm.

The diameter of the disk-shaped support substrate may be appropriately determined depending on the size of the semiconductor substrate and the like, and is not particularly limited, and is, for example, 100 to 1,000 mm.

An example of the support substrate is a glass wafer having a diameter of about 300 mm and a thickness of about 700 μm.

<<Release Agent Layer>>

The release agent layer is a layer formed of a release agent composition.

The release agent layer is provided between the semiconductor substrate and the support substrate.

The release agent layer may be in contact with the support substrate or may be in contact with the semiconductor substrate.

The release agent layer is formed using the release agent composition for light irradiation release of the present invention described above.

The release agent composition of the present invention can be suitably used for forming the release agent layer of a laminate including a semiconductor substrate, a support substrate, and a release agent layer provided between the semiconductor substrate and the support substrate. The laminate is used for release of the semiconductor substrate from the support substrate after the release agent layer absorbs light irradiated from the support substrate side.

One of the characteristics of the release agent layer obtained from the release agent composition of the present invention is that the semiconductor substrate can be easily released from the support substrate after irradiation with light.

The thickness of the release agent layer is not particularly limited, and is ordinarily 0.01 to 10 μm, and is preferably 0.03 μm or more, more preferably 0.05 μm or more, and still more preferably 0.1 μm or more, from the viewpoint of maintaining the film strength, and is preferably 8 μm or less, more preferably 5 μm or less, still more preferably 2 μm or less, and yet still more preferably 1 μm or less, from the viewpoint of avoiding non-uniformity caused by a thick film.

The method for forming the release agent layer from the release agent composition will be described in detail in the description of <<Method for producing one example of laminate in first embodiment>> described below.

<<Adhesive Layer>>

The adhesive layer is provided between the support substrate and the semiconductor substrate.

The adhesive layer is in contact with, for example, the semiconductor substrate. The adhesive layer may be in contact with, for example, the support substrate.

The adhesive layer is not particularly limited, but is preferably a layer formed of an adhesive composition.

<<Adhesive Composition>>

Examples of the adhesive composition include, but are not limited to, a polysiloxane-based adhesive, an acrylic resin-based adhesive, an epoxy resin-based adhesive, a polyamide-based adhesive, a polystyrene-based adhesive, a polyimide adhesive, and a phenolic resin-based adhesive.

Among them, a polysiloxane-based adhesive is preferable as the adhesive composition because the adhesive composition exhibits suitable adhesive function during processing of the semiconductor substrate or the like, can be suitably released after processing, is further excellent in heat resistance, and can be suitably removed by the cleaning agent composition.

In a preferable aspect, the adhesive composition contains a polyorganosiloxane.

In another preferred aspect, the adhesive composition contains a component that cures by a hydrosilylation reaction.

For example, the adhesive composition used in the present invention contains a curable component (A) to be an adhesive component. The adhesive composition used in the present invention may contain a component (A) to be cured to be an adhesive component and a component (B) that does not cause a curing reaction. Here, examples of the component (B) that does not cause a curing reaction include a polyorganosiloxane. Note that in the present invention, the wording "does not cause a curing reaction" does not mean not causing any curing reaction, but means not causing a curing reaction occurring in the curable component (A).

In a preferred aspect, the component (A) may be a component to be cured by a hydrosilylation reaction or a polyorganosiloxane component (A') to be cured by a hydrosilylation reaction.

In another preferred aspect, the component (A) contains, for example, as an example of the component (A'), a polyorganosiloxane (a1) having a $C_{2-40}$ alkenyl group bonded to a silicon atom, a polyorganosiloxane (a2) having an Si-H group, and a platinum group metal-based catalyst (A2). Here, the $C_{2-40}$ alkenyl group may be substituted. Examples of the substituent include a halogen atom, a nitro group, a cyano group, an amino group, a hydroxy group, a carboxyl group, an aryl group, and a heteroaryl group.

In another preferable aspect, the polyorganosiloxane component (A') that is cured by a hydrosilylation reaction includes a polysiloxane (A1) containing one or two or more units selected from the group consisting of a siloxane unit (Q unit) represented by $SiO_2$, a siloxane unit (M unit) represented by $R^1R^2R^3SiO_{1/2}$, a siloxane unit (D unit) represented by $R^4R^5SiO_{2/2}$, and a siloxane unit (T unit) represented by $R^6SiO_{3/2}$, and a platinum group metal-based catalyst (A2). The polysiloxane (A1) includes: a polyorganosiloxane (a1') containing one or two or more units selected from the group consisting of a siloxane unit (Q' unit) represented by $SiO_2$, a siloxane unit (M' unit) represented by $R^{1'}R^{2'}R^{3'}SiO_{1/2}$, a siloxane unit (D' unit) represented by $R^{4'}R^{5'}SiO_{2/2}$, and a siloxane unit (T' unit) represented by $R^{6'}SiO_{3/2}$, and also containing at least one selected from the group consisting of M' unit, D' unit, and T' unit, and a polyorganosiloxane (a2') containing one or two or more units selected from the group consisting of a siloxane unit (Q" unit) represented by $SiO_2$, a siloxane unit (M" unit) represented by $R^{1''}R^{2''}R^{3''}SiO_{1/2}$, a siloxane unit (D" unit) represented by $R^{4''}R^{5''}SiO_{2/2}$, and a siloxane unit (T" unit) represented by $R^{6''}SiO_{3/2}$, and also containing at least one selected from the group consisting of M" unit, D" unit, and T" unit.

Note that (a1') is an example of (a1), and (a2') is an example of (a2).

$R^1$ to $R^6$ are groups or atoms bonded to a silicon atom, and each independently represent an optionally substituted alkyl group, an optionally substituted alkenyl group, or a hydrogen atom. Examples of the substituent include a halogen atom, a nitro group, a cyano group, an amino group, a hydroxy group, a carboxyl group, an aryl group, and a heteroaryl group.

$R^{1'}$ to $R^{6'}$ are groups bonded to a silicon atom and each independently represent an optionally substituted alkyl group or an optionally substituted alkenyl group, provided that at least one of $R^{1'}$ to $R^{6'}$ is an optionally substituted alkenyl group. Examples of the substituent include a halogen atom, a nitro group, a cyano group, an amino group, a hydroxy group, a carboxyl group, an aryl group, and a heteroaryl group.

$R^{1''}$ to $R^{6''}$ are groups or atoms bonded to a silicon atom, and each independently represent an optionally substituted alkyl group or a hydrogen atom, provided that at least one of $R^{1''}$ to $R^{6''}$ is a hydrogen atom. Examples of the substituent include a halogen atom, a nitro group, a cyano group, an amino group, a hydroxy group, a carboxyl group, an aryl group, and a heteroaryl group.

The alkyl group may be linear, branched, or cyclic, and is preferably a linear or branched alkyl group. The number

of carbon atoms thereof is not particularly limited, and is usually 1 to 40, preferably 30 or less, more preferably 20 or less, and still more preferably 10 or less.

Specific examples of the optionally substituted linear or branched alkyl group include, but are not limited to, a methyl group, an ethyl group, an n-propyl group, an i-propyl group, an n-butyl group, an i-butyl group, an s-butyl group, a tertiary butyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group, and the number of carbon atoms thereof is usually 1 to 14, preferably 1 to 10, and more preferably 1 to 6. Among them, a methyl group is particularly preferable.

Specific examples of the optionally substituted cyclic alkyl group include, but are not limited to, cycloalkyl groups such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group; and a bicycloalkyl group such as a bicyclobutyl group, a bicyclopentyl group, a bicyclohexyl group, a bicycloheptyl group, a bicyclooctyl group, a bicyclononyl group, and a bicyclodecyl group, and the number of carbon atoms thereof is usually 3 to 14, preferably 4 to 10, and more preferably 5 to 6.

The alkenyl group may be linear or branched, and the number of carbon atoms thereof is not particularly limited, and is usually 2 to 40, preferably 30 or less, more preferably 20 or less, and still more preferably 10 or less.

Specific examples of the optionally substituted linear or branched alkenyl group include, but are not limited to, a vinyl group, an allyl group, a butenyl group, and a pentenyl group, and the number of carbon atoms thereof is usually 2 to 14, preferably 2 to 10, and more preferably 1 to 6. Among them, an ethenyl group and a 2-propenyl group are particularly preferable.

Specific examples of the optionally substituted cyclic alkenyl group include, but are not limited to, cyclopentenyl and cyclohexenyl, and the number of carbon atoms thereof is usually 4 to 14, preferably 5 to 10, and more preferably 5 to 6.

As described above, the polysiloxane (A1) contains a polyorganosiloxane (a1') and a polyorganosiloxane (a2'), and an alkenyl group contained in the polyorganosiloxane (a1') and a hydrogen atom (Si-H group) contained in the polyorganosiloxane (a2') form a crosslinked structure by a hydrosilylation reaction by the platinum group metal-based catalyst (A2) and are cured. As a result, a cured film is formed.

The polyorganosiloxane (a1') contains one or two or more units selected from the group consisting of a Q' unit, an M' unit, a D' unit, and a T' unit, and contains at least one selected from the group consisting of an M' unit, a D' unit, and a T' unit. As the polyorganosiloxane (a1'), two or more kinds of polyorganosiloxanes satisfying such conditions may be used in combination.

Examples of preferred combinations of two or more types selected from the group consisting of a Q' unit, an M' unit, a D' unit, and a T' unit include, but are not limited to, (Q' unit and M' unit), (D' unit and M' unit), (T' unit and M' unit), and (Q' unit, T' unit, and M' unit).

In addition, when two or more types of polyorganosiloxanes included in the polyorganosiloxane (a1') are contained, a combination of (Q' unit and M' unit) and (D' unit and M' unit), a combination of (T' unit and M' unit) and (D' unit and M' unit), and a combination of (Q' unit, T' unit, and M' unit) and (T' unit and M' unit) are preferable, but the combinations are not limited thereto.

The polyorganosiloxane (a2') contains one or two or more units selected from the group consisting of a Q" unit, an M" unit, a D" unit, and a T" unit, and contains at least one selected from the group consisting of an M" unit, a D" unit, and a T" unit. As the polyorganosiloxane (a2'), two or more types of polyorganosiloxanes satisfying such conditions may be used in combination.

Examples of preferred combinations of two or more selected from the group consisting of a Q" unit, an M" unit, a D" unit, and a T" unit include, but are not limited to, (M" unit and D" unit), (Q" unit and M" unit), and (Q" unit, T" unit, and M" unit).

The polyorganosiloxane (a1') contains siloxane units in which alkyl groups and/or alkenyl groups are bonded to silicon atoms of the polyorganosiloxane, and the proportion of alkenyl groups in all substituents represented by $R^{1'}$ to $R^{6'}$ is

preferably 0.1% to 50.0% by mol, more preferably 0.5% to 30.0% by mol, and the remaining $R^{1'}$ to $R^{6'}$ can be alkyl groups.

The polyorganosiloxane (a2') contains siloxane units in which alkyl groups and/or hydrogen atoms are bonded to silicon atoms of the polyorganosiloxane, and the proportion of hydrogen atoms in all substituents and substitutional atoms represented by $R^{1''}$ to $R^{6''}$ is preferably 0.1% to 50.0% by mol, more preferably 10.0% to 40.0% by mol, and the remaining $R^{1''}$ to $R^{6''}$ can be alkyl groups.

When the component (A) contains (a1) and (a2), in a preferable aspect of the present invention, the molar ratio of the alkenyl group contained in the polyorganosiloxane (a1) and the hydrogen atom constituting the Si-H bond contained in the polyorganosiloxane (a2) is in the range of 1.0:0.5 to 1.0:0.66.

The weight-average molecular weight of the polysiloxane such as the polyorganosiloxane (a1) or the polyorganosiloxane (a2) is not particularly limited, and each is typically 500 to 1,000,000, and is preferably 5,000 to 50,000 from the viewpoint of achieving the effects of the present invention with good reproducibility.

Note that in the present invention, the weight average molecular weight, the number average molecular weight, and the dispersity of the polyorganosiloxane (excluding the organosiloxane polymer) can be measured, for example, using a GPC apparatus (EcoSEC, HLC-8320GPC manufactured by Tosoh Corporation) and a GPC column (TSKgel SuperMultiporeHZ-N and TSKgel SuperMultiporeHZ-H manufactured by Tosoh Corporation), at a column temperature of 40°C, using tetrahydrofuran as an eluent (eluent solvent), at a flow rate of 0.35 mL/min, and using polystyrene (Shodex manufactured by Showa Denko K.K.) as a standard sample.

The viscosity of the polyorganosiloxane (a1) and the polyorganosiloxane (a2) is not particularly limited, and each is usually 10 to 1,000,000 (mPa·s), and is preferably 50 to 10,000 (mPa·s) from the viewpoint of achieving the effects of the present invention with good reproducibility. The viscosities of the polyorganosiloxane (a1) and the polyorganosiloxane (a2) are values measured with an E-type rotational viscometer at 25°C.

The polyorganosiloxane (a1) and the polyorganosiloxane (a2) react with each other by a hydrosilylation reaction to form a film. Accordingly, the mechanism of curing is different from a mechanism, for example, through silanol groups, and therefore, any siloxane does not need to contain a silanol group or a functional group that forms a silanol group by hydrolysis, such as an alkyloxy group.

In a preferable aspect of the present invention, the adhesive composition contains a platinum group metal-based catalyst (A2) together with the polyorganosiloxane component (A').

Such a platinum-based metal catalyst is a catalyst for promoting the hydrosilylation reaction between the alkenyl group of the polyorganosiloxane (a1) and the Si-H group of the polyorganosiloxane (a2).

Specific examples of the platinum-based metal catalyst include, but are not limited to, platinum-based catalysts such as platinum black, second platinum chloride, chloroplatinic acid, a reaction product of chloroplatinic acid and monohydric alcohol, a complex of chloroplatinic acid and olefins, and platinum bisacetoacetate.

Examples of the complex of platinum and olefins include, but are not limited to, a complex of divinyltetramethyldisiloxane and platinum.

The amount of the platinum group metal-based catalyst (A2) is not particularly limited, but is usually in the range of 1.0 to 50.0 ppm with respect to the total amount of the polyorganosiloxane (a1) and the polyorganosiloxane (a2).

The polyorganosiloxane component (A') may contain a polymerization inhibitor (A3) for the purpose of suppressing the progress of the hydrosilylation reaction.

The polymerization inhibitor is not particularly limited as long as it is possible to suppress the progress of the hydrosilylation reaction, and specific examples thereof include alkynyl alcohols such as 1-ethynyl-1 cyclohexanol and 1,1-diphenyl-2-propyn-1-ol.

The amount of the polymerization inhibitor is not particularly limited, but is usually 1,000.0 ppm or more with respect to the total amount of the polyorganosiloxane (a1) and the polyorganosiloxane (a2) from the viewpoint of obtaining the effect, and is 10,000.0 ppm or less from the viewpoint of preventing excessive suppression of the hydrosilylation reaction.

An example of the adhesive composition used in the present invention may include the component (A) that cures and the component (B), which does not undergo a curing reaction, serves as a release agent component. By including such a component (B) in the adhesive composition, the obtained adhesive layer can be suitably released with good reproducibility.

Typical examples of the component (B) include a noncurable polyorganosiloxane, and specific examples thereof include, but are not limited to, an epoxy group-containing polyorganosiloxane, a methyl group-containing polyorganosiloxane, and a phenyl group-containing polyorganosiloxane.

Examples of the component (B) include polydimethylsiloxane. The polydimethylsiloxane may be modified. Examples of the optionally modified polydimethylsiloxane include, but are not limited to, an epoxy group-containing polydimethylsiloxane, an unmodified polydimethylsiloxane, or a phenyl group-containing polydimethylsiloxane.

Preferred examples of the polyorganosiloxane as the component (B) include, but are not limited to, an epoxy group-containing polyorganosiloxane, a methyl group-containing polyorganosiloxane, and a phenyl group-containing polyorganosiloxane.

The weight-average molecular weight of the polyorganosiloxane as the component (B) is not particularly limited, and is usually 100,000 to 2,000,000, and is preferably 200,000 to 1,200,000, more preferably 300,000 to 900,000 from the viewpoint of achieving the effects of the present invention with good reproducibility. In addition, the dispersity is not particularly limited, and is usually 1.0 to 10.0, and is preferably 1.5 to 5.0, and more preferably 2.0 to 3.0 from the viewpoint of achieving suitable release with good reproducibility, and the like. The weight-average molecular weight and the dispersity can be measured by the above-described method related to the polyorganosiloxane.

The viscosity of the polyorganosiloxane as the component (B) is not particularly limited, and is usually 1,000 to 2,000,000 $mm^2/s$. The value of the viscosity of the polyorganosiloxane as the component (B) is represented by kinematic viscosity, and centistokes (cSt) = $mm^2/s$. The value can also be determined by dividing the viscosity (mPa·s) by the density ($g/cm^3$). That is, the value can be determined from the viscosity and density measured with an E-type rotational viscometer at 25°C, and can be calculated from the equation: kinematic viscosity ($mm^2/s$) = viscosity (mPa·s)/density ($g/cm^3$).

Examples of the epoxy group-containing polyorganosiloxane include those containing a siloxane unit ($D^{10}$ unit) represented by $R^{11}R^{12}SiO_{2/2}$.

$R^{11}$ is a group bonded to a silicon atom and represents an alkyl group, $R^{12}$ is a group bonded to a silicon atom and represents an epoxy group or an organic group containing an epoxy group, and specific examples of the alkyl group can include the above-described examples.

The epoxy group in the organic group containing an epoxy group may be an independent epoxy group without being condensed with another ring, or may be an epoxy group forming a condensed ring with another ring, such as a 1,2-epoxycyclohexyl group.

Specific examples of the organic group containing an epoxy group include, but are not limited to, 3-glycidoxypropyl and 2-(3,4-epoxycyclohexyl)ethyl.

In the present invention, preferred examples of the epoxy group-containing polyorganosiloxane may include, but are not limited to, an epoxy group-containing polydimethylsiloxane.

The epoxy group-containing polyorganosiloxane contains the above-described siloxane unit ($D^{10}$ unit), but may contain, in addition to $D^{10}$ unit, Q units, M units, and/or T units.

In a preferred aspect of the present invention, specific examples of the epoxy group-containing polyorganosiloxane include a polyorganosiloxane composed only of $D^{10}$ units, a polyorganosiloxane containing $D^{10}$ units and Q units, a polyorganosiloxane containing $D^{10}$ units and M units, a polyorganosiloxane containing $D^{10}$ units and T units, a polyorganosiloxane containing $D^{10}$ units, Q units, and M units, a polyorganosiloxane containing $D^{10}$ units, M units, and T units, or a polyorganosiloxane containing $D^{10}$ units, Q units, M units, and T units.

The epoxy group-containing polyorganosiloxane is preferably an epoxy group-containing polydimethylsiloxane having an epoxy value of 0.1 to 5. In addition, the weight-average molecular weight is not particularly limited, and is usually from 1,500 to 500,000, and is preferably 100,000 or less from the viewpoint of suppressing precipitation in the composition.

Specific examples of the epoxy group-containing polyorganosiloxane include, but are not limited to, those represented by formulae (E1) to (E3).

[Chem. 49]

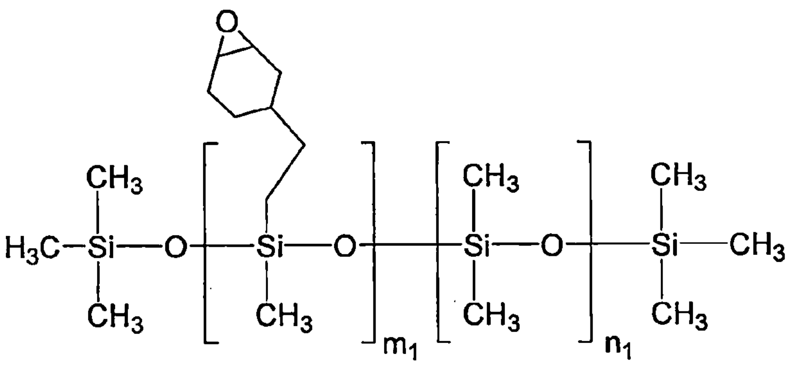

(E1)

($m_1$ and $n_1$ represent the number of respective repeating units, and are positive integers.)

[Chem. 50]

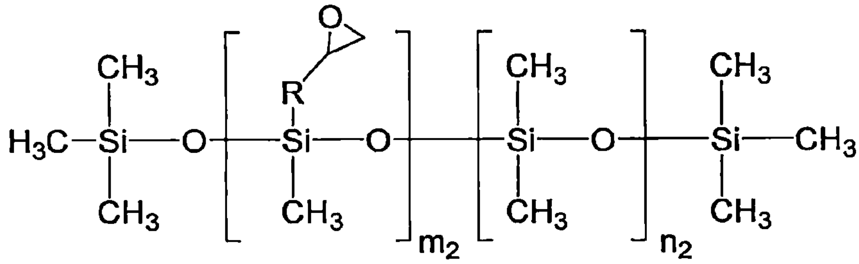

(E2)

($m_2$ and $n_2$ represent the number of respective repeating units, and are positive integers, and R is a $C_{1-10}$ alkylene group.)

[Chem. 51]

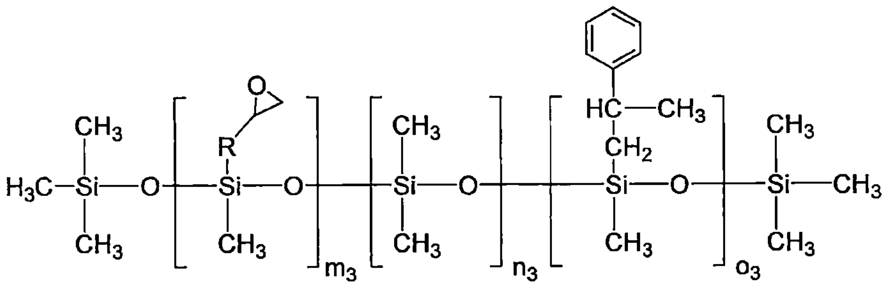

(E3)

($m_3$, $n_3$, and $o_3$ represent the number of respective repeating units, and are positive integers, and R is a $C_{1-10}$ alkylene group.)

Examples of the methyl group-containing polyorganosiloxane include those containing a siloxane unit ($D^{200}$ unit) represented by $R^{210}R^{220}SiO_{2/2}$, and preferably those containing a siloxane unit ($D^{20}$ unit) represented by $R^{21}R^{21}SiO_{2/2}$.

$R^{210}$ and $R^{220}$ are groups bonded to silicon atoms, and each independently represent an alkyl group, with at least one of $R^{210}$ or $R^{220}$ being a methyl group, and specific examples of the alkyl group may include the above-described examples.

$R^{21}$ is a group bonded to a silicon atom and represents an alkyl group, and specific examples of the alkyl group may include the above-described examples. Among them, a methyl group is preferable as $R^{21}$.

In the present invention, preferred examples of the methyl group-containing polyorganosiloxane may include, but are not limited to, a polydimethylsiloxane.

The methyl group-containing polyorganosiloxane contains the above-described siloxane unit ($D^{200}$ unit or $D^{20}$ unit), but may contain, in addition to $D^{200}$ unit and $D^{20}$ unit, Q units, M units, and/or T units.

In an aspect of the present invention, specific examples of the methyl group-containing polyorganosiloxane include a polyorganosiloxane composed only of $D^{200}$ units, a polyorganosiloxane containing $D^{200}$ units and Q units, a polyorganosiloxane containing $D^{200}$ units and M units, a polyorganosiloxane containing $D^{200}$ units and T units, a polyorganosiloxane containing $D^{200}$ units, Q units, and M units, a polyorganosiloxane containing $D^{200}$ units, M units, and T units, or a polyorganosiloxane containing $D^{200}$ units, Q units, M units, and T units.

In a preferred aspect of the present invention, specific examples of the methyl group-containing polyorganosiloxane include a polyorganosiloxane composed only of $D^{20}$ units, a polyorganosiloxane containing $D^{20}$ units and Q units, a polyorganosiloxane containing $D^{20}$ units and M units, a polyorganosiloxane containing $D^{20}$ units and T units, a polyorganosiloxane containing $D^{20}$ units, Q units, and M units, a polyorganosiloxane containing $D^{20}$ units, M units, and T units, or a polyorganosiloxane containing $D^{20}$ units, Q units, M units, and T units.

Specific examples of the methyl group-containing polyorganosiloxane include, but are not limited to, those represented by formula (M1).

[Chem. 52]

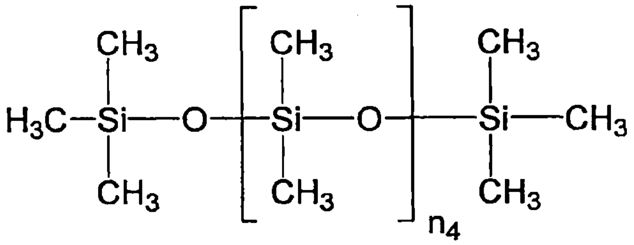

(M1)

($n_4$ represents the number of repeating units, and is a positive integer.)

Examples of the phenyl group-containing polyorganosiloxane include those containing a siloxane unit ($D^{30}$ unit) represented by $R^{31}R^{32}SiO_{2/2}$.

$R^{31}$ is a group bonded to a silicon atom and represents a phenyl group or an alkyl group, $R^{32}$ is a group bonded to a silicon atom and represents a phenyl group, specific examples of the alkyl group may include the above-described examples, and a methyl group is preferable.

The phenyl group-containing polyorganosiloxane contains the above-described siloxane unit ($D^{30}$ unit), and may contain, in addition to $D^{30}$ unit, Q units, M units, and/or T units.

In a preferred aspect of the present invention, specific examples of the phenyl group-containing polyorganosiloxane include a polyorganosiloxane composed only of $D^{30}$ units, a polyorganosiloxane containing $D^{30}$ units and Q units, a polyorganosiloxane containing $D^{30}$ units and M units, a polyorganosiloxane containing $D^{30}$ units and T units, a polyorganosiloxane containing $D^{30}$ units, Q units, and M units, a polyorganosiloxane containing $D^{30}$ units, M units, and T units, or a polyorganosiloxane containing $D^{30}$ units, Q units, M units, and T units.

Specific examples of the phenyl group-containing polyorganosiloxane include, but are not limited to, those represented by formula (P1) or (P2).

[Chem. 53]

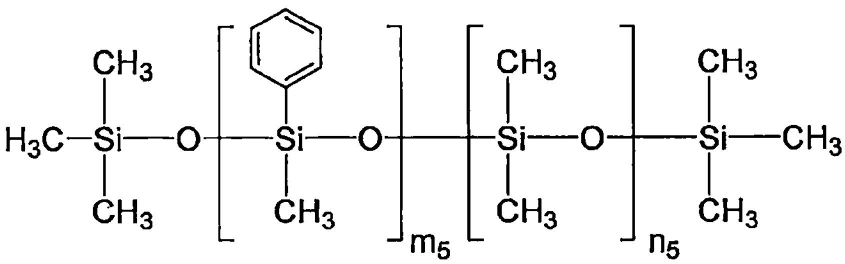

(P1)

($m_5$ and $n_5$ represent the number of respective repeating units, and are positive integers.)

[Chem. 54]

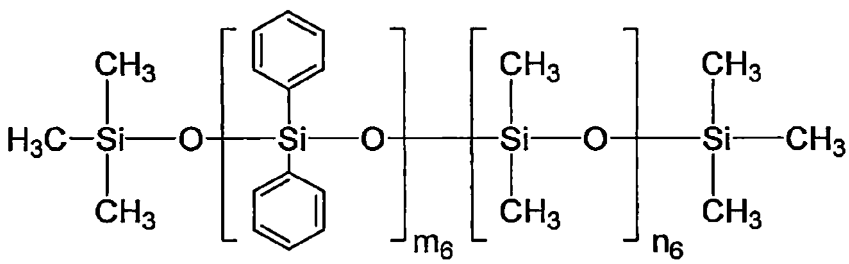

(P2)

($m_6$ and $n_6$ represent the number of respective repeating units, and are positive integers.)

The polyorganosiloxane as the release agent component (B) may be a commercially available product or a synthetic product.

Examples of commercially available products of the polyorganosiloxane include, but are not limited to, Wacker

Silicone Fluid AK series (AK 50, AK 350, AK 1000, AK 10000, AK 1000000) and GENIOPLAST GUM, which are products manufactured by Wacker Chemie AG, dimethyl silicone oil (KF-96L, KF-96A, KF-96, KF-96H, KF-69, KF-965, KF-968) and cyclic dimethyl silicone oil (KF-995) manufactured by Shin-Etsu Chemical Co., Ltd.; epoxy group-containing polyorganosiloxane manufactured by Gelest, Inc. (trade name: CMS-227, ECMS-327), epoxy group-containing polyorganosiloxane manufactured by Shin-Etsu Chemical Co., Ltd. (KF-101, KF-1001, KF-1005, X-22-343), epoxy group-containing polyorganosiloxane (BY16-839) manufactured by Dow Corning Corporation; and phenyl group-containing polyorganosiloxane (PMM-1043, PMM-1025, PDM-0421, PDM-0821) manufactured by Gelest, Inc., phenyl group-containing polyorganosiloxane (KF50-3000CS) manufactured by Shin-Etsu Chemical Co., Ltd., and phenyl group-containing polyorganosiloxane (TSF431, TSF433) manufactured by Momentive Performance Materials, Inc.

In one aspect, the adhesive composition used in the present invention contains a component (A) to be cured and a component (B) that does not cause a curing reaction, and in another aspect, a polyorganosiloxane is contained as the component (B).

An example of the adhesive composition used in the present invention can contain the component (A) and the component (B) in any ratio, but in consideration of the balance between adhesiveness and releasability, the ratio of the component (A) and the component (B) is preferably 99.995 : 0.005 to 30 : 70, and more preferably 99.9 : 0.1 to 75 : 25 in mass ratio [(A) : (B)].

That is, when the polyorganosiloxane component (A') cured by a hydrosilylation reaction is contained, the ratio of the component (A') and the component (B) is preferably 99.995 : 0.005 to 30 : 70, more preferably 99.9 : 0.1 to 75 : 25 in mass ratio [(A') : (B)].

The viscosity of the adhesive composition used in the present invention is not particularly limited, and is usually 500 to 20,000 mPa·s, and preferably 1,000 to 1,0000 mPa·s at 25°C.

An example of the adhesive composition used in the present invention can be manufactured by mixing the component (A) and the component (B) when used with a solvent.

The mixing order is not particularly limited, and examples of the method for easily and reproducibly producing the adhesive composition include, but are not limited to, a method in which the component (A) and the component (B) are dissolved in a solvent, and a method in which a part of the component (A) and the component (B) is dissolved in a solvent, the rest is dissolved in a solvent, and the obtained solution is mixed. When the adhesive composition is prepared, the components may be heated as appropriate, as long as the components are not decomposed or altered.

In the present invention, for the purpose of removing foreign matter, a solvent, a solution, or the like to be used may be filtered using a filter or the like during the production of the adhesive composition or after mixing all the components.

The thickness of the adhesive layer included in the laminate of the present invention is not particularly limited, but is usually 5 to 500 μm, and is preferably 10 μm or more, more preferably 20 μm or more, and still more preferably 30 μm or more from the viewpoint of maintaining the film strength, and is preferably 200 μm or less, more preferably 150 μm or less, still more preferably 120 μm or less, and further preferably 70 μm or less from the viewpoint of avoiding nonuniformity caused by a thick film.

The method for forming the adhesive layer from the adhesive composition will be described in detail in the description of <<Method for Producing One Example of Laminate in First Embodiment>> described below.

Hereinafter, an example of the configuration of the laminate of the first embodiment will be described with reference to the drawings.

The laminate of Fig. 1 includes a semiconductor substrate 1, an adhesive layer 2, a release agent layer 3, and a support substrate 4 in this order.

The adhesive layer 2 and the release agent layer 3 are provided between the semiconductor substrate 1 and the support substrate 4. The adhesive layer 2 is in contact with the semiconductor substrate 1. The release agent layer 3 is in contact with the adhesive layer 2 and the support substrate 4.

<<Method for Producing One Example of Laminate in First Embodiment>>

A method for producing a laminate will be described below with the laminate shown in Fig. 1 as an example of the laminate in the first embodiment.

An example of the laminate of the present invention can be produced, for example, by a method including the following steps 1 to 3.

Step 1: a step of applying an adhesive composition onto a semiconductor substrate to form an adhesive coating layer
Step 2: a step of applying a release agent composition onto a support substrate to form a release agent layer
Step 3: a step of heating the adhesive coating layer in a state where the adhesive coating layer and the release agent layer are in contact with each other to form an adhesive layer.

The coating method for the adhesive composition is not particularly limited, and is usually a spin coating method.

A method for separately forming a coating film by a spin coating method or the like, forming a sheet-like coating film, and attaching the sheet-like coating film as an adhesive coating layer can be adopted.

The heating temperature of the applied adhesive composition varies depending on the type and amount of the adhesive component contained in the adhesive composition, whether or not a solvent is contained, the boiling point of the solvent to be used, the desired thickness of the adhesive layer, and the like, and thus cannot be generally determined, but the heating temperature is usually 80°C to 150°C, and the heating time is usually 30 seconds to 5 minutes.

When the adhesive composition contains a solvent, the applied adhesive composition is usually heated.

The film thickness of an adhesive coating layer obtained by applying an adhesive composition and heating the adhesive composition, as necessary, is usually about 5 to 500 μm, and finally, is appropriately determined to fall within the above-described range of the thickness of the adhesive layer.

The coating method for the release agent composition is not particularly limited, but is usually a spin coating method.

The heating temperature of the applied release agent composition varies depending on the type and amount of the release agent component contained in the release agent composition, the desired thickness of the release agent layer, and the like, and thus cannot be generally determined, but from the viewpoint of achieving a suitable release agent layer with good reproducibility, the heating temperature is 80°C or more and 300°C or less, and the heating time is appropriately determined usually in the range of 10 seconds to 10 minutes depending on the heating temperature. The heating temperature is preferably 100°C or higher and 280°C or lower, and more preferably 150°C or higher and 250°C or lower. The heating time is preferably 30 seconds or more and 8 minutes or less, and more preferably 1 minute or more and 5 minutes or less.

The heating can be performed using a hot plate, an oven, or the like.

The film thickness of the release agent obtained by applying the release agent composition and heating the release agent composition, if necessary, is usually about 5 nm to 100 μm.

In the present invention, the laminate of the present invention can be obtained by combining such coating layers to be in contact with each other, bringing the two layers into close contact with each other by applying a load in the thickness direction of the semiconductor substrate and the support substrate while performing heat treatment or decompression treatment or both thereof, and then performing post-heat treatment. Note that which treatment condition of heat treatment, decompression treatment, and combination use of both is adopted is appropriately determined in consideration of various circumstances such as the type of the adhesive composition, the specific composition of the release agent composition, the compatibility of films obtained from both compositions, the film thickness, and the required adhesive strength.

The heat treatment is appropriately determined from the range of usually 20 to 150°C from the viewpoint of removing the solvent from the composition, from the viewpoint of softening the adhesive coating layer to achieve suitable bonding with the release agent layer, and the like. In particular, from the viewpoint of suppressing or avoiding excessive curing and unnecessary alteration of the adhesive component (A), the heating temperature is preferably 130°C or lower, and more preferably 90°C or lower, and the heating time is appropriately determined depending on the heating temperature and the type of the adhesive. However, from the viewpoint of reliably exhibiting suitable adhesion, the heating time is usually 30 seconds or longer, and preferably 1 minute or longer. From the viewpoint of suppressing alteration of the adhesive layer and other members, the heating time is usually 10 minutes or shorter, preferably 5 minutes or shorter.

In the decompression treatment, the adhesive coating layer and the release agent layer in contact with each other may be exposed to an atmospheric pressure of 10 to 10,000 Pa. The time for the decompression treatment is usually 1 to 30 minutes.

From the viewpoint of obtaining a laminate in which the substrate can be satisfactorily separated with good reproducibility, the two layers in contact with each other are bonded to each other preferably by decompression treatment, and more preferably by combined use of heat treatment and decompression treatment.

The load in the thickness direction of the semiconductor substrate and the support substrate is not particularly limited as long as the load does not adversely affect the semiconductor substrate, the support substrate, and the two layers therebetween, and can bring them into close contact with each other, but is usually within the range of 10 to 1,000 N.

The temperature of the post-heating is preferably 120°C or higher from the viewpoint of achieving a sufficient curing rate and the like, and is preferably 260°C or lower from the viewpoint of preventing alteration of the substrate and each layer, and the like.

The post-heating time is usually 1 minute or more, and preferably 5 minutes or more from the viewpoint of achieving suitable bonding of the substrate and the layer constituting the laminate, and is usually 180 minutes or less, and preferably 120 minutes or less from the viewpoint of suppressing or avoiding an adverse effect on each layer due to excessive heating, and the like.

The heating can be performed using a hot plate, an oven, or the like. When post-heating is performed using a hot plate, heating may be performed with either the semiconductor substrate or the support substrate of the laminate facing downward, but it is preferable to perform post-heating with the semiconductor substrate facing downward from the

viewpoint of achieving suitable release with good reproducibility.

Note that one object of the post-heat treatment is to achieve an adhesive layer and a release agent layer which are more suitable self-standing films, particularly to suitably achieve curing by a hydrosilylation reaction.

Hereinafter, an example of a method for producing the laminate of Fig. 1 will be described with reference to Figs. 2A to 2C.

Figs. 2A to 2C are views for describing one aspect of producing the laminate.

First, a laminate in which an adhesive coating layer 2a is formed on the semiconductor substrate 1 is prepared (Fig. 2A). This laminate can be obtained, for example, by applying the adhesive composition onto the semiconductor substrate 1, followed by heating.

Separately, a laminate in which the release agent layer 3 is formed on the support substrate 4 is prepared (Fig. 2B). This laminate can be obtained, for example, by applying the release agent composition on the support substrate 4, followed by heating.

Next, the laminate shown in Fig. 2A and the laminate shown in Fig. 2B are bonded to each other such that the adhesive coating layer 2a and the release agent layer 3 are in contact with each other. Then, after a load is applied in the thickness direction between the semiconductor substrate 1 and the support substrate 4 under reduced pressure, a heating device (not shown, a hot plate) is disposed on the surface opposite to a surface of the semiconductor substrate 1 with which the adhesive coating layer 2a is in contact, and the adhesive coating layer 2a is heated and cured by the heating device to be converted into the adhesive layer 2 (Fig. 2C).

The laminate is obtained by the steps shown in Figs. 2A to 2C.

Note that, in Fig. 1, in the laminate, the semiconductor substrate 1, the adhesive layer 2, the release agent layer 3, and the support substrate 4 are stacked in this order, and thus the above-described production method has been exemplified. However, for example, when producing a laminate in which the semiconductor substrate 1, the release agent layer 3, the adhesive layer 2, and the support substrate 4 are stacked in this order, the laminate can be produced by a method including a first step of coating a surface of the semiconductor substrate with the release agent composition and, if necessary, heating the release agent composition to form the release agent layer, a second step of coating a surface of the support substrate with the release agent composition and, if necessary, heating the release agent composition to form the adhesive coating layer, and a third step of bringing the release agent layer of the semiconductor substrate and the adhesive coating layer of the support substrate into close contact with each other by applying a load in the thickness direction of the semiconductor substrate and the support substrate while performing at least one of heat treatment and decompression treatment, and then performing post-heat treatment to form the laminate.

Note that as long as the effect of the present invention is not impaired, application and heating of each composition may be sequentially performed on any one of the substrates.

<Second Embodiment>

The laminate including an electronic device layer is used for processing of the electronic device layer. While the electronic device layer is being processed, the electronic device layer is adhered to the support substrate. After processing the electronic device layer, the release agent layer is irradiated with light, and then the electronic device layer is separated from the support substrate.

<<Electronic Device Layer>>

The electronic device layer refers to a layer having an electronic device, and in the present invention, refers to a layer in which a plurality of semiconductor chip substrates are embedded in a sealing resin, that is, a layer including a plurality of semiconductor chip substrates and a sealing resin disposed between the semiconductor chip substrates.

Here, the "electronic device" means a member constituting at least a part of an electronic component. The electronic device is not particularly limited, and can be one in which various mechanical structures and circuits are formed on the surface of a semiconductor substrate. The electronic device is preferably a composite of a member made of metal or a semiconductor and a resin that seals or insulates the member. The electronic device may be one in which a rewiring layer, which will be described later, and/or a semiconductor element or other elements are sealed or insulated with a sealing material or an insulating material, and has a single-layer or multi-layer structure.

<<Support Substrate>>

As the support substrate, those similar to those described in the section of <<Support Substrate>> above of <First Embodiment> above are exemplified.

<<Release Agent Layer>>

The release agent layer is formed using the release agent composition for release by irradiation with light of the present invention described above.
The detailed description of the release agent layer is as described in the section of <<Release Agent Layer>> above of <First Embodiment> above.

<<Adhesive Layer>>

The adhesive layer is formed using the adhesive composition described above.
The detailed description of the adhesive layer is as described in the section of <<Adhesive Layer>> above of <First Embodiment> above.
Hereinafter, an example of the configuration of the laminate of the second embodiment will be described with reference to the drawings.
Fig. 3 shows a schematic cross-sectional view of an example of the laminate of the second embodiment.
The laminate of Fig. 3 includes the support substrate 24, the release agent layer 23, the adhesive layer 22, and the electronic device layer 26 in this order.
The electronic device layer 26 includes a plurality of semiconductor chip substrates 21 and a sealing resin 25 which is a sealing material disposed between the semiconductor chip substrates 21.
The adhesive layer 22 and the release agent layer 23 are provided between the electronic device layer 26 and the support substrate 24. The adhesive layer 22 is in contact with the electronic device layer 26. The release agent layer 23 is in contact with the adhesive layer 22 and the support substrate 24.
In addition, another example of the configuration of the laminate of the second embodiment is shown in Fig. 4.
When the release agent layer according to the present invention is a release agent layer having adhesive performance having both the release function and the adhesive function, the laminate may be formed not in a two-layer structure of the release agent layer and the adhesive layer but in a one-layer structure of the release agent layer having adhesive performance.
Fig. 4 shows a schematic cross-sectional view of another example of the laminate.
The laminate of Fig. 4 includes the support substrate 24, a release agent layer 27 having adhesive performance, and the electronic device layer 26 in this order.
The release agent layer 27 having adhesive performance is provided between the support substrate 24 and the electronic device layer 26. The release agent layer 27 having adhesive performance can be prepared by mixing components of a release agent composition that forms a release agent with components of an adhesive composition that forms an adhesive layer.

<<Method for Producing One Example of Laminate in Second Embodiment>>

A method for producing a laminate will be described below with the laminate shown in Fig. 3 as an example of the laminate in the second embodiment.
The laminate of the present invention can be produced, for example, by a method including the following steps 1 to 5.

Step 1: a step of coating a surface of the support substrate with the release agent composition to form a release agent coating layer (if necessary, further heating is performed to form a release agent layer)
Step 2: a step of coating a surface of the release agent coating layer or the release agent layer with the adhesive composition to form an adhesive coating layer (if necessary, further heating is performed to form an adhesive layer)
Step 3: a step of placing a semiconductor chip substrate on the adhesive coating layer or the adhesive layer, and bonding the semiconductor chip substrate to the adhesive coating layer or the adhesive layer while performing at least one of heat treatment and decompression treatment
Step 4: a step of curing the adhesive coating layer by post-heat treatment to form an adhesive layer
Step 5: a step of sealing the semiconductor chip substrate fixed onto the adhesive layer using a sealing resin

To describe the third step in more detail, for example, there is the following step (i) of the embodiment.

(i) The semiconductor chip substrate is placed on the adhesive coating layer or the adhesive layer, and while at least one of the heat treatment and the decompression treatment is performed, a load is applied in the thickness direction of the semiconductor chip substrate and the support substrate to bring the semiconductor chip substrate and the support substrate into close contact with each other, and the semiconductor chip substrate is bonded to the adhesive coating

layer or the adhesive layer.

Note that step 4 may be performed after the semiconductor chip substrate in step 3 is bonded to the adhesive coating layer, or may be performed in combination with step 3. For example, by placing the semiconductor chip substrate on the adhesive coating layer and heating and curing the adhesive coating layer while applying a load in the thickness direction of the semiconductor chip substrate and the support substrate, adhesion between the semiconductor chip substrate and the adhesive coating layer and curing from the adhesive coating layer to the adhesive layer may be performed together, and the adhesive layer and the semiconductor chip substrate may be bonded to each other.
In addition, step 4 may be performed before step 3, the semiconductor chip substrate may be placed on the adhesive layer, and while a load is applied in the thickness direction of the semiconductor chip substrate and the support substrate, the adhesive layer and the semiconductor chip substrate may be bonded to each other.
The coating method, the heating temperature of the applied release agent composition or adhesive composition, the heating means, and the like are as described in the above <<Method for producing one example of laminate in first embodiment>> of the above <First embodiment>.
Hereinafter, the procedure of the method for producing a laminate of the second embodiment will be described in more detail with reference to the drawings. In this production method, the laminate shown in Fig. 3 is produced.
As shown in Fig. 5A, a release agent coating layer 23' made of the release agent composition is formed on the support substrate 24. At that time, the release agent coating layer 23' may be heated to form a release agent layer 23.
Next, as shown in Fig. 5B, an adhesive coating layer 22' made of the adhesive composition is formed on the release agent coating layer 23' or the release agent layer 23. At that time, the adhesive coating layer 22' may be heated to form an adhesive layer 22.
Next, as shown in Fig. 5C, the semiconductor chip substrate 21 is placed on the adhesive layer 22 or the adhesive coating layer 22', and while at least one of the heat treatment and the decompression treatment is performed, a load is applied in the thickness direction of the semiconductor chip substrate 21 and the support substrate 24 to bring the semiconductor chip substrate 21 and the support substrate 24 into close contact with each other, and the semiconductor chip substrate 21 is bonded to the adhesive layer 22 or the adhesive coating layer 22'. When the semiconductor chip substrate 21 is bonded to the adhesive coating layer 22', the adhesive coating layer 22' is cured by post-heat treatment to form the adhesive layer 22, and the semiconductor chip substrate 21 is fixed to the adhesive layer 22.
Note that when the adhesive coating layer 22' is subjected to the post-heat treatment, the release agent coating layer 23' may also be subjected to the post-heat treatment to form the release agent layer 23.
Next, as illustrated in Fig. 5D, the semiconductor chip substrate 21 fixed onto the adhesive layer 22 is sealed using the sealing resin 25. In Fig. 5D, the plurality of semiconductor chip substrates 21 temporarily adhered onto the support substrate 24 via the adhesive layer 22 is sealed with the sealing resin 25. The electronic device layer 26, which includes the semiconductor chip substrate 21 and the sealing resin 25 between the semiconductor chip substrates 21, is formed on the adhesive layer 22, and as described above, the electronic device layer 26 is a base material layer in which the plurality of semiconductor chip substrates are embedded in the sealing resin.

<<<Sealing Step>>>

The semiconductor chip substrate 21 is sealed using a sealing material.
As the sealing material for sealing the semiconductor chip substrate 21, a member capable of insulating or sealing a member made of metal or a semiconductor is used.
In the present invention, for example, a resin composition (sealing resin) is used as the sealing material. The type of the sealing resin is not particularly limited as long as the sealing resin can seal and/or insulate metal or a semiconductor, and for example, an epoxy-based resin or a silicone-based resin is preferably used.
The sealing material may contain, in addition to the resin component, other components such as a filler. Examples of the filler include spherical silica particles.
In the sealing step, for example, the sealing resin heated to 130°C to 170°C is supplied onto the adhesive layer 22 to cover the semiconductor chip substrate 21 while maintaining a high viscosity state, and is compression-molded to form a layer containing the sealing resin 25 on the adhesive layer 22. At this time, the temperature condition is, for example, 130°C to 170°C. In addition, the pressure applied to the semiconductor chip substrate 21 is, for example, 50 to 500 N/$cm^2$.

(Method for Producing Processed Semiconductor Substrate or Electronic Device Layer)

When the laminate according to the present invention is used, a method for producing a processed semiconductor substrate or a method for producing a processed electronic device layer can be provided.
In the "method for producing a processed semiconductor substrate", the laminate described in the section of <First Embodiment> above of the (Laminate) above is used. In addition, in the "method for producing a processed

electronic device layer", the laminate described in the section of <Second Embodiment> above of the (Laminate) above is used.

The "method for producing a processed semiconductor substrate" will be described in <Third Embodiment> below, and the "method for producing a processed electronic device layer" will be described in <Fourth Embodiment> below.

<Third Embodiment>

The method for producing a processed semiconductor substrate of the present invention includes the following step 5A and the following step 6A. The method for producing a processed electronic device layer may further include the following step 7A.

Here, step 5A is a step of processing the semiconductor substrate in the laminate described in the section of <First Embodiment> above.

In addition, step 6A is a step of separating the semiconductor substrate processed in step 5A and the support substrate from each other.

In addition, step 7A is a step of cleaning the processed semiconductor substrate after step 6A.

The processing performed on the semiconductor substrate in step 5A is, for example, processing on the side opposite to the circuit surface of the wafer, and includes thinning of the wafer by polishing the back surface of the wafer. Thereafter, for example, a through-silicon via (TSV) or the like is formed, and the thinned wafer is then released from the support substrate to form a laminate of wafers which are three-dimensionally mounted. In addition, for example, before and after that, a wafer back surface electrode and the like are also formed. Heat of approximately 250 to 350°C is applied to thinning of a wafer and a TSV process in a state of being adhered to the support substrate. The laminate of the present invention usually includes the adhesive layer to provide heat resistance to the load.

The processing performed on the semiconductor substrate in the step 5A may be a step of dicing the semiconductor substrate.

The processing is not limited to the above-described processing, and includes, for example, implementation of a process of mounting a semiconductor component in a case where the support substrate is temporarily adhered in order to support a base material for mounting the semiconductor component.

In Step 6A, examples of the method for separating (releasing) the semiconductor substrate and the support substrate include, but are not limited to, a method for mechanical release with equipment having a sharp portion, a releasing method for separation between the support and the semiconductor wafer, and the like after the light irradiation to the release agent layer.

By irradiating the release agent layer with light from the support substrate side, the release agent layer is altered (for example, the release agent layer is separated or decomposed) as described above, and thereafter, for example, one of the substrates is pulled up, and the semiconductor substrate and the support substrate can be easily separated from each other.

The release agent layer is not necessarily irradiated with light over the entire region of the release agent layer. Even when the region irradiated with light and the region not irradiated with light are mixed, the semiconductor substrate and the support substrate can be separated from each other by a slight external force such as pulling up of the support substrate as long as the release agent layer as a whole has sufficiently improved releasing ability. The ratio and positional relationship between the region irradiated with light and the region not irradiated with light vary depending on the type and specific composition of the adhesive to be used, the thickness of the adhesive layer, the thickness of the adhesive layer, the thickness of the release agent layer, the intensity of light to be emitted, and the like, but those skilled in the art can appropriately set conditions without requiring an excessive test. For such circumstances, according to the method for producing a processed semiconductor substrate of the present invention, for example, in a case where the support substrate of the laminate to be used is light-transmissive, it is possible to shorten the irradiation time with light when release is performed by irradiation with light from the support substrate side, and as a result, not only improvement in throughput can be expected, but also physical stress and the like required for release can be avoided, and the semiconductor substrate and the support substrate can be easily and efficiently separated from each other only by irradiation with light.

The dose of light required for release is usually 50 to 3,000 mJ/cm$^2$. The irradiation time is appropriately determined depending on the wavelength and the irradiation amount.

The wavelength of the light used for release is preferably, for example, a wavelength of 250 to 600 nm, more preferably a wavelength of 250 to 370 nm as described above. A more suitable wavelength is 308 nm, 343 nm, 355 nm, 365 nm, or 532 nm. The irradiation amount of light required for release is an irradiation amount that can cause suitable alteration, for example, decomposition of the first structure in the release agent layer.

The light used for release may be laser light or non-laser light emitted from a light source such as an ultraviolet lamp.

The substrate can be cleaned by spraying a cleaning agent composition onto the surface of at least one of the

separated semiconductor substrate and the support substrate, or immersing the separated semiconductor substrate or the support substrate in a cleaning agent composition.

In addition, the surface of the processed semiconductor substrate or the like may be cleaned using a removal tape or the like.

As an example of cleaning the substrate, step 7A of cleaning the processed semiconductor substrate may be performed after step 6A.

Examples of the cleaning agent composition to be used for cleaning include the following.

The cleaning agent composition usually contains a solvent.

The cleaning agent composition may contain a salt.

A suitable example of the cleaning agent composition includes a cleaning agent composition containing a quaternary ammonium salt and a solvent.

The quaternary ammonium salt is composed of a quaternary ammonium cation and an anion, and is not particularly limited as long as the quaternary ammonium salt is used for this type of application.

Such quaternary ammonium cations typically include tetra (hydrocarbon) ammonium cations. On the other hand, examples of an anion paired therewith include, but are not limited to, a hydroxide ion ($OH^-$); a halogen ion such as a fluorine ion ($F^-$), a chlorine ion ($Cl^-$), a bromine ion ($Br^-$), and an iodine ion ($I^-$); a tetrafluoroborate ion ($BF_4^-$); or a hexafluorophosphate ion ($PF_6^-$).

The quaternary ammonium salt is preferably a halogen-containing quaternary ammonium salt, and more preferably a fluorine-containing quaternary ammonium salt.

In the quaternary ammonium salt, the halogen atom may be contained in the cation or the anion, and is preferably contained in the anion.

In a preferable aspect, the fluorine-containing quaternary ammonium salt is tetra (hydrocarbon) ammonium fluoride.

Specific examples of the hydrocarbon group in tetra (hydrocarbon) ammonium fluoride include a $C_{1-20}$ alkyl group, a $C_{2-20}$ alkenyl group, a $C_{2-20}$ alkynyl group, and a $C_{6-20}$ aryl group.

In a more preferable aspect, the tetra(hydrocarbon)ammonium fluoride contains tetraalkylammonium fluoride.

Specific examples of tetraalkylammonium fluoride include, but are not limited to, tetramethylammonium fluoride, tetraethylammonium fluoride, tetrapropylammonium fluoride, and tetrabutylammonium fluoride. Among them, tetrabutylammonium fluoride is preferable.

As the quaternary ammonium salt such as tetra(hydrocarbon)ammonium fluoride, a hydrate may be used. In addition, the quaternary ammonium salts such as tetra(hydrocarbon)ammonium fluoride may be used alone or in combination of two or more thereof.

The amount of the quaternary ammonium salt is not particularly limited as long as the quaternary ammonium salt dissolves in the solvent contained in the cleaning agent composition, but is usually 0.1% to 30% by mass with respect to the cleaning agent composition.

The solvent contained in the cleaning agent composition is not particularly limited as long as the solvent is used for this type of application and dissolves a salt such as a quaternary ammonium salt, but from the viewpoint of obtaining a cleaning agent composition having excellent cleanability with good reproducibility, from the viewpoint of obtaining a cleaning agent composition having excellent uniformity by dissolving a salt such as a quaternary ammonium salt satisfactorily, and the like, the cleaning agent composition preferably contains one or more amide-based solvents.

Suitable examples of the amide-based solvents include an acid amide derivative represented by formula (Z).

[Chem. 55]

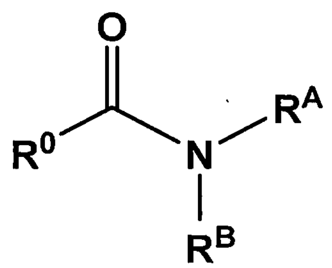

(Z)

In the formula, $R^0$ represents an ethyl group, a propyl group or an isopropyl group, and is preferably an ethyl group or an isopropyl group, and more preferably an ethyl group. $R^A$ and $R^B$ each independently represent a $C_{1-4}$ alkyl group. The $C_{1-4}$ alkyl group may be linear, branched, or cyclic, and specific examples thereof include a methyl group, an ethyl group, a propyl group, an isopropyl group, a cyclopropyl group, an n-butyl group, an isobutyl group, an s-butyl group, a t-butyl group,

and a cyclobutyl group. Among them, $R^A$ and $R^B$ are preferably a methyl group or an ethyl group, more preferably a methyl group or an ethyl group, and still more preferably a methyl group.

Examples of the acid amide derivative represented by formula (Z) include N,N-dimethylpropionamide, N,N-diethylpropionamide, N-ethyl-N-methylpropionamide, N,N-dimethylbutyramide, N,N-diethylbutyramide, N-ethyl-N-methylbutyramide, N,N-dimethylisobutyramide, N,N-diethylisobutyramide, or N-ethyl-N-methylisobutyramide. Among them, N,N-dimethylpropionamide and N,N-dimethylisobutyramide are particularly preferable, and N,N-dimethylpropionamide is more preferable.

The acid amide derivative represented by formula (Z) may be synthesized by a substitution reaction between a corresponding carboxylic acid ester and an amine, or a commercially available product may be used.

Another example of the preferable amide-based solvents includes a lactam compound represented by formula (Y).

[Chem. 56]

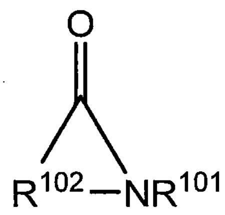

(Y)

In formula (Y), $R^{101}$ represents a hydrogen atom or a $C_{1-6}$ alkyl group, and $R^{102}$ represents a $C_{1-6}$ alkylene group. Specific examples of the $C_{1-6}$ alkyl group include a methyl group, an ethyl group, an n-propyl group, and an n-butyl group, and specific examples of the $C_{1-6}$ alkylene group include, but are not limited to, a methylene group, an ethylene group, a trimethylene group, a tetramethylene group, a pentamethylene group, and a hexamethylene group.

Specific examples of the lactam compound represented by formula (Y) may include an α-lactam compound, a β-lactam compound, a γ-lactam compound, and a δ-lactam compound, and these compounds can be used alone or in combination of two or more thereof.

In a preferable aspect, the lactam compound represented by formula (Y) contains 1-alkyl-2 pyrrolidone (N-alkyl-γ-butyrolactam), in a more preferable aspect, N-methylpyrrolidone (NMP) or N-ethylpyrrolidone (NEP), and in a still more preferable aspect, N-methylpyrrolidone (NMP).

The cleaning agent composition may contain one or more other organic solvents different from the above-described amide compound.

Such other organic solvents are used for this type of application, and are not particularly limited as long as the other organic solvents are organic solvents compatible with the above-described amide compound.

Examples of other preferred solvents include alkylene glycol dialkyl ethers, aromatic hydrocarbon compounds, and cyclic structure-containing ether compounds, but are not limited thereto.

The amount of the other organic solvent different from the above-described amide compound is usually appropriately determined to be 95% by mass or less in the solvent contained in the cleaning agent composition as long as the quaternary ammonium salt contained in the cleaning agent composition is not precipitated or separated, and is uniformly mixed with the above-described amide compound.

In addition, the cleaning agent composition may contain water as the solvent, but usually, only an organic solvent is intended to be used as the solvent from the viewpoint of avoiding corrosion of the substrate and the like. In this case, it is not denied that hydrated water of the salt or trace amounts of water contained in the organic solvent are contained in the cleaning agent composition. The water content of the cleaning agent composition is usually 5% by mass or less.

The constituent elements and method elements related to the above-described steps of the method for producing a processed semiconductor substrate of the present invention may be variously changed without departing from the gist of the present invention.

The method for producing a processed semiconductor substrate of the present invention may include steps other than the above-described steps.

In the releasing method of the present invention, when the semiconductor substrate or the support substrate of the laminate of the present invention is light-transmissive, the semiconductor substrate and the support substrate of the laminate are separated from each other by irradiating the release agent layer with light from the semiconductor substrate side or the support substrate side.

In an example of the laminate of the present invention, since the semiconductor substrate and the support substrate are temporarily adhered to each other by the adhesive layer and the release agent layer to be suitably releasable, for example, when the support substrate is light-transmissive, the semiconductor substrate and the support

substrate can be easily separated from each other by irradiating the release agent layer with light from the support substrate side of the laminate. Usually, release is performed after the semiconductor substrate of the laminate is processed.

An example of the third embodiment will be described with reference to Figs. 6A to 6D. This example is an example of producing a thinned semiconductor substrate.

First, a laminate is prepared (Fig. 6A). This laminate is the same laminate as the laminate shown in Figs. 1 and 2C.

Next, the surface of the semiconductor substrate 1 opposite to a surface in contact with the adhesive layer 2 is polished using a polishing apparatus (not shown) to thin the semiconductor substrate 1 (Fig. 6B). Note that a through electrode may be formed on the thinned semiconductor substrate 1.

Next, after the release agent layer 3 is irradiated with light from the support substrate 4 side, the thinned semiconductor substrate 1 and the support substrate 4 are separated from each other using a releasing device (not shown) (Fig. 6C).

Then, the thinned semiconductor substrate 1 is obtained (Fig. 6D).

Here, residues of the adhesive layer 2 and the release agent layer 3 may remain on the thinned semiconductor substrate 1. Accordingly, it is preferable to clean the thinned semiconductor substrate 1 using the cleaning agent composition to remove the residues of the adhesive layer 2 and the release agent layer 3 from the semiconductor substrate 1.

<Fourth Embodiment>

The method for producing a processed electronic device layer of the present invention includes the following step 5B and the following step 6B. The method for producing a processed electronic device layer may further include the following step 7B.

Here, step 5B is a step of processing the electronic device layer in the laminate described in the section of <Second Embodiment> above.

In addition, step 6B is a step of separating the electronic device layer processed in step 5B from the support substrate.

In addition, step 7B is a step of cleaning the processed electronic device layer after step 6B.

Hereinafter, a specific example of the fourth embodiment will be described with reference to Figs. 7A to 7F.

Examples of the processing performed on the electronic device layer in step 5B include a grinding step and a wiring layer forming step.

<<Grinding Step>>

The grinding step is a step of grinding the resin part of the layer of the sealing resin 25 in the electronic device layer 26 such that a part of the semiconductor chip substrate 21 is exposed.

For example, as shown in Fig. 7B, the sealing resin part is ground by grinding the layer of the sealing resin 25 of the laminate shown in Fig. 7A until the layer has a thickness substantially equal to that of the semiconductor chip substrate 21. Note that the laminate shown in Fig. 7A is the same laminate as the laminate shown in Figs. 3 and 5D.

<<Wiring Layer Forming Step>>

The wiring layer forming step is a step of forming a wiring layer on the exposed semiconductor chip substrate 21 after the grinding step.

In Fig. 7C, a wiring layer 28 is formed on the electronic device layer 26 including a layer of the semiconductor chip substrate 21 and the sealing resin 25.

The wiring layer 28 is also called a redistribution layer (RDL), and is a thin-film wiring body constituting wiring connected to a substrate, and may have a single-layer or multi-layer structure. The wiring layer may be, but is not limited to, one in which wiring is formed of a conductor (for example, metals such as aluminum, copper, titanium, nickel, gold, and silver, and alloys such as a silver-tin alloy) between dielectrics (for example, silicon oxide ($SiO_x$) or a photosensitive resin such as photosensitive epoxy).

Examples of the method for forming the wiring layer 28 include the following methods.

First, a dielectric layer of silicon oxide ($SiO_x$), a photosensitive resin, or the like is formed on the layer of the sealing resin 25. The dielectric layer made of silicon oxide can be formed by, for example, a sputtering method, a vacuum vapor deposition method, or the like. The dielectric layer made of a photosensitive resin can be formed by coating the layer of the sealing resin 25 with a photosensitive resin by a method such as spin coating, dipping, roller blade, spray coating, or slit coating.

Subsequently, wiring is formed on the dielectric layer with a conductor such as metal. As a method for forming the

wiring, for example, known semiconductor process techniques such as lithography processing such as photolithography (regist lithography) or etching processing can be used. Examples of such lithography processing include lithography processing using a positive resist material and lithography processing using a negative resist material.

In the method for producing a laminate according to the fourth embodiment, a bump can be further formed or an element can be mounted on the wiring layer 28. The element can be mounted on the wiring layer 28 using, for example, a chip mounter or the like.

The laminate according to the fourth embodiment may be a laminate prepared in a process based on a fan-out type technology in which a terminal provided on a semiconductor chip substrate is mounted on a wiring layer extending outside a chip area.

In step 6B, examples of the method for separating (releasing) the electronic device layer and the support substrate include, but are not limited to, a method for mechanical releasing with equipment having a sharp portion, a releasing method for separation between the support and the electronic device layer, and the like after the light irradiation to the release agent layer.

By irradiating the release agent layer with light from the support substrate side, the release agent layer is altered (for example, the release agent layer is separated or decomposed) as described above, and thereafter, for example, one of the substrates is pulled up, and the electronic device layer and the support substrate can be easily separated from each other.

Figs. 7D to 7E are schematic cross-sectional views for describing a separation method for the laminate, and Fig. 7F is a schematic cross-sectional view for describing a cleaning method after separation of the laminate. One embodiment of the method for manufacturing a semiconductor package (electronic component) can be described with reference to Figs. 7D to 7F.

As shown in Fig. 7D, the step of separating the laminate is a step of separating the electronic device layer 26 and the support substrate 24 from each other by irradiating the release agent layer 23 with light (arrow) through the support substrate 24 to alter the release agent layer 23.

After irradiating the release agent layer 23 with light (arrow) to alter the release agent layer 23, the support substrate 24 is separated from the electronic device layer 26 as shown in Fig. 7E.

The irradiation conditions, irradiation methods, and the like of irradiation of the adhesive layer with light are as described in the section of <Third Embodiment> above.

The substrate can be cleaned by spraying the cleaning agent composition onto the surface of at least one of the separated electronic device layer and the support substrate, or immersing the separated electronic device layer or the support substrate in the cleaning agent composition.

In addition, the surface of the processed electronic device layer or the like may be cleaned using a removal tape or the like.

For example, in Fig. 7E, the adhesive layer 22 and the release agent layer 23 are attached to the electronic device layer 26 after the separation step, but the adhesive layer 22 and the release agent layer 23 can be removed by decomposing the adhesive layer 22 and the release agent layer 23 using a cleaning agent composition such as acid or alkali. By removing the release agent layer and the adhesive layer, a processed electronic device layer (electronic component) as shown in Fig. 7F can be suitably obtained.

The constituent elements and method elements related to the above-described steps of the method for producing a processed electronic device layer of the present invention may be variously changed without departing from the gist of the present invention.

The method for producing a processed electronic device layer of the present invention may include steps other than the above-described steps.

In the laminate of the present invention, since the electronic device layer and the support substrate are temporarily adhered to each other by the adhesive layer to be suitably releasable, for example, when the support substrate is light-transmissive, the electronic device layer and the support substrate can be easily separated from each other by irradiating the release agent layer with light from the support substrate side of the laminate. Ordinarily, release is performed after the electronic device layer of the laminate is processed.

## Examples

Hereinafter, the present invention will be more specifically described with reference to Examples, but the present invention is not limited to the following Examples. The apparatus used is as follows.

[Apparatus]

(1) Stirrer: planetary centrifugal mixer ARE-500 manufactured by Thinky Corporation
(2) Viscometer: rotational viscometer TVE-22H manufactured by Toki Sangyo Co., Ltd.
(3) Vacuum bonding apparatus: automatic bonder manufactured by SUSS MicroTec SE
(4) Film thickness measurement: DEKTAK XT-A manufactured by Bruker
(5) Laser irradiation device: IPEX-848 manufactured by Light Machinery Co., Ltd.

[Condition for measuring molecular weight]

The weight average molecular weight of the resin composition was measured using a GPC apparatus (HLC-8320GPC manufactured by Tosoh Corporation) and a GPC column (TSKgel Super-MultiporeHZ-N (2 columns)), at a column temperature of 40°C, using THF (tetrahydrofuran) as an eluent (elution solvent), at a flow rate of 0.35 mL/min, and using polystyrene (Shodex manufactured by Showa Denko K.K.) as a standard sample.

[1] Preparation of Adhesive Composition

[Preparation Example 1]

In a 600 mL vessel dedicated to the stirrer were put 80 g of an MQ resin (manufactured by Wacker Chemie GmbH) containing a polysiloxane skeleton and a vinyl group, 2.52 g of SiH group-containing linear polydimethylsiloxane (manufactured by Wacker Chemie GmbH) having a viscosity of 100 mPa·s, 5.89 g of SiH group-containing linear polydimethylsiloxane (manufactured by Wacker Chemie GmbH) having a viscosity of 70 mPa·s, and 0.22 g of 1-ethynyl-1-cyclohexanol (manufactured by Wacker Chemie GmbH), followed by stirring with the stirrer for 5 minutes to yield a mixture (I).

Stirred were 0.147 g of a platinum catalyst (manufactured by Wacker Chemie GmbH) and 5.81 g of vinyl group-containing linear polydimethylsiloxane (manufactured by Wacker Chemie GmbH) having a viscosity of 1,000 mPa·s with the stirrer for 5 minutes to yield a mixture (II).

To the mixture (I) was added 3.96 g of the obtained mixture (II), followed by stirring with the stirrer for 5 minutes to yield a mixture (III).

Finally, the obtained mixture (III) was filtered through a nylon filter 300 mesh to obtain an adhesive composition.

[2] Synthesis of Resin Composition

[Synthesis Example A]

A flask was charged with 5.00 g of a 30 mass% solution of 5,5-dimethyl-1,3-bis(oxiranylmethyl)imidazolidine-2,4-dione in propylene glycol monomethyl ether (hereinafter, abbreviated as PGME), 3.57 g of 4,4-dihydroxybenzophenone, 3.82 g of 1,3-bis[2-(7-oxabicyclo[4.1.0]heptan-3-yl)ethyl]-1,1,3,3-tetramethyldisiloxane, 0.27 g of tetrabutylphosphonium bromide, and 10.27 g of PGME to prepare a raw material mixture, and the raw material mixture was heated and refluxed at 105°C for 24 hours under a nitrogen atmosphere. After the mixture was cooled to room temperature, 20.00 g of PGME, a cation exchange resin, and an anion exchange resin were added to the resultant reaction mixture, and the mixture was then stirred at room temperature for 4 hours to remove unreacted monomers and a catalyst used for the reaction. Finally, the ion exchange resins were removed by filtration to yield a reaction product-containing solution as a filtrate. The amount of the cation exchange resin and the amount of the anion exchange resin were each the same mass as the solid of the raw material mixture prepared at the beginning. The resultant reaction product corresponds to the following formula (A-1), and as a result of measurement by the above-described method, the weight average molecular weight was 2,384.

Formula (A-1)

[Chem. 57]

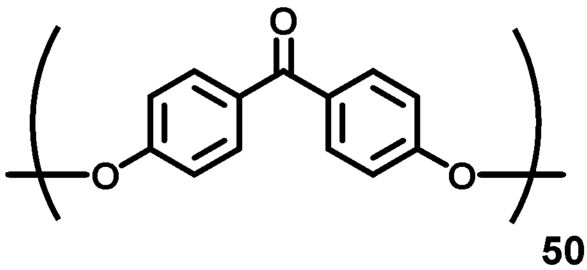

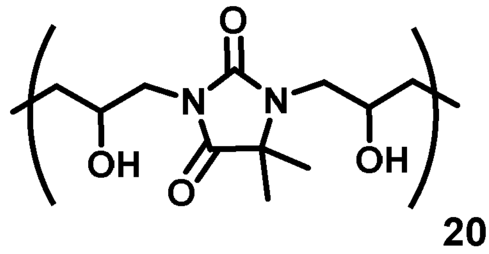

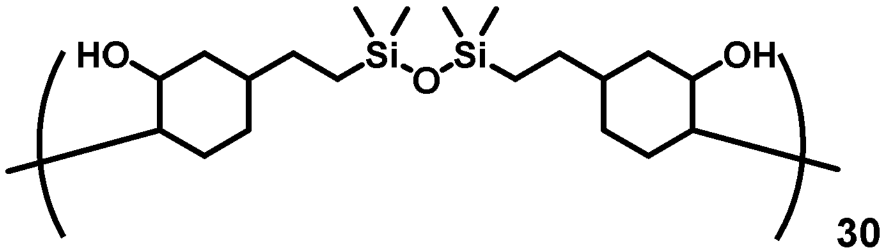

[Synthesis Example B]

A flask was charged with 4.00 g of bisphenol A diglycidyl ether, 2.65 g of 4,4-dihydroxybenzophenone, 0.20 g of tetrabutylphosphonium bromide, and 10.27 g of cyclohexanone (hereinafter, abbreviated as CY) to prepare a raw material mixture, and the raw material mixture was heated and refluxed at 105°C for 24 hours under a nitrogen atmosphere. After the mixture was cooled to room temperature, 20.00 g of CY, a cation exchange resin, and an anion exchange resin were added to the resultant reaction mixture, and the mixture was then stirred at room temperature for 4 hours to remove unreacted monomers and a catalyst used for the reaction. Finally, the ion exchange resins were removed by filtration to yield a reaction product-containing solution as a filtrate. The amount of the cation exchange resin and the amount of the anion exchange resin were each the same mass as the solid of the raw material mixture prepared at the beginning. The resultant reaction product corresponds to the following formula (A-2), and as a result of measurement by the above-described method, the weight average molecular weight was 15,283.

Formula (A-2)

[Chem. 58]

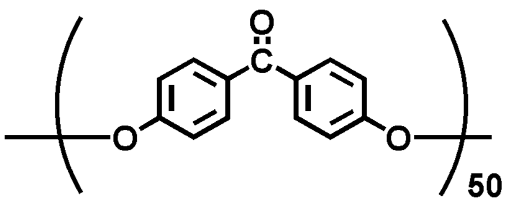

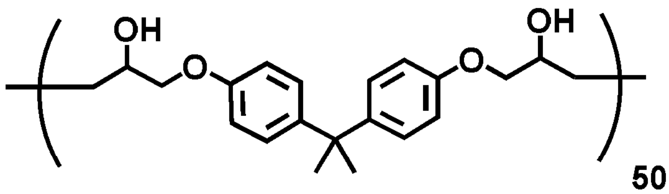

[3] Preparation of Release Agent Composition

[Preparation Example 2]

To 6 g (solid content: 23.29 wt%) of the resin solution obtained in Synthesis Example A, 14.00 g of cyclohexanone was added and dissolved to prepare a release agent composition.

[Comparative Preparation Example 1]

To 6 g (solid content: 18.39 wt%) of the resin solution obtained in Synthesis Example B, 12.39 g of cyclohexanone was added and dissolved to prepare a release agent composition.

[4] Preparation of Cleaning Agent Composition

[Preparation Example 3]

6 g of tetrabutylammonium fluoride trihydrate (manufactured by KANTO CHEMICAL CO., INC.) was mixed with 94 g of N,N-dimethylpropionamide, and the mixture was well stirred to prepare a cleaning agent composition.

To Check Film Removability

[Example 1-1]

[5] The release agent composition obtained in Preparation Example 2 was spin-coated on a 4-inch bare silicon wafer with a final film thickness of 250 nm, and heated at 230°C for 30 minutes to form a film on the bare silicon wafer. The substrates on which the films were formed were prepared as many as necessary for evaluation.

[Comparative Example 1-1]

The release agent composition obtained in Comparative Preparation Example 1 was spin-coated on a 4-inch bare silicon wafer with a final film thickness of 250 nm, and heated at 230°C for 30 minutes to form a film on the bare silicon wafer. The substrates on which the films were formed were prepared as many as necessary for evaluation.

The film thickness of each film obtained in Example 1-1 and Comparative Example 1-1 was measured (film thickness before immersion). Then, each film, together with the substrate, was immersed in 7 mL of the cleaning agent composition obtained in Preparation Example 3 for 5 minutes and dried with an air gun, and then the film thickness of each film was measured again (film thickness after immersion). In addition, the same operation was performed except that cyclohexanone was used instead of the cleaning agent composition, and the film thickness was measured.

The residual film rate (%) by immersion was calculated by the following formula.

Residual film rate (%) = [film thickness after immersion (nm)/film thickness before immersion (nm)] × 100.

Table 1 shows the results.

[Table 1]

| Release agent composition | Example 1-1 | Comparative Example 1-1 |
|---|---|---|
| Cleaning agent composition | 0% | 0% |
| Cyclohexanone | 0% | 0% |

[6] To Produce Laminate

[Examples 2-1 and 2-2] and [Comparative Examples 2-1 and 2-2]

Each release agent composition obtained in Preparation Example 2 and Comparative Preparation Example 1 was spin-coated on a 300-mm silicon wafer (thickness: 775 μm) as a substrate on the device side such that the film thickness in the finally obtained laminate was 250 nm, and the resulting silicon wafer was baked at 230°C for 30 minutes to form a release agent coating layer on the silicon wafer.

Next, the adhesive composition obtained in Preparation Example 1 was spin-coated on the release agent coating layer so as to have a thickness of 65 μm to form an adhesive coating layer.

Then, using a bonding apparatus, the glass wafer (EAGLE-SG, manufactured by Corning; thickness: 700 μm) and the silicon wafer were bonded so as to sandwich the release agent coating layer and the adhesive coating layer, followed by post-heating treatment at 200°C for 10 minutes to prepare a laminate. Bonding was performed at a temperature of 23°C and a reduced pressure of 1,000 Pa, under a load of 30 N.

Next, the obtained laminate was heat-treated at 300°C for 2 hours or 350°C for 1 hour. The obtained laminate was

cut into a 4 cm square using a dicing device.

[7] To Check Releasability

Using a laser irradiation device, the release agent layer was irradiated with a laser having a wavelength of 308 nm at various irradiation amounts shown in Tables 2-1 and 2-2 from the glass wafer side of the fixed laminate. Then, each support substrate was manually lifted to check whether or not the support substrate can be released. A case where the silicon wafer was released without being damaged was evaluated as "◦", and a case where the silicon wafer was not released was evaluated as "×". The results of releasability are shown in Table 2-1 and Table 2-2.

[8] To Check Cleanability

The silicon substrate obtained after laser releasing was immersed in 7 mL of the cleaning composition for 5 minutes, and the substrate surface was rinsed with isopropyl alcohol and air-dried to obtain a cleaned substrate. For determination of whether or not cleaning was possible, the silicon substrate after cleaning was observed with an optical microscope, and a case where a residue was not observed on the substrate was evaluated as "◦", and a case where a residue was observed was evaluated as "×". The results are shown in Table 2-1 and Table 2-2.

[Table 2-1]

| | Example 2-1 | | | | | | Example 2-2 |
|---|---|---|---|---|---|---|---|
| Release agent composition | Preparation Example 2 | | | | | | Preparation Example 2 |
| Heat treatment | 300°C 2h | | | | | | 350°C 1h |
| Cleaning agent composition | Preparation Example 3 | | | | | | Preparation Example 3 |
| Irradiation amount [mJ/cm$^2$] | 100 | 120 | 150 | 200 | 250 | 300 | 300 |
| Releasability Result | × | × | ○ | ○ | ○ | ○ | ○ |
| Cleanability Result | - | - | ○ | ○ | ○ | ○ | ○ |

[Table 2-2]

| | Comparative Example 2-1 | | | | | | Comparative Example 2-2 |
|---|---|---|---|---|---|---|---|
| Release agent composition | Comparative Preparation Example 1 | | | | | | Comparative Preparation Example 1 |
| Heat treatment | 300°C 2h | | | | | | 350°C 1h |
| Cleaning agent composition | Preparation Example 3 | | | | | | Preparation Example 3 |
| Irradiation amount [mJ/cm$^2$] | 100 | 120 | 150 | 200 | 250 | 300 | 300 |
| Releasability Result | × | × | ○ | ○ | ○ | ○ | ○ |
| Cleanability Result | - | - | ○ | ○ | × | × | × |

[9] Preparation of Release Agent Composition

[Preparation Example 4]

To 6 g (solid content: 23.29 wt%) of the resin solution obtained in Synthesis Example A, 0.098 g of 1,3,4,6-tetrakis(methoxymethyl)glycoluril (hereinafter, abbreviated as PL), 0.014 g of pyridinium-p-toluenesulfonic acid (hereinafter, abbreviated as Py-PTS), and 17.29 g of PGME were added and dissolved to prepare a release agent composition.

[Comparative Preparation Example 2]

To 6 g (solid content: 18.39 wt%) of the resin solution obtained in Synthesis Example B, 12.39 g of PGME was added to prepare a release agent composition.

[Comparative Preparation Example 3]

To 6 g (solid content: 18.39 wt%) of the resin solution obtained in Synthesis Example B, 0.077 g of PL, 0.011 g of Py-PTS, and 12.39 g of PGME were added and dissolved to prepare a release agent composition.

[10] To Check Film Removability

[Example 1-2]

The release agent composition obtained in Preparation Example 4 was spin-coated on a 4-inch bare silicon wafer with a final film thickness of 250 nm, and heated at 230°C for 30 minutes to form a film on the bare silicon wafer. The substrates on which the films were formed were prepared as many as necessary for evaluation.

[Comparative Example 1-2]

The release agent composition obtained in Comparative Preparation Example 2 was spin-coated on a 4-inch bare silicon wafer with a final film thickness of 250 nm, and heated at 230°C for 30 minutes to form a film on the bare silicon wafer. The substrates on which the films were formed were prepared as many as necessary for evaluation.

[Comparative Example 1-3]

The release agent composition obtained in Comparative Preparation Example 3 was spin-coated on a 4-inch bare silicon wafer with a final film thickness of 250 nm, and heated at 230°C for 30 minutes to form a film on the bare silicon wafer. The substrates on which the films were formed were prepared as many as necessary for evaluation.

The film thickness of each film obtained in Example 1-2 and Comparative Examples 1-2 and 1-3 was measured (film thickness before immersion). Then, each film, together with the substrate, was immersed in 7 mL of the cleaning agent composition obtained in Preparation Example 3 for 5 minutes and dried with an air gun, and then the film thickness of each film was measured again (film thickness after immersion). In addition, the same operation was performed except that PGME was used instead of the cleaning agent composition, and the film thickness was measured.

The residual film rate (%) by immersion was calculated by the following formula.

Residual film rate (%) = [film thickness after immersion (nm)/film thickness before immersion (nm)] $\times$ 100.

The results are shown in Table 3.

[Table 3]

| Release agent composition | Example 1-2 | Comparative Example 1-2 | Comparative Example 1-3 |
|---|---|---|---|
| Cleaning agent composition | 0% | 0% | >80% |
| PGME | >80% | 0% | >80% |

[11] To Produce Laminate

[Example 2-3] and [Comparative Example 2-3]

Each release agent composition obtained in Preparation Example 4 or Comparative Preparation Example 3 was spin-coated on a 300-mm glass wafer (EAGLE-SG, manufactured by Corning Incorporated; thickness: 700 μm) as a carrier-side substrate so that the film thickness in the finally obtained laminate was 250 nm, and baked at 230°C for 30 minutes to form a release agent coating layer on the glass wafer.

On the other hand, the adhesive composition obtained in Preparation Example 1 was spin-coated on a 300 mm silicon wafer (thickness: 775 μm) as a substrate on the device side such that the film thickness in the finally obtained laminate was 65 μm to form an adhesive coating layer on the silicon wafer that is a semiconductor substrate.

Then, using a bonding apparatus, the glass wafer and the silicon wafer were bonded so as to sandwich the release agent coating layer and the adhesive coating layer, followed by post-heating treatment at 200°C for 10 minutes to prepare a laminate. Note that bonding was performed under a load of 30 N at a temperature of 23°C and a degree of vacuum of 1,000 Pa. The obtained laminate was cut into a 4 cm square using a dicing device.

[12] To Check Releasability

Using a laser irradiation device, the release agent layer was irradiated with a laser having a wavelength of 308 nm at various irradiation amounts shown in Table 4 from the glass wafer side of the fixed laminate. Then, each support substrate was manually lifted to check whether or not the support substrate can be released. A case where the silicon wafer was released without being damaged was evaluated as "◦", and a case where the silicon wafer was not released was evaluated as "×". The results of releasability are shown in Table 4.

[13] To Check Cleanability

The silicon substrate (silicon wafer) obtained after laser releasing was immersed in 7 mL of the cleaning agent composition for 5 minutes and air-dried to yield a cleaned substrate. For determination of whether or not cleaning was possible, the silicon substrate after cleaning was observed with an optical microscope, and a case where a residue was not observed on the substrate was evaluated as "◦", and a case where a residue was observed was evaluated as "×". The results are shown in Table 4.

[Table 4]

| | Example 2-3 | | | | | | | Comparative Example 2-3 | | | | | | |
|---|---|---|---|---|---|---|---|---|---|---|---|---|---|---|
| Release agent composition | Preparation Example 4 | | | | | | | Comparative Preparation Example 3 | | | | | | |
| Irradiation amount [mJ/cm$^2$] | 100 | 120 | 150 | 200 | 220 | 240 | 260 | 100 | 120 | 150 | 200 | 220 | 240 | 260 |
| Releasability Result | × | ○ | ○ | ○ | ○ | ○ | ○ | × | × | ○ | ○ | ○ | ○ | ○ |
| Cleanability Result | - | ○ | ○ | ○ | ○ | ○ | ○ | - | - | × | × | × | × | × |

Tables 1 to 4 have demonstrated that the release agent composition of the present invention exhibits good cleanability by including a siloxane structure. Further, it has been confirmed that when a crosslinking agent is contained, the release agent composition of the present invention exhibits solvent resistance to a common organic solvent, and becomes soluble in the cleaning agent composition and can be washed. In addition, it has been found that the substrate can be easily released after the release agent composition is irradiated with light because the release agent composition has a light absorbing site.

Reference Signs List

1 Semiconductor substrate
2 Adhesive layer
2a Adhesive coating layer
3 Release agent layer
4 Support substrate
21 Semiconductor chip substrate
22 Adhesive layer
23 Release agent layer
24 Support substrate
25 Sealing resin
26 Electronic device layer
27 Release agent layer having adhesive performance
28 Wiring layer

## Claims

1. A release agent composition for release by irradiation with light, comprising

   a polymer and a solvent,
   the polymer comprising a first structure, a second structure, and a third structure, wherein
   the first structure has a structure that absorbs light to impart releasability to a release agent layer formed from the release agent composition,
   the second structure has a -Si-O-Si- structure in a main chain of the polymer, and
   the third structure has an aromatic hydrocarbon ring and/or a heterocyclic ring.

2. The release agent composition according to claim 1, wherein the first structure is a repeating unit represented by the following formula (1):

   [Chem. 1]

   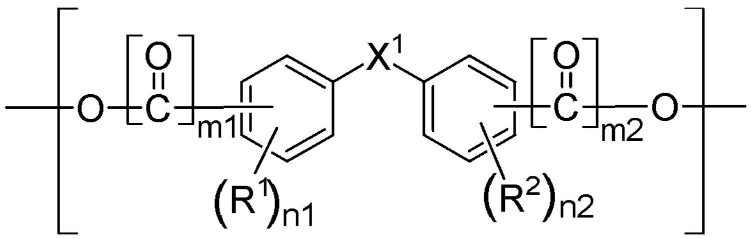

   (1)

   wherein in the formula (1), $X^1$ represents -O-, -CO-, - $NR^a$- (where $R^a$ represents a hydrogen atom, an optionally substituted alkyl group, or an optionally substituted aryl group), -SO-, -$SO_2$-, -N=N-, -CH=CH-CO-, or -CH=CH-CO-$CH_2$-CO-CH=CH-,
   m1 and m2 each independently represent 0 or 1,
   $R^1$ and $R^2$ each independently represent a halogen atom or a monovalent group,
   n1 and n2 each independently represent an integer of 0 to 4,
   when there are two or more $R^1$ moieties, the two or more $R^1$ moieties are the same or different, and
   when there are two or more $R^2$ moieties, the two or more $R^2$ moieties are the same or different.

3. The release agent composition according to claim 1, wherein the second structure is a repeating unit represented by the following formula (2-1) or (2-2):

   [Chem. 2]

   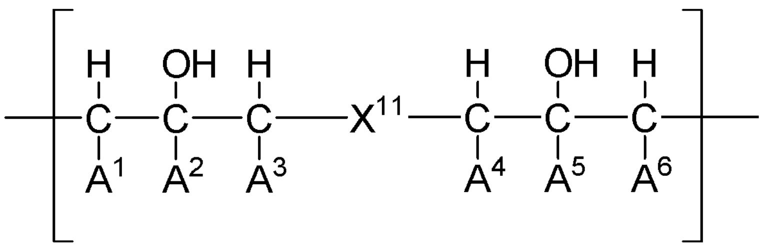

   (2-1)

   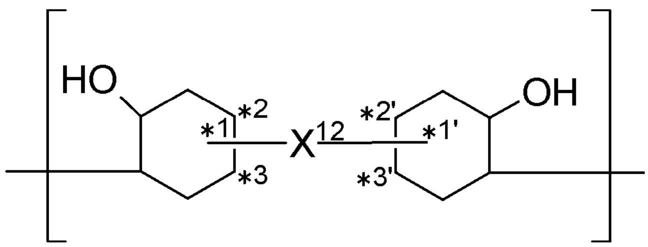

   (2-2)

wherein in the formula (2-1), $X^{11}$ represents a divalent group having a -Si-O-Si- structure, and $A^1$, $A^2$, $A^3$, $A^4$, $A^5$, and $A^6$ each independently represent a hydrogen atom, a methyl group, or an ethyl group, in the formula (2-2), $X^{12}$ represents a divalent group having a -Si-O-Si- structure, *1 and *1' represent a bond, the bond *1 is bonded to a carbon atom *2 or a carbon atom *3, and the bond *1' is bonded to a carbon atom *2' or a carbon atom *3'.

**4.** The release agent composition according to claim 3, wherein $X^{11}$ in the formula (2-1) and $X^{12}$ in the formula (2-2) are each independently a structure represented by the following formula (S):

[Chem. 3]

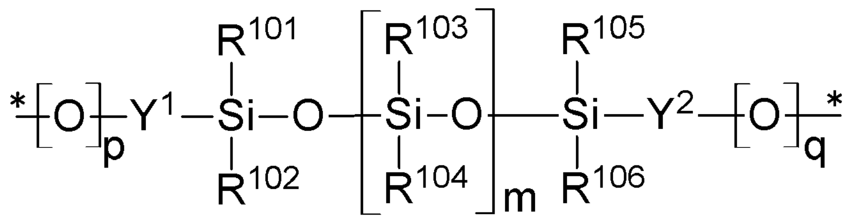

(S)

wherein in the formula (S), $R^{101}$ to $R^{106}$ each independently represent a substituted or unsubstituted alkyl group, a substituted or unsubstituted alkenyl group, or a substituted or unsubstituted aryl group, $Y^1$ and $Y^2$ each independently represent a $C_{1-10}$ alkylene group, m represents an integer of 0 or 1 or more, p and q each independently represent 0 or 1, when m is 2 or more, 2 or more of $R^{103}$ or $R^{104}$ are the same or different, and * represents a bond.

**5.** The release agent composition according to claim 1, wherein the third structure is a repeating unit represented by the following formula (3):

[Chem. 4]

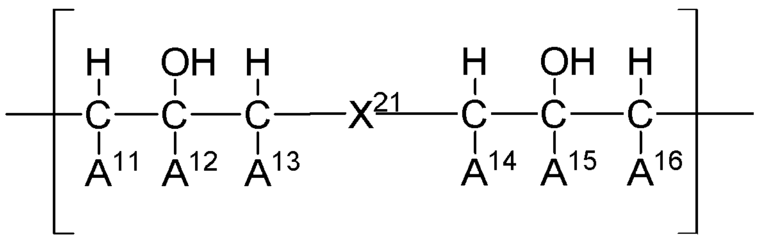

(3)

wherein in the formula (3), $X^{21}$ represents a divalent group having an aromatic hydrocarbon ring and/or a heterocyclic ring, and $A^{11}$, $A^{12}$, $A^{13}$, $A^{14}$, $A^{15}$, and $A^{16}$ each independently represent a hydrogen atom, a methyl group, or an ethyl group.

**6.** The release agent composition according to claim 5, wherein $X^{21}$ in the formula (3) is any of a structure represented by the following formula (3-1) and a structure represented by the following formula (3-2):

[Chem. 5]

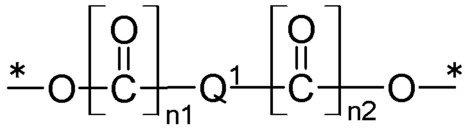 (3-1)

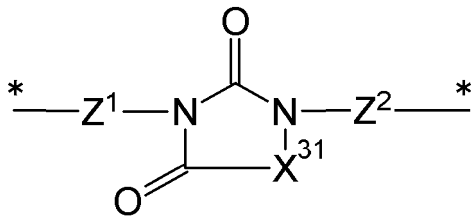 (3-2)

wherein in the formula (3-1), $Q^1$ represents a divalent organic group represented by the following formula (3-1-1) or a divalent organic group represented by the following formula (3-1-2), n1 and n2 each independently represent 0 or 1, and * represents a bond,
in the formula (3-2), $X^{31}$ represents a divalent group represented by any one of the following formulae (3-2-1) to (3-2-3), $Z^1$ and $Z^2$ each independently represent a single bond or a divalent group represented by formula (3-2-4) below, and * represents a bond;

[Chem. 6]

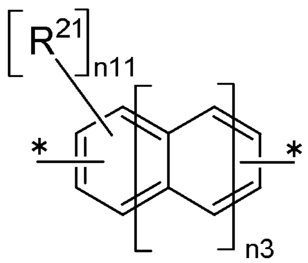 (3-1-1)

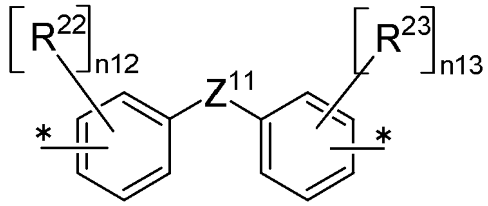 (3-1-2)

wherein in the formulae (3-1-1) and (3-1-2), $R^{21}$ to $R^{23}$ each independently represent a halogen atom, a hydroxy group, a $C_{1-6}$ alkyl group, a $C_{2-6}$ alkenyl group, a $C_{2-6}$ alkynyl group, a $C_{1-6}$ alkoxy group, a $C_{2-6}$ alkenyloxy group, a $C_{2-6}$ alkynyloxy group, a $C_{2-6}$ acyl group, a $C_{6-12}$ aryloxy group, a $C_{7-13}$ arylcarbonyl group, or a $C_{7-13}$ aralkyl group, and * represents a bond,
in the formula (3-1-1), n3 represents 0 or 1, when n3 is 0, n11 represents an integer of 0 to 4, when n3 is 1, n11 represents an integer of 0 to 6, and when there are two or more $R^{21}$ moieties, the two or more $R^{21}$ moieties are the same or different,
in the formula (3-1-2), $Z^{11}$ represents a single bond or a $C_{1-6}$ alkylene group, n12 and n13 each independently represent an integer of 0 to 4, when there are two or more $R^{22}$ moieties, the two or more $R^{22}$ moieties are the same or different, and when there are two or more $R^{23}$ moieties, the two or more $R^{23}$ moieties are the same or different;

[Chem. 7]

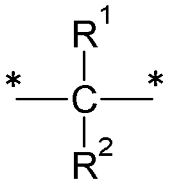 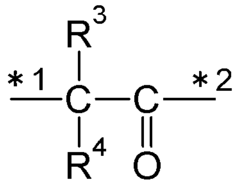 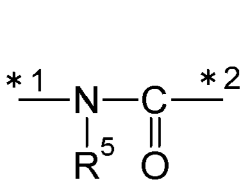

(3-2-1) (3-2-2) (3-2-3)

in the formulae (3-2-1) to (3-2-3), $R^1$ to $R^5$ each independently represent a hydrogen atom, a $C_{1-10}$ alkyl group optionally interrupted by an oxygen atom or a sulfur atom, a $C_{2-10}$ alkenyl group optionally interrupted by an oxygen atom or a sulfur atom, a $C_{2-10}$ alkynyl group optionally interrupted by an oxygen atom or a sulfur atom, a benzyl group, or a phenyl group provided that the phenyl group is optionally substituted with at least one monovalent group selected from the group consisting of a $C_{1-6}$ alkyl group, a halogen atom, a $C_{1-6}$ alkoxy group, a nitro group, a cyano group, and a $C_{1-6}$ alkylthio group, $R^1$ and $R^2$ are optionally bonded to each other to form a $C_{3-6}$ ring, $R^3$ and $R^4$ are optionally bonded to each other to form a $C_{3-6}$ ring,
* represents a bond, *1 represents a bond bonded to a carbon atom in the formula (3-2), and *2 represents a bond bonded to a nitrogen atom in the formula (3-2); and

[Chem. 8]

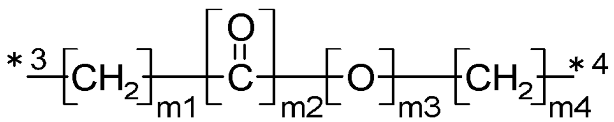 (3-2-4)

wherein in the formula (3-2-4), m1 is an integer of 0 to 4, m2 is 0 or 1, m3 is 0 or 1, and m4 is an integer of 0 to 2, provided that, when m3 is 1, m1 and m2 are not both 0 at the same time, *3 represents a bond bonded to a nitrogen atom in formula (3-2), and *4 represents a bond.

**7.** A laminate comprising:

a semiconductor substrate or an electronic device layer;
a light-transmissive support substrate; and
a release agent layer provided between the semiconductor substrate or the electronic device layer and the support substrate, wherein
the release agent layer is a release agent layer formed of the release agent composition according to any one of claims 1 to 6.

**8.** The laminate according to claim 7, comprising an adhesive layer provided between the semiconductor substrate or the electronic device layer and the support substrate.

**9.** A method for producing a processed semiconductor substrate or a processed electronic device layer, the method comprising:

step 5A of processing the semiconductor substrate of the laminate according to claim 7, or step 5B of processing the electronic device layer of the laminate according to claim 7; and
step 6A of separating the semiconductor substrate processed in step 5A and the support substrate from each other, or step 6B of separating the electronic device layer processed in step 5B and the support substrate from each other.

**10.** The method for producing a processed semiconductor substrate or a processed electronic device layer according to claim 9, wherein step 6A or step 6B comprises a step of irradiating the laminate with a laser from the support substrate side.

FIG. 1

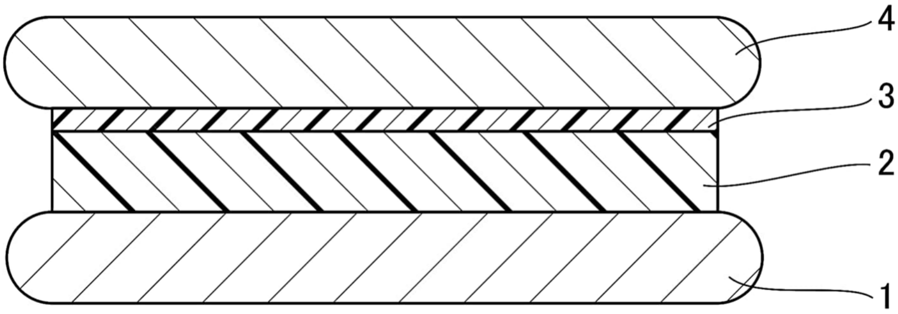


FIG. 2A

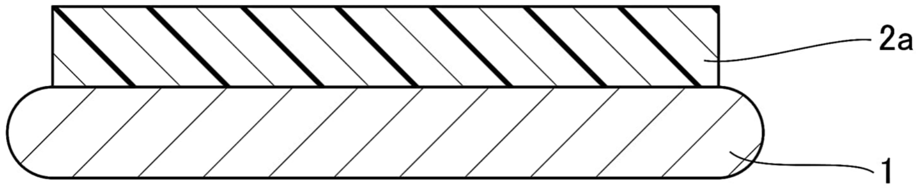


FIG. 2B

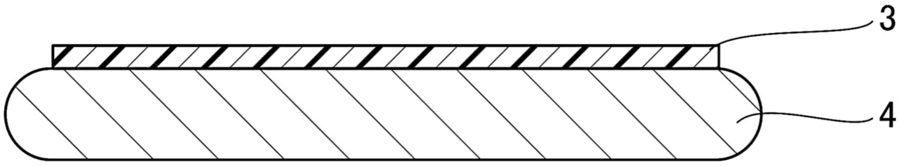

FIG. 2C

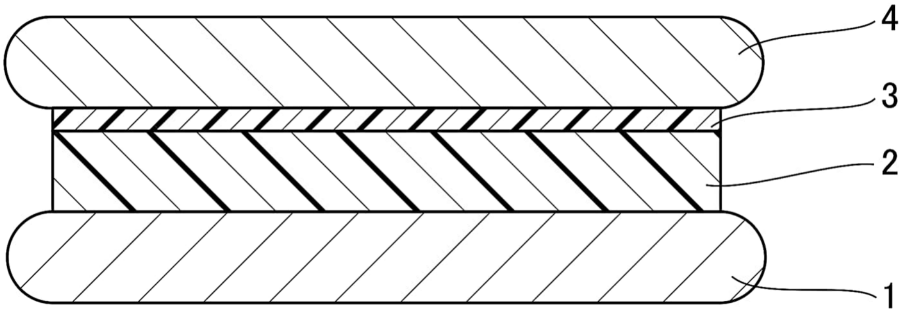


FIG. 3

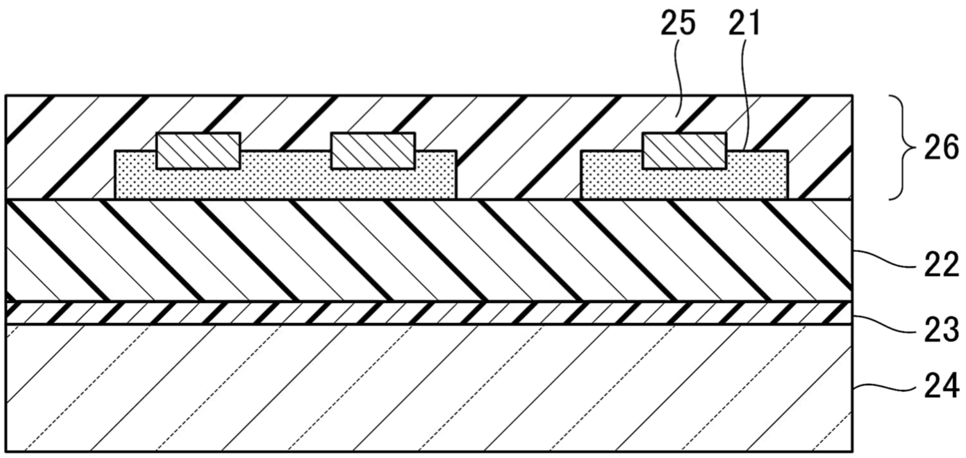

FIG. 4

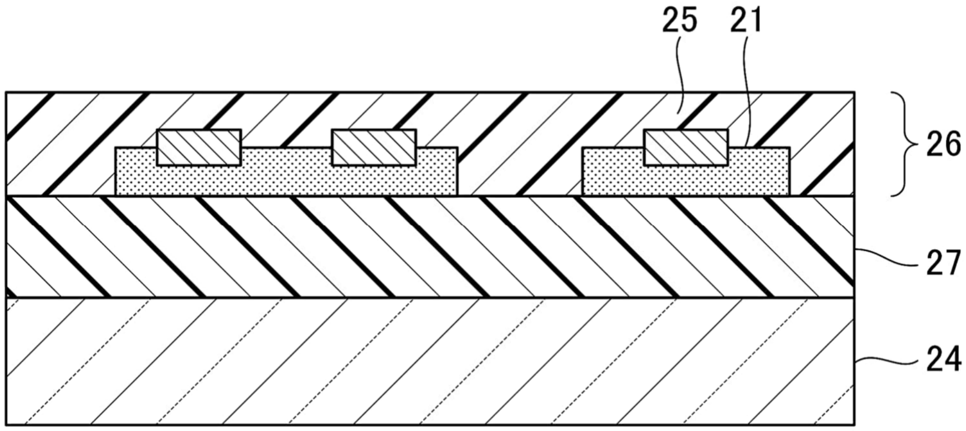


FIG. 5A

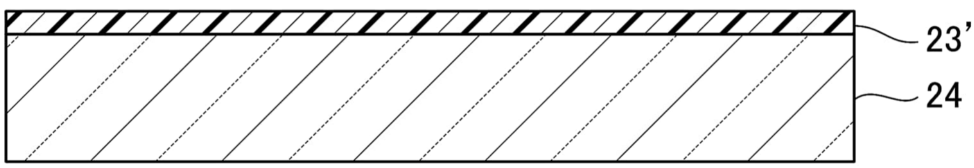


FIG. 5B

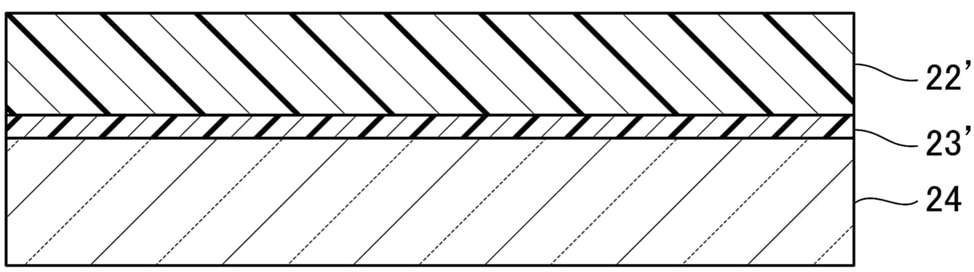

FIG. 5C

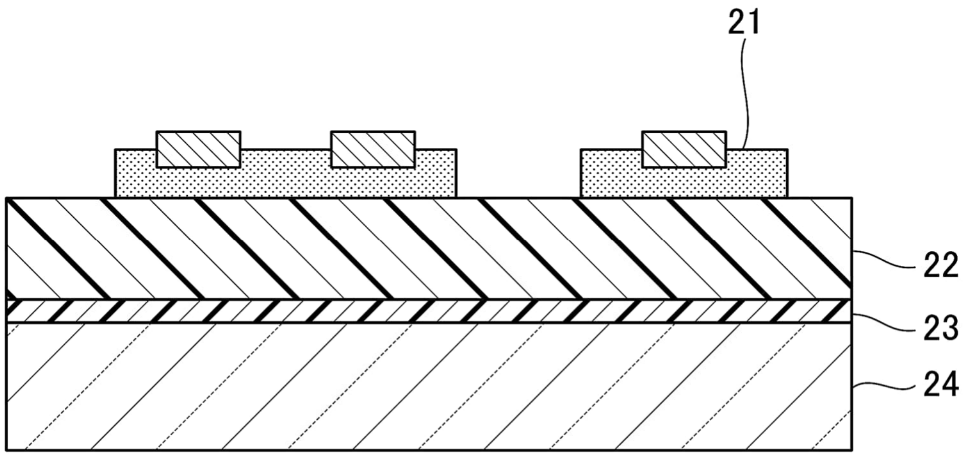


FIG. 5D

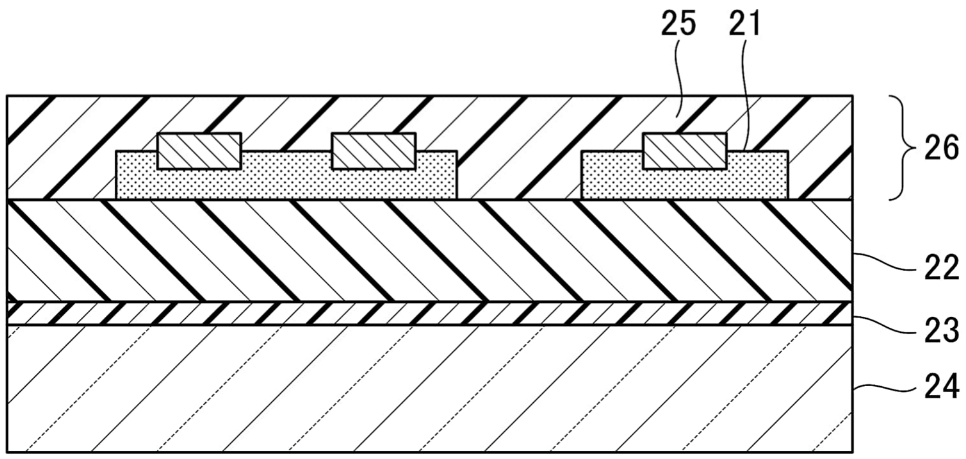

FIG. 6A

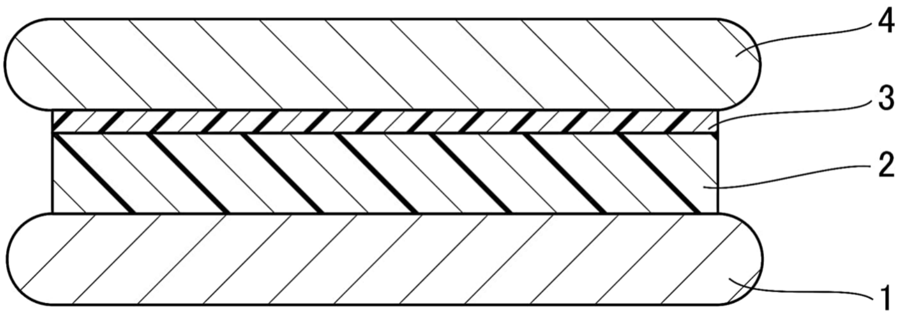


FIG. 6B

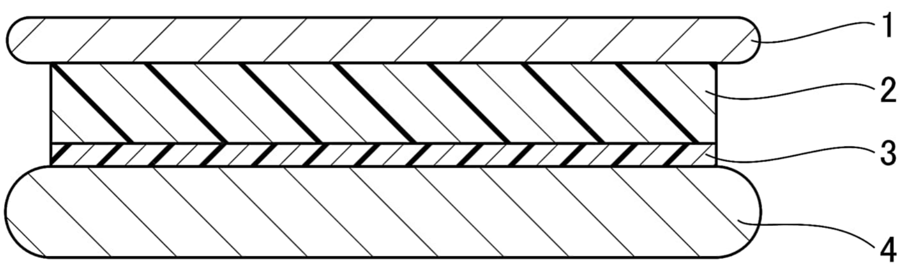


FIG. 6C

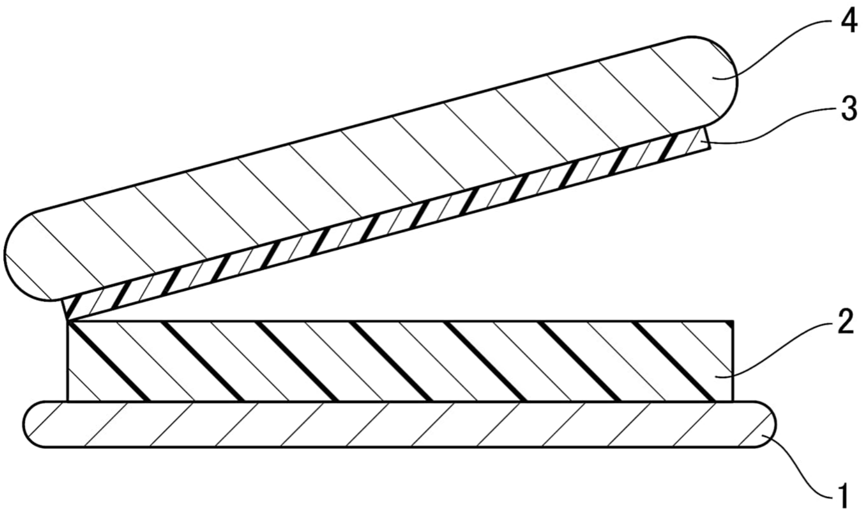

FIG. 6D

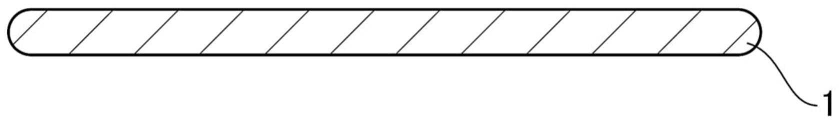


FIG. 7A

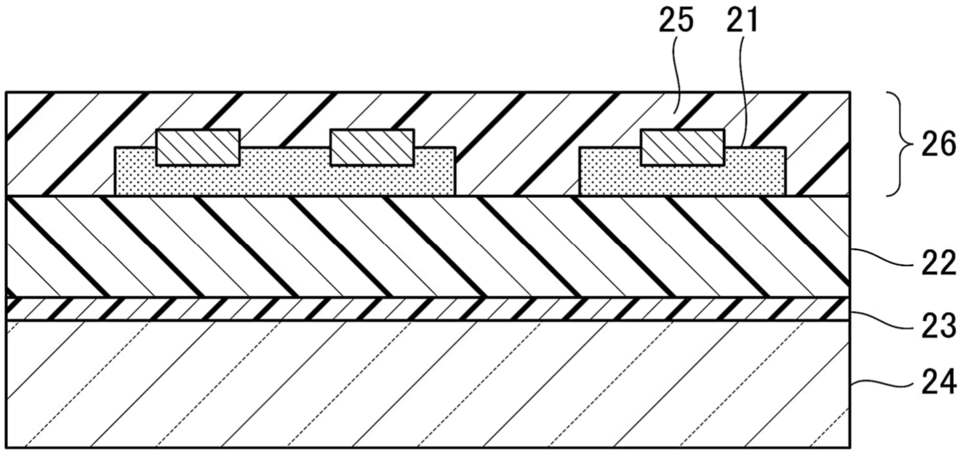


FIG. 7B

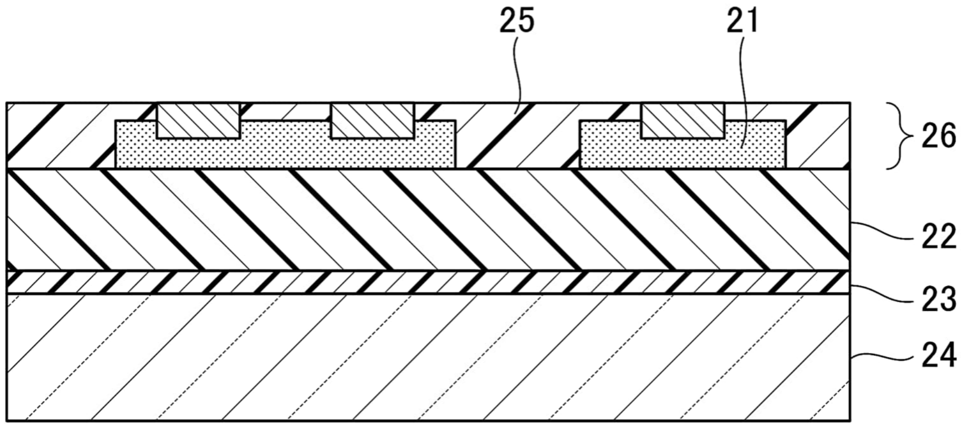

FIG. 7C

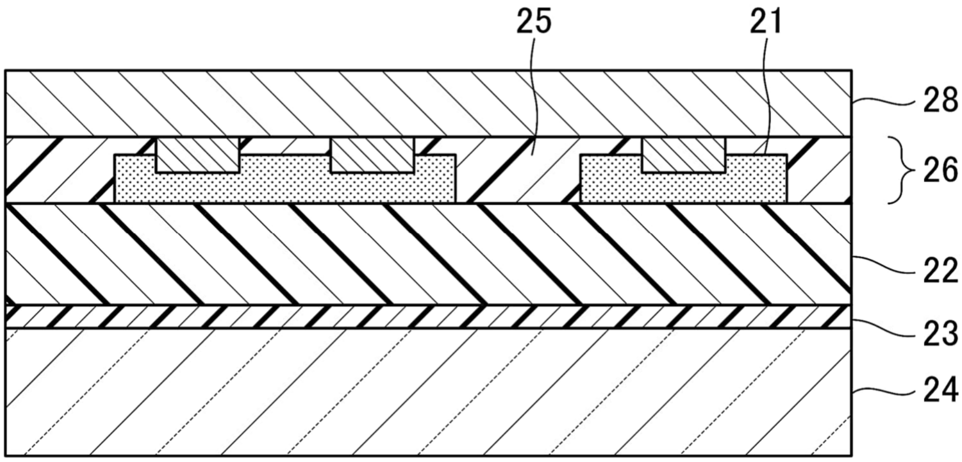


FIG. 7D

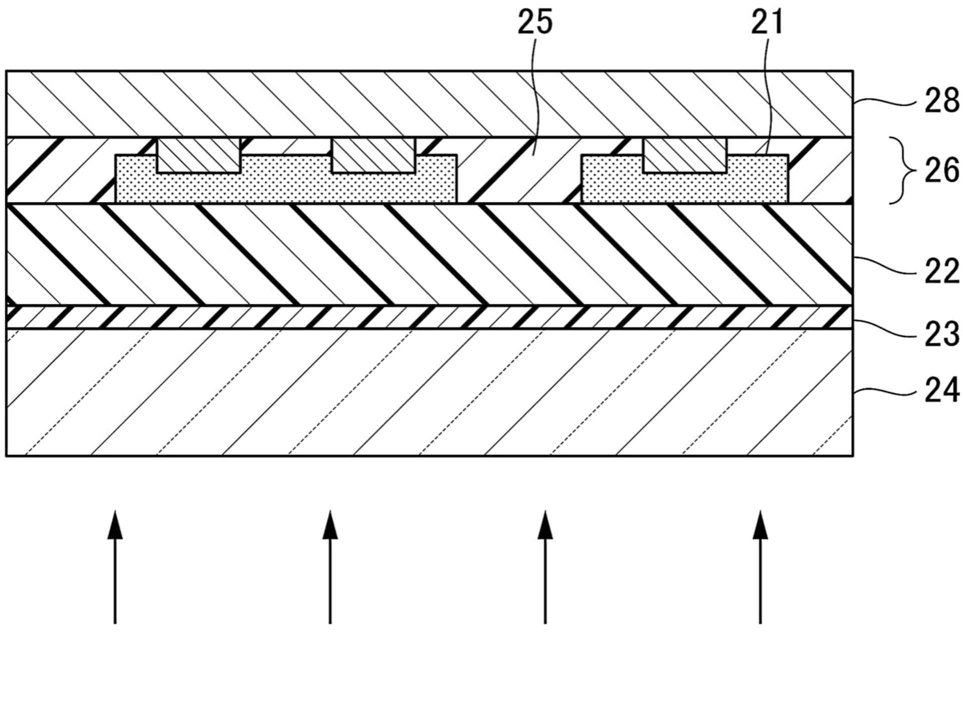

FIG. 7E

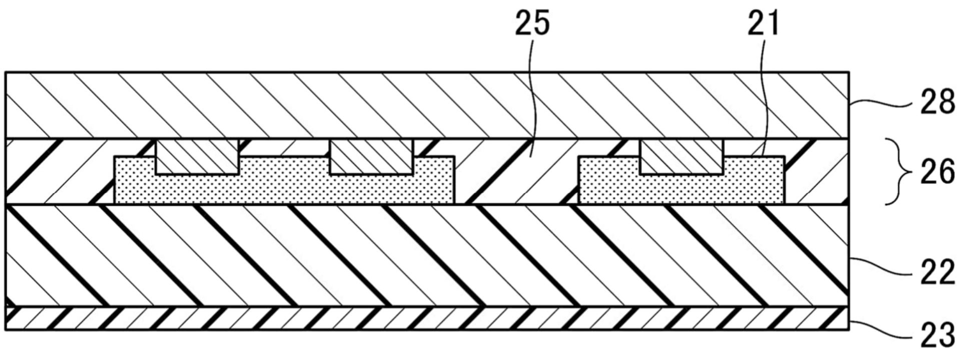


FIG. 7F

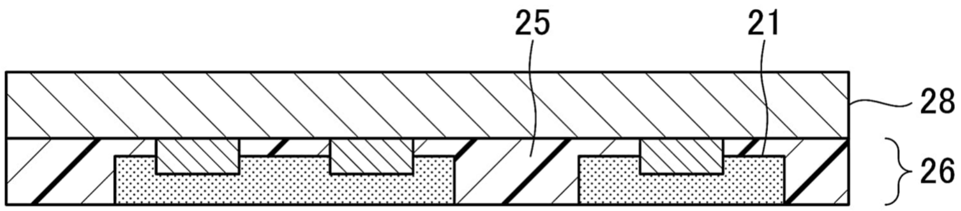

## INTERNATIONAL SEARCH REPORT

International application No.
**PCT/JP2024/009720**

**A. CLASSIFICATION OF SUBJECT MATTER**

***H01L 21/304***(2006.01)i; ***C09D 5/20***(2006.01)i; ***H01L 21/02***(2006.01)i; ***H01L 21/683***(2006.01)i
FI: H01L21/304 622J; H01L21/02 C; H01L21/68 N; C09D5/20

According to International Patent Classification (IPC) or to both national classification and IPC

**B. FIELDS SEARCHED**

Minimum documentation searched (classification system followed by classification symbols)

H01L21/304; C09D5/20; H01L21/02; H01L21/683

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2022/210241 A1 (NISSAN CHEMICAL CORPORATION) 06 October 2022 (2022-10-06) paragraphs [0009], [0012]-[0013], [0024]-[0042], [0143]-[0144] | 1, 7-10 |
| A | | 2-6 |
| X | WO 2022/210238 A1 (NISSAN CHEMICAL CORPORATION) 06 October 2022 (2022-10-06) paragraphs [0008], [0011]-[0012], [0022]-[0030], [0053] | 1, 7-10 |
| A | | 2-6 |
| A | WO 2020/138240 A1 (NISSAN CHEMICAL CORPORATION) 02 July 2020 (2020-07-02) paragraphs [0003], [0047], [0055], [0094] | 1-10 |

☐ Further documents are listed in the continuation of Box C.    ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **20 May 2024** | **28 May 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/009720**

| Patent document cited in search report | Publication date (day/month/year) | Patent family member(s) | Publication date (day/month/year) |
|---|---|---|---|
| WO 2022/210241 A1 | 06 October 2022 | EP 4310157 A1<br>paragraphs [0010], [0013]-[0021], [0048]-[0081], [0240]-[0242]<br>CN 117157738 A<br>KR 10-2023-0162674 A | |
| WO 2022/210238 A1 | 06 October 2022 | EP 4306609 A1<br>paragraphs [0009], [0012]-[0020], [0046]-[0064], [0108]<br>CN 117083697 A<br>KR 10-2023-0164088 A | |
| WO 2020/138240 A1 | 02 July 2020 | US 2022/0073801 A1<br>paragraphs [0003], [0061], [0070], [0097]<br>EP 3907074 A1<br>CN 113226743 A<br>KR 10-2021-0107788 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004064040 A
- JP 2012106486 A
- WO 2019088103 A